# EUROPEAN PATENT SPECIFICATION

(11) **EP 3 871 279 B1**
(45) Date of publication and mention of the grant of the patent: **01.04.2026**
(21) Application number: 19794230.3
(22) Date of filing: 18.10.2019
(51) Int. Cl.: H10K 30/57, H10K 71/15, H10K 85/50, H10K 30/50

(54) **MULTI-JUNCTION DEVICE PRODUCTION PROCESS**
HERSTELLUNGSVERFAHREN FÜR VORRICHTUNG MIT MEHREREN ÜBERGÄNGEN
PROCÉDÉ DE PRODUCTION DE DISPOSITIF À JONCTIONS MULTIPLES

(30) Priority: 22.10.2018 GB 201817166
(43) Date of publication of application: 01.09.2021
(73) Proprietor: Oxford Photovoltaics Limited, Oxford OX5 1QU (GB)
(72) Inventor: SNAITH, Henry James, Oxford, Oxfordshire OX1 3PU (GB); MCMEEKIN, David P., Oxford, Oxfordshire OX1 3PU (GB)
(74) Representative: J A Kemp LLP
(86) International application number: PCT/GB2019/052988
(87) International publication number: WO 2020/084285

(56) References cited:
- WO-A1-2016/198889
- WO-A1-2017/153752
- US-A1- 2016 005 795
- LI NING ET AL: "An Efficient Solution-Processed Intermediate Layer for Facilitating Fabrication of Organic Multi-Junction Solar Cells", ADVANCED ENERGY MATERIALS, vol. 3, no. 12, 16 July 2013 (2013-07-16), DE, pages 1597 - 1605, XP093053860, ISSN: 1614-6832, DOI: 10.1002/aenm.201300372
- NAKITA K. NOEL ET AL: "A low viscosity, low boiling point, clean solvent system for the rapid crystallisation of highly specular perovskite films", ENERGY & ENVIRONMENTAL SCIENCE, vol. 10, no. 1, 26 September 2016 (2016-09-26), Cambridge, pages 145 - 152, XP055589901, ISSN: 1754-5692, DOI: 10.1039/C6EE02373H
- ALEXANDRA J. RAMADAN ET AL: "Unravelling the Improved Electronic and Structural Properties of Methylammonium Lead Iodide Deposited from Acetonitrile", CHEMISTRY OF MATERIALS, vol. 30, no. 21, 5 October 2018 (2018-10-05), pages 7737 - 7743, XP055656839, ISSN: 0897-4756, DOI: 10.1021/acs.chemmater.8b03084

## Description

### FIELD OF THE INVENTION

The invention provides a process for producing a multi-junction device comprising a layer of a crystalline A/M/X material.

### BACKGROUND TO THE INVENTION

When the first report of a perovskite solar cell was made in 2009, the solar light to electrical power conversion efficiency stood at 3%. By 2012, perovskite photovoltaic devices achieving 9.2% and 10.9% had been achieved. Since then, there has been burgeoning research into the field of perovskite photovoltaics and photovoltaic devise based on other A/M/X materials, with such materials showing the promise to completely transform the energy landscape. Perovskite-based photovoltaic devise have since achieved certified efficiencies in excess of 23%.

Apart from the obvious lure of high power conversion efficiencies, one of the most attractive features of A/M/X materials is the relative simplicity with which high-quality films of this material can be manufactured. Perovskite films can be fabricated through a variety of methods, including one-step spin-coating, vapour deposition and dip-coating, as well as various combinations of these three routes. One-step spin-coating, however, remains the simplest and quickest method with the added bonus of not requiring the use of particularly expensive equipment. Many variations of this method have been developed, such as the inclusion of an additional step in the form of anti-solvent quenching. It is expected that solution processing manufacturing methodologies such as inkjet printing, spray-coating, slot dye coating, blade coating and gravure printing, will be able to undertaken, using slight modifications from spin-coating methods developed in laboratories.

While perovskite solar cells are of significant importance in photovoltaic research, there remain some concerns with respect to the viability of this material for market purposes. One is the stability of the material and the anomalous hysteresis, which is frequently observed in the J-V characteristics of these devices. The cause of this hysteresis has been shown to be due to ion motion, and many attempts to mitigate this effect have been made. The so called inverted positive-intrinsic-negative (p-i-n) structure has been shown to exhibit little to negligible hysteresis, while for the regular negative-intrinsic-positive (n-i-p) structure, the replacement of TiO₂, often used as the n-type charge collection layer, by an organic electron acceptor such as C60 or phenyl-C61-butyric acid methyl ester (PCBM), or the inclusion of a thin layer of such materials on top of the TiO₂ layer, has been quite successful in the reduction of hysteresis, and this results in a significant increase in the steady-state power output of the device.

To date, most reports of perovskite films manufactured via solution methods use high boiling point, polar, aprotic solvents (see, for instance, Eperon et al, Morphological Control for High Performance, Solution-Processed Planar Heterojunction Perovskite Solar Cells, Adv. Funct. Mater. 2013). While the most frequently used solvent is dimethylformamide (DMF), other solvents include dimethylsulfoxide (DMSO), γ-butyrolactone and dimethylacetamide (DMA). The choice of solvent is, in this case, limited by the lead halide salts which tend to be either sparingly, or completely insoluble in most of the solvents commonly used in the processing of organic semiconductors and dye-sensitized solar cell materials. One of the disadvantages to using solvents such as these is the need to heat films to fairly high temperatures (≥ 100°C) to induce crystallisation of the perovskite or A/M/X material film. This can be somewhat circumvented by the use of a so called anti-solvent quenching method, where a film is drenched in an anti-solvent at a specified time during spin-coating, causing the immediate crystallisation of the perovskite material. However, this can complicate the process by requiring an additional anti-solvent quenching step.

WO 2017/153752 A1 describes a process for producing a layer of crystalline A/M/X material,
wherein the process comprises disposing on a substrate a precursor composition comprising: (a) a first precursor compound comprising a first cation (M), which first cation is a metal or metalloid cation; and (b) a solvent, wherein the solvent comprises; (i) acetonitrile, propionitrile, acetone or a mixture thereof; and (ii) an alkylamine. Also described is a composition comprising: (i) a compound of formula MXn, (ii) a compound of formula AX, (iii) acetonitrile, propionitrile, acetone or a mixture thereof; and (iv) an alkylamine of formula R^{A}NH₂, wherein R^{A} is a C₁₋₈ alkyl group.

Noel et al. (N. K. Noel, S. N. Habisreutinger, B. Wenger, M. T. Klug, M. T. Hörantner, M. B. Johnston, R. J. Nicholas, D. T. Moore, H. J. Snaith, Energy Environ. Sci. 2017, 10, 145) describes a low viscosity, low boiling point, solvent system for the crystallisation of highly specular perovskite films.

Alexandra J. Ramadan et al. Chemistry of materials, vol. 30, no. 21, 5 October 2018, pages 7737-7743 describes methylammonium lead iodide thin films processed using an acetonitrile/methylamine composite solvent system.

WO 2016/198889 A1 describes a photovoltaic device that comprises a photoactive region, the photoactive region comprising a perovskite material comprising a formamidinium cation, a caesium cation, at least one divalent inorganic cation, iodide and bromide.

Li Ning et al. Advanced Energy Materials, vol. 3, no. 12, 16 July 2013, pages 1597-1605 describes a solution-processed intermediate layer for facilitating fabrication of organic multi-junction solar cells.

US 2016/005795 A1 describes an organic tandem photovoltaic device which includes a first electrode, a second electrode spaced apart from said first electrode, first and second photoactive organic bulk heterojunction layers, and an interconnecting layer. The interconnecting layer is between and electrically connects the first and second photoactive organic bulk heterojunction layers. The interconnecting layer includes an electron extracting interface layer of a first inorganic material and a hole extracting interface layer of a second inorganic material.

As discussed in WO 2017/153752 A1 there are several problems associated with existing solution-based methods for forming films of A/M/X materials. The solvents used at present (such as DMF, DMSO, γ-butyrolactone and DMA) have been chosen because they are able to dissolve the precursor compounds for A/M/X materials, and particularly the metal halide precursors. However, these solvents have high boiling points, increasing the energy requirements or complexity of solution processing. They also have a tendency to remove pre-existing organic layers during device production. These solvents are known to be toxic and can be correspondingly difficult to handle and may be prohibitive for large volume manufacturing due to toxicological concerns. Finally, these solvents cause problems for atmosphere purification units, and are hence challenging to employ in manufacturing.

An additional concern is the solubility of other components of multi-junction devices (such as organic, electron-accepting layers in photovoltaic devices) in high boiling point solvents such as DMF, the most commonly used perovskite solvent. Both C60 and PCBM are sparingly soluble in DMF. Upon deposition of the perovskite layer, this can cause two problems: (i) the almost complete washing away of the electron selective contact in the worst case scenario; or (ii) the formation of pinholes, and thus shunting pathways, in the best case scenario. Even if the partial washing away of the electron selective contact only occurs to a very small degree, this introduces another problem: irreproducibility in device performance due to constant changes in both the thickness and the uniformity of the n-type acceptor.

Multi-junction device architectures can increase the power conversion efficiency of photovoltaic cells beyond the single-junction thermodynamic limit that most currently commercial cells operate within. Monolithic tandem solar cells with solution processed perovskite layers have traditionally had to remain a combination of silicon PV cells with a single perovskite solar cell junction.

Metal halide perovskite semiconductors exhibit high performance when integrated in optoelectronic devices such as light-emitting-diodes (LEDs), photo-detectors, lasers and solar cells. These perovskites typically have a general chemical formula ABX₃ allowing their band gap to be tuned by substituting their chemical constituents, i.e. the A-site cation (methylammonium, formamidinium, cesium), B-site metal cation (lead or tin), or X-site anions (iodide, bromide, chloride). This enables halide perovskite semiconductors to be tuned to absorb specific regions of the solar spectrum, and employed in multiple-junction applications, which have the capability of surpassing the Shockley-Queisser and the Tiedje-Yablonovitch thermodynamic efficiency limits. By reducing the difference between the photon energy and the electronic band gap energy, the charge-carrier thermalization losses can be minimized, thus increasing the maximum obtainable power conversion efficiency (PCE). In order to reduce the conversion of photon energy into heat, multiple absorber materials with a wide range of band gaps are required. Recently, efficient solar cells employing wide-band gap perovskites have been fabricated by partial substitution of the organic A-site cation with cesium (Cs) to improve their structural, thermal, and light stability. Furthermore, narrow band gap materials have also been explored through modifications to the B-site cation, where the partial substitution of lead (Pb) with tin (Sn) results in an anomalous band gap bowing behavior, leading to band gaps approaching 1.2 eV.

Given the potential advantages afforded by perovskite semiconductors described above, in particular the ability to alter the chemical composition to tune the band gap as necessary, it is highly desirable to be able to construct all-perovskite multi-junction solar cells.

Recent interest in all-perovskite multi-junction solar cells has demonstrated that these devices are challenging to produce, particularly by solution-based methods. This is in part due to the inability to easily construct multiple junction solar cells, one on top of the other using solvents such as DMF and DMSO. DMF and DMSO are both strongly coordinating solvents used in the dissolution of perovskite salts. These solvents, used for processing uniform and high quality perovskite films, readily interpenetrate the layers upon which they are processed and this results in washing away, or chemically destructing, any perovskite layer already processed beneath.

Perovskite solar cells exhibiting record efficiencies have been processed via solution-based fabrication methods, reaching 23% in a single junction device. The ability to fabricate high quality absorber materials from solution-based processes, in combination with their exceptional optoelectronic properties, has led to the rapid rise of perovskite solar cells. In recent years, significant breakthroughs have been made in four-terminal (4T) and two-terminal (2T) perovskite-on-silicon, perovskite-on-Cu(In,Ga)Se₂ (CIGS), perovskite-on-Cu₂ZnSn(S,Se)₄ (CZTSSe) and also perovskite-on-perovskite tandem cells. Tandem solar cells require a semi-transparent electrode and/or recombination layers between each sub-cell, which can be fabricated using a variety of materials and processing methods. These highly conductive transparent layers have been fabricated using silver nanowires (Ag-NWs), N4,N4,N4",N4"-tetra([1,1'-biphenyl]-4-yl)-[1,1':4',1"-terphenyl]-4,4"-diamine doped 2,2'-(perfluoronaphthalene-2,6-diylidene) dimalononitrile (TaTm:F₆-TCNNQ), poly(3,4-ethylenedioxythiophene) polystyrene sulfonate (PEDOT:PSS), aluminum doped zinc oxide (AZO), and most notably indium tin oxide (ITO) . These materials can also be processed using different deposition techniques such as: spray-coating, film transfer lamination, vacuum deposition, and sputter coating. Sputtered ITO has gained considerable attraction due to its high optical transparency throughout the visible and near-infrared (NIR) region, combined with a low resistivity. Due to its dense and compact nature, the sputtered ITO can serve as a physical barrier to the solvents which are used to process the subsequent material layers. These solvents rapidly re-dissolve any underlying perovskite layers unless they are protected by a dense pin-hole free layer, such as indium oxide tin oxide (ITO).

As recently shown, monolithic all-perovskite tandem cells, with power conversion efficiencies (PCEs) of over 17%, can be fabricated using a dense, sputtered ITO layer. These sputter coated TCOs require high vacuum deposition systems and dense buffer layers comprised of nanoparticle (NP) or atomic layer deposition (ALD) layers to prevent the organic and perovskite layers from sputter damage. Furthermore, the lower refractive index of ITO, in comparison to the perovskite absorber layers, introduces significant internal reflective losses, thus limiting the maximum feasible power conversion efficiency. The redissolution problem has thus far prevented any experimental realization of an all-solution-processed multi-junction perovskite solar cell, without employing sputter coated ITO or other more complex processing techniques.

To date, it has not been possible to construct multiple junction all-perovskite solar cells entirely via solution processing. To try to protect the first perovskite layer, and allow the fabrication of all-perovskite solar cells a number of strategies have been employed as discussed below.

In Eperon et al. (Perovskite-perovskite tandem photovoltaics with optimized bandgaps, Science, 2016) to protect the underlying first perovskite layer from damage from the solvent used for deposition of the second perovskite layer, the recombination layer used comprises a layer of tin oxide sputter coated with indium tin oxide. This recombination layer provides a physical barrier between the perovskite layers through which solvents such as DMF/DMSO cannot pass. However, this requires more complicated processing techniques such as sputter coating which lead to a more complex, lengthy and costly manufacturing process.

In Heo et al. (CH3NH3PbBr3-CH3NH3PbI3 Perovskite-Perovskite Tandem Solar Cells with Exceeding 2.2 V Open Circuit Voltage, Adv. Mater. 2016, 28, 5121-5125) the issue of solvent damage to the underlying perovskite layer is circumvented by manufacturing the top and bottom parts of the solar cell separately, then laminating them together. A thick hole-transport layer is required to maintain adhesiveness between the front and back cells. The PCE obtained for these solar cells is around 10.8%. This process requires a more complex series of manufacturing steps, including lamination, and is therefore not fully solvent-based.

In Sheng et al, Monolithic Wide Band Gap Perovskite/Perovskite Tandem Solar Cells with Organic Recombination Layers, J. Phys. Chem. C 2017, 121, 27256-27262, to avoid solution processing the second perovskite layer with DMF, a sequential vapour-solution processing method is employed. The resulting tandem solar cell has a PCE of 5.9%. Such a process is not well suited to large-scale printing techniques as it requires thermal evaporation of the precursors.

In Jiang et al A two-terminal perovskite/perovskite tandem solar cell J. Mater. Chem 2016, 4, 1208-1213, anti-solvent quenching techniques are used to deposit the perovskite layers and a film transfer-lamination technique is utilised to place the recombination layer onto the bottom cell. These more complex techniques also prevent such a method being employed on a large scale.

None of these strategies provide a simple, all-solution method for preparing multi-junction devices.

### SUMMARY OF THE INVENTION

The present invention enables construction of A/M/X multi-junction devices without having to resort to complex processing techniques such as sputter coating, lamination or vapour deposition, thereby enabling an all-solution route to multi-junction devices that allows cheap and easy manufacture of such devices using conventional printing techniques, for instance solution processing manufacturing methodologies such as inkjet printing, spray-coating, slot dye coating, blade coating and gravure printing, as well as spin-coating. In particular, the invention provides both solution-processed perovskite layers, and solution-processed charge recombination layers including tunnel junctions.

By employing a highly volatile, low boiling point aprotic solvent/organic amine-based solvent system, it is shown that perovskite junctions can be stacked on one another to create all-solution processed all-perovskite multi-junction solar cells. The solvation strength of such a solvent system can be tuned by altering the amount of organic amine present. This means that the solvent used has the solvation strength necessary to dissolve the A/M/X precursor materials, but with minimal excess organic amine, thereby eliminating the risk of damage to the underlying layers in the device. Thus, the solvents used have been found to not wash off existing organic layers or underlying perovskite layers during the production of multi-junction devices. This improves the reproducibility and efficiency of produced devices.

The inventors have developed a recombination layer that can be disposed between the various photoactive layers using solution-based techniques. The charge recombination layer described herein is deposited using solution-based methods. This means that no complex techniques such as sputter-coating, lamination or vacuum deposition are required, making the multi-junction devices simpler to produce. In addition, it also means that thin (<100 nm) charge recombination layers can be manufactured leading to a reduction in internal reflective losses and an increase in power conversion efficiency.

This all-solution processed architecture has the potential of being applied to the manufacturing of large area films on both rigid and flexible substrates, using deposition techniques such as roll-to-roll (R2R) processing, blade coating, slot dye coating, gravure printing or inkjet printing. The invention therefore provides a route to fully solution-processed multi-junction solar cells. These findings open new possibilities for large-scale, low-cost, printable perovskite multi-junction solar cells.

Accordingly, the present invention provides a process for producing a multi-junction device comprising a layer of a crystalline A/M/X material, which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and wherein the process comprises forming the layer of the crystalline A/M/X material by disposing a film-forming solution on a substrate, wherein the film-forming solution comprises:
(a) one or more M cations; and
(b) a solvent;

wherein the solvent comprises
   (i) an aprotic solvent; and
   (ii) an organic amine
and wherein the substrate comprises: a photoactive region comprising a photoactive material,
and a charge recombination layer which is disposed on the photoactive region;
wherein the process further comprises a step of producing the substrate by disposing the charge recombination layer on the photoactive region by solution deposition, wherein said step comprises disposing a solvent dispersion of nanoparticles of a transparent conducting oxide on the photoactive region.

Also described herein is a multi-junction device obtainable or obtained by the process of the invention as defined above.

Also described herein is a multi-junction device comprising:
(a) at least two photoactive regions, wherein at least one of the photoactive regions comprises a layer of a crystalline A/M/X material which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and
(b) a charge recombination layer which comprises nanoparticles of a transparent conducting oxide.

In contrast to a dense, sputtered ITO layer which introduces significant internal reflective losses due to the lower refractive index of ITO compared to the A/M/X absorber layers, the nanoparticles result in a non-continuous layer which is not only solution-processable, but also able to scatter light through any subsequent light absorbing layers, thus increasing the light absorption of the device.

Also described herein is a multi-junction device comprising:
(a) at least two photoactive regions, wherein at least one of the photoactive regions comprises a layer of a crystalline A/M/X material which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18;
(b) a charge recombination layer which comprises a conducting polymer.

Also described herein is a multi-junction device comprising
(a) at least three photoactive regions, wherein each one of the photoactive regions comprises a layer of a crystalline A/M/X material which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and
(b) at least one charge recombination layer disposed between the photoactive regions.

The invention can also advantageously be employed to produce multi-junction light emitting devices, where multiple junctions of different band gap light emitting diodes result in a combined white light emission.

### BRIEF DESCRIPTION OF THE FIGURES

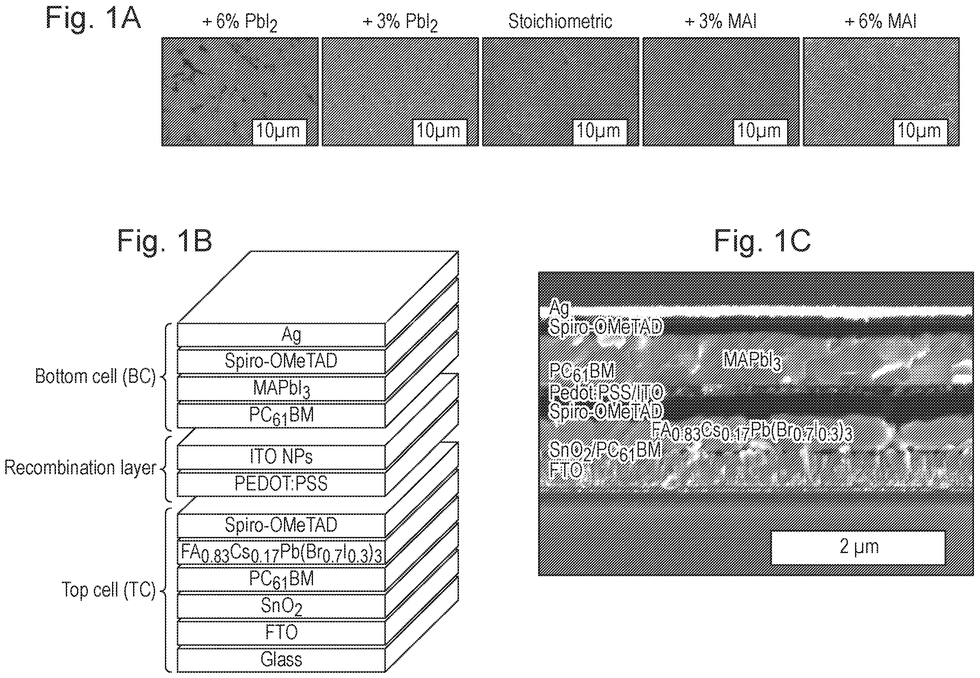

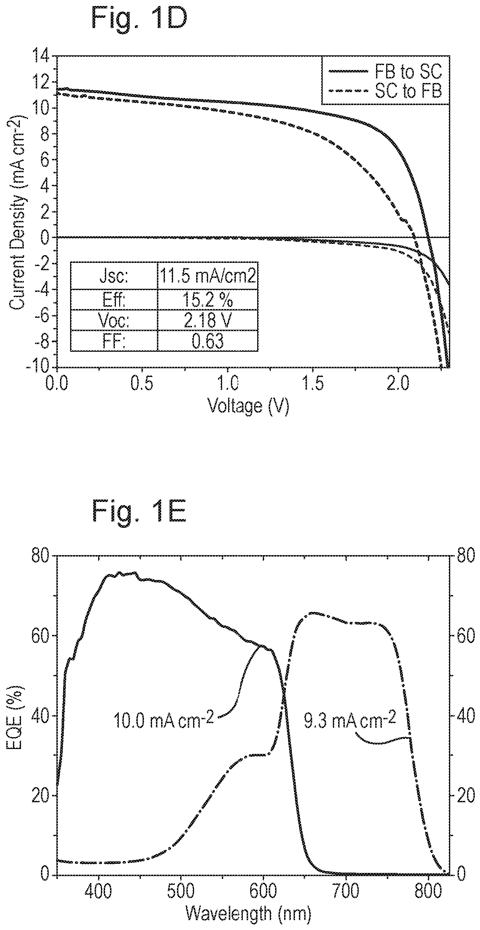

Figures 1A-E show results for two-terminal (2T) FA_{0.83}Cs_{0.17}Pb(Br_{0.7}I_{0.3})₃/MAPbI₃ (where MA=methylammonium, CH₃NH₃⁺) tandem perovskite solar cells. Fig. 1A shows a scanning electron microscopy (SEM) image of the top view of MAPbI₃ thin film deposited on top of the top-cell (TC) and interlayer, prepared using an acetonitrile(CH₃CN) / methylamine (CH₃NH₂) (ACN/MA) solvent system, ranging from a 6% relative molar excess of PbI₂ to a 6% relative molar excess of MAI, with respect to the stoichiometric molar ratio of 100: 100 MAI:PbI₂. Fig. 1B shows schematics showing an all-solution processed perovskite/perovskite two-terminal (2T) tandem perovskite solar cell. Incoming light will be from below the device. Fig. 1C shows an SEM cross-section of the 2T perovskite/perovskite tandem cell. Fig. 1D shows J-V characteristics for the champion FA_{0.83}Cs_{0.17}Pb(Br_{0.7}I_{0.3})₃/MAPbI₃ tandem heterojunction solar cell, with an applied mismatch factor of 1.004, measured at a 0.25 V/s scan rate. Fig. 1E shows an external quantum efficiency (EQE) spectrum for each sub-cell, and the integrated current density for the tandem perovskite solar cell.

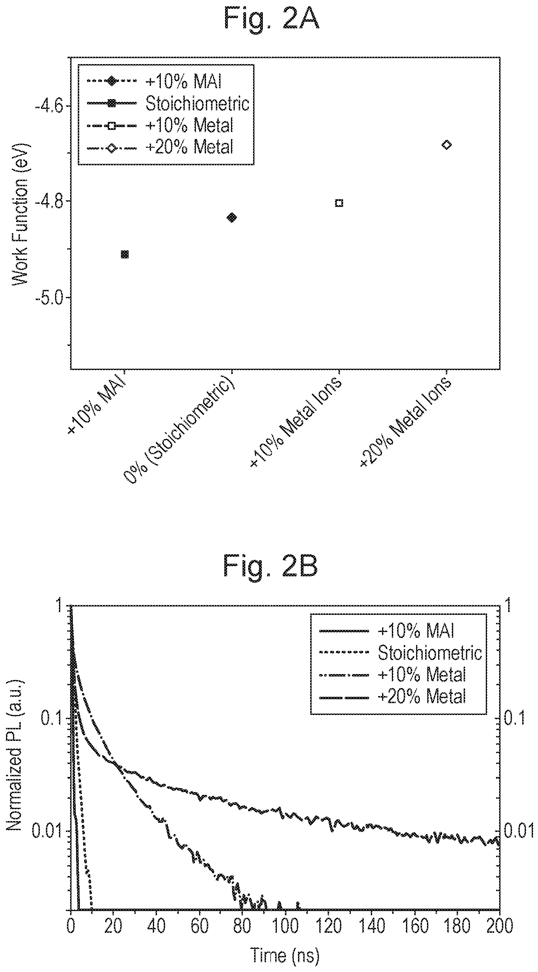

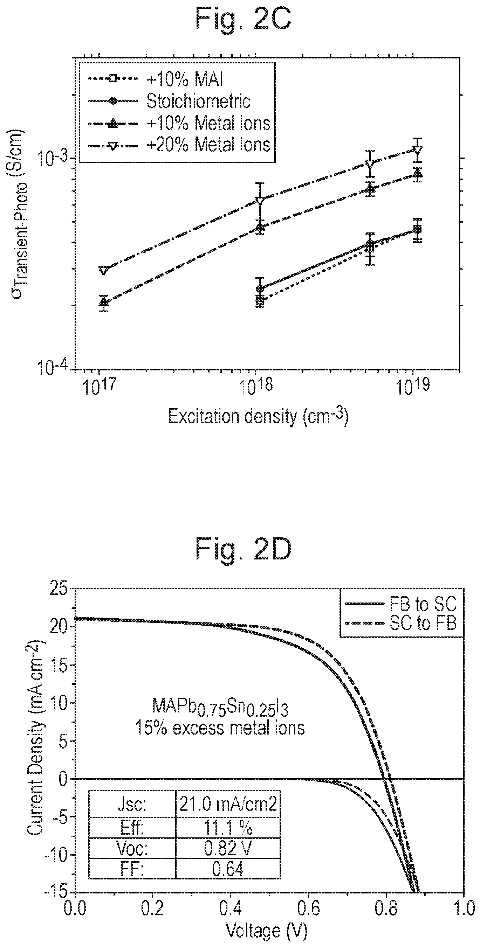

Figures 2A-D show the impact of varying the composition of A to B-site cations for ACN processed MAPb_{0.75}Sn_{0.25}I₃ perovskite materials. Fig. 2A) shows Kelvin-probe measurement of varying A to B-site stoichiometry Fig. 2B) shows normalized time-resolved photoluminescence (PL) measurements taken at the peak emission wavelength of varying A to B-site stoichiometry Fig. 2C) shows the impact of A to B-site stoichiometry on the transient photocurrent. Fig. 2D shows J-V characteristics of an optimized MAPb_{0.75}Sn_{0.25}I₃ single-junction heterojunction solar cell with 15% excess metal ions, measured at a 0.25 V/s scan rate.

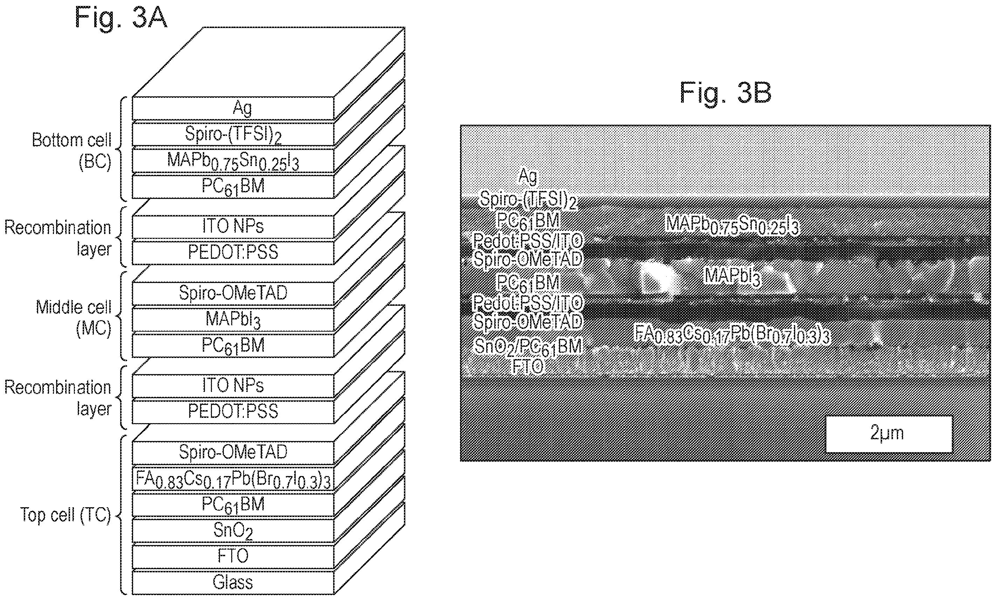

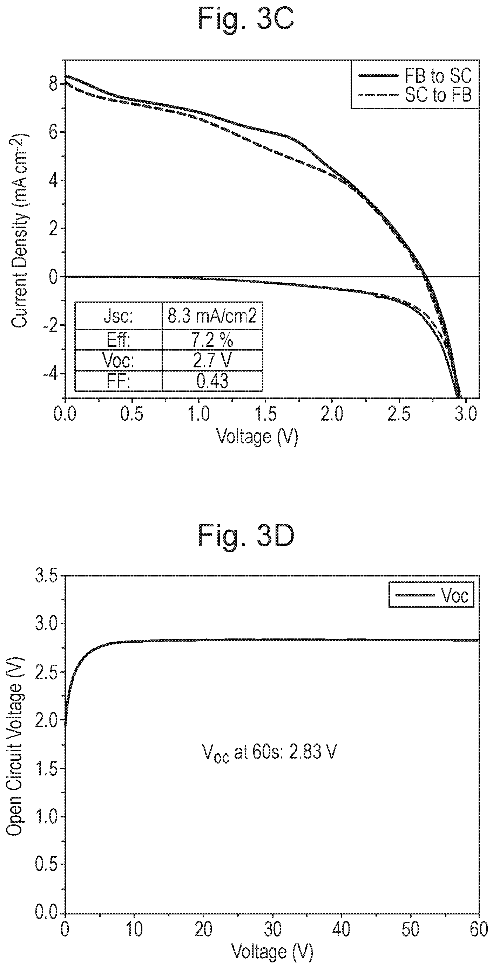

Figures 3A-D show FA_{0.83}Cs_{0.17}Pb(Br_{0.7}I_{0.3})₃/MAPbI₃/MAPb_{0.75}Sn_{0.25}I₃ triple-junction perovskite solar cells. Fig. 3A is a schematic showing an all-solution processed triple-junction two-terminal (2T) perovskite solar cell. Incoming light will be from below the device. Fig. 3B shows an SEM cross-section of the triple-junction 2T all-perovskite tandem. Fig. 3C shows J-V characteristics for the champion FA_{0.83}Cs_{0.17}Pb(Br_{0.7}I_{0.3})₃ / MAPbI₃ / MAPb_{0.75}Sn_{0.25}I₃ triple-junction heterojunction solar cell fabricated, with an applied mismatch factor of 1.323, measured at a 0.25 V/s scan rate. Fig. 3D shows the open circuit voltage (Voc) of the triple-junction heterojunction perovskite solar cell measured over a 60s time span.

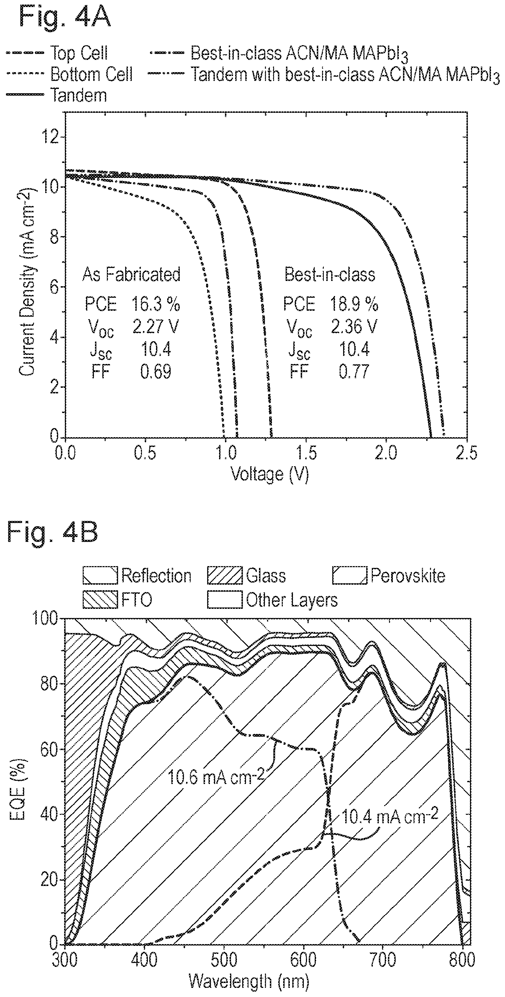

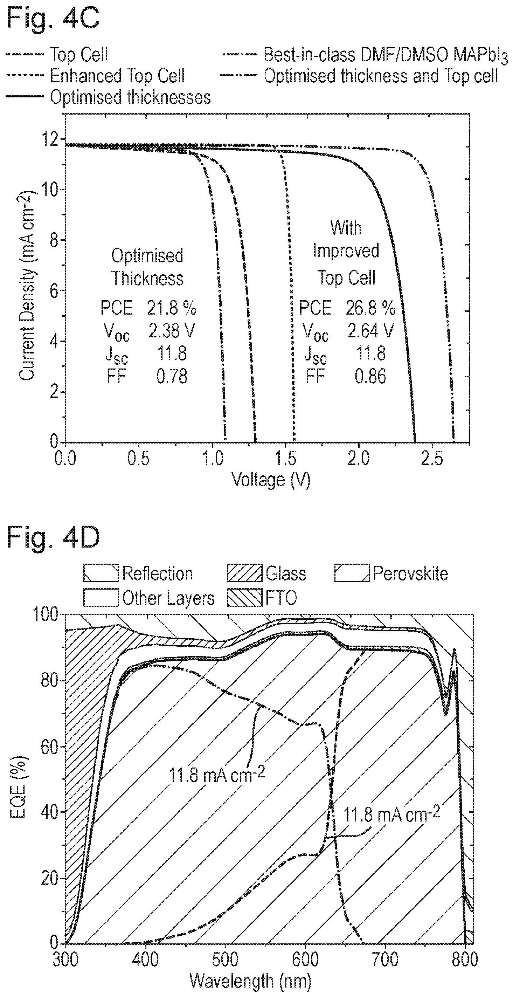

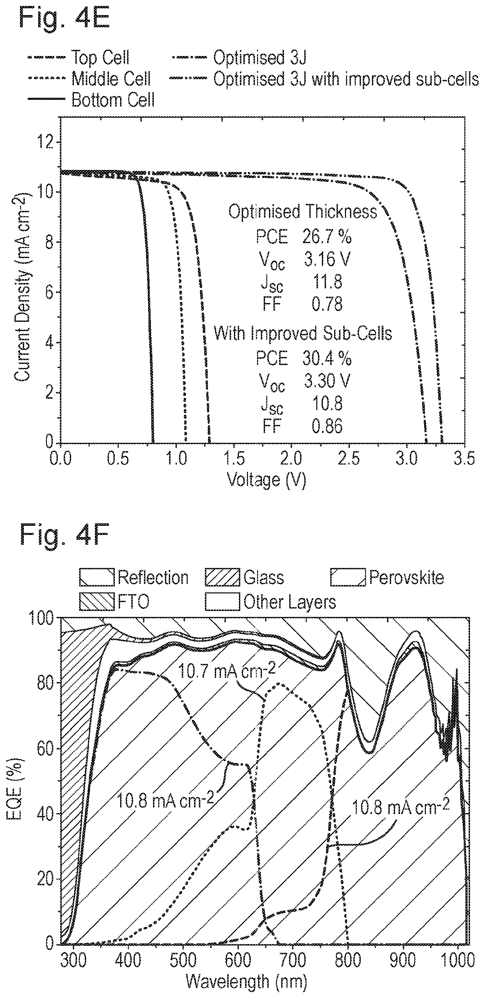

Figures 4A-F show the optical and electrical modelling of multi-junction perovskite solar cells. Fig. 4A shows calculated J-V characteristics and Fig. 4B shows the EQE spectrum for the fully-solution processed FA_{0.83}Cs_{0.17}Pb(Br_{0.7}I_{0.3})₃/MAPbI₃ tandem solar cell, with single junction experimental data and with best-in-class ACN/MA MAPbI₃ single junction cell. Fig. 4C shows calculated J-V characteristics and Fig. 4D shows the simulated EQE spectrum of a FA_{0.83}Cs_{0.17}Pb(Br_{0.7}I_{0.3})₃/MAPbI₃ tandem solar cell assuming optimized layers thicknesses, sub 50 nm interlayer, MgF₂ anti-reflection coating, and an enhanced top cell performance. Fig. 4E shows J-V characteristics and Fig. 4F shows the simulated EQE spectrum for a FA_{0.83}Cs_{0.17}Pb(Br_{0.7}I_{0.3})₃/MAPbI₃/FA_{0.6}MA_{0.4}Pb_{0.4}Sn_{0.6}I₃ triple-junction architecture, assuming optimized layers thicknesses, sub 50 nm interlayer, MgF₂ anti-reflection coating, and an enhanced top cell performance.

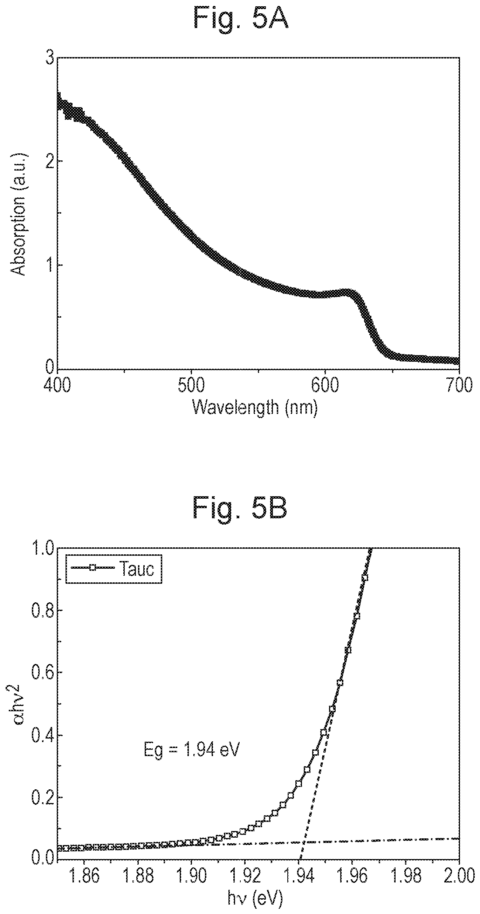

Figures 5A-B show optical characterization of FA_{0.83}Cs_{0.17}Pb(Br_{0.7}I_{0.3})₃ perovskite material with 2% potassium additive. Fig. 5A shows the absorption spectrum of FA_{0.83}Cs_{0.17}Pb(Br_{0.7}I_{0.3})₃ measured with an integration sphere. Fig. 5B shows the Tauc plot of FA_{0.83}Cs_{0.17}Pb(Br_{0.7}I_{0.3})₃ perovskite assuming direct band gap material and fitting of optical band gap from intercept.

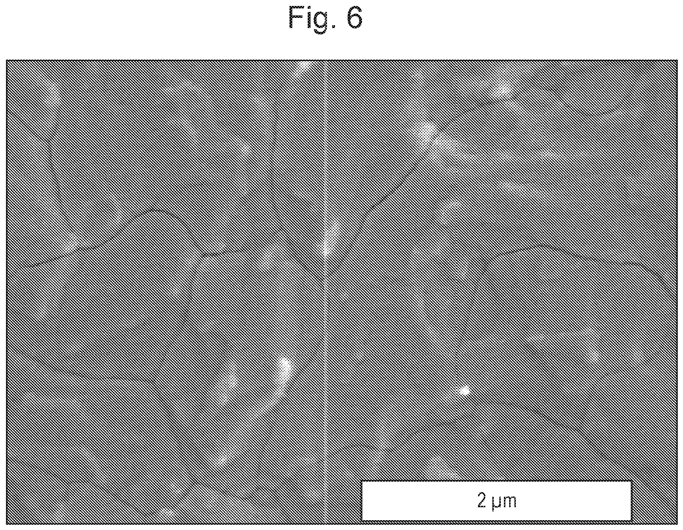

Figures 6 shows an SEM image of the top view of FA_{0.83}Cs_{0.17}Pb(Br_{0.7}I_{0.3})₃ perovskite film.

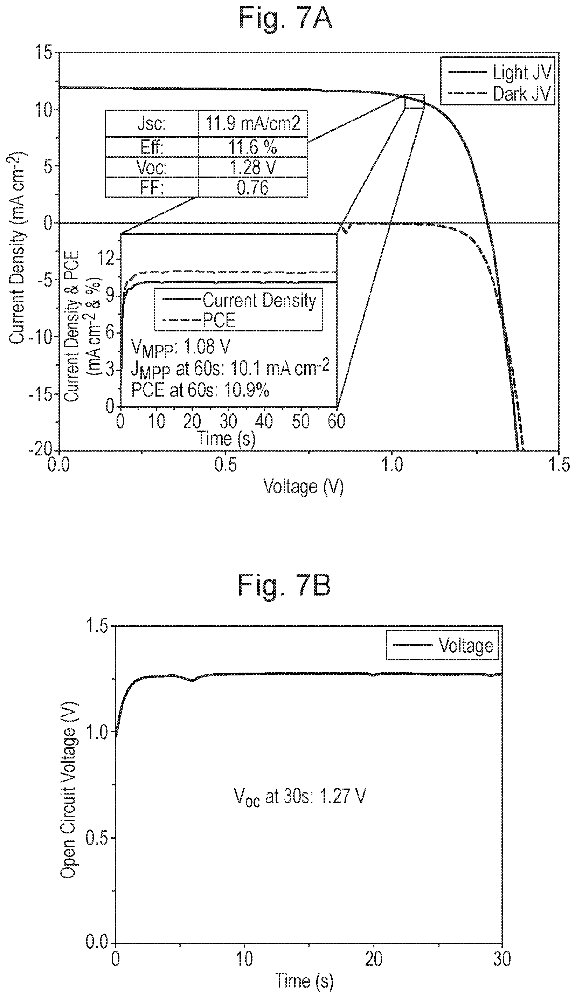

Figures 7A and 7B show current-voltage characteristic of a SnO₂/PCBM/FA_{0.83}Cs_{0.17}Pb(Br_{0.7}I_{0.3})₃/Spiro-OMeTAD perovskite solar cell with 2% mol. potassium (K⁺) additive. Fig. 7A shows forward bias to short-circuit current-voltage curve measured under simulated air-mass (AM) 1.5 100 mW cm⁻² sun light using a 0.25V/s scan rate. The inset figure shows the photocurrent density and power conversion efficiency measured at the maximum power point for a 60s time span. Fig. 7B shows the stabilized open circuit voltage (V_{oc}) of FA_{0.83}Cs_{0.17}Pb(Br_{0.7}I_{0.3})₃ heterojunction perovskite solar cell.

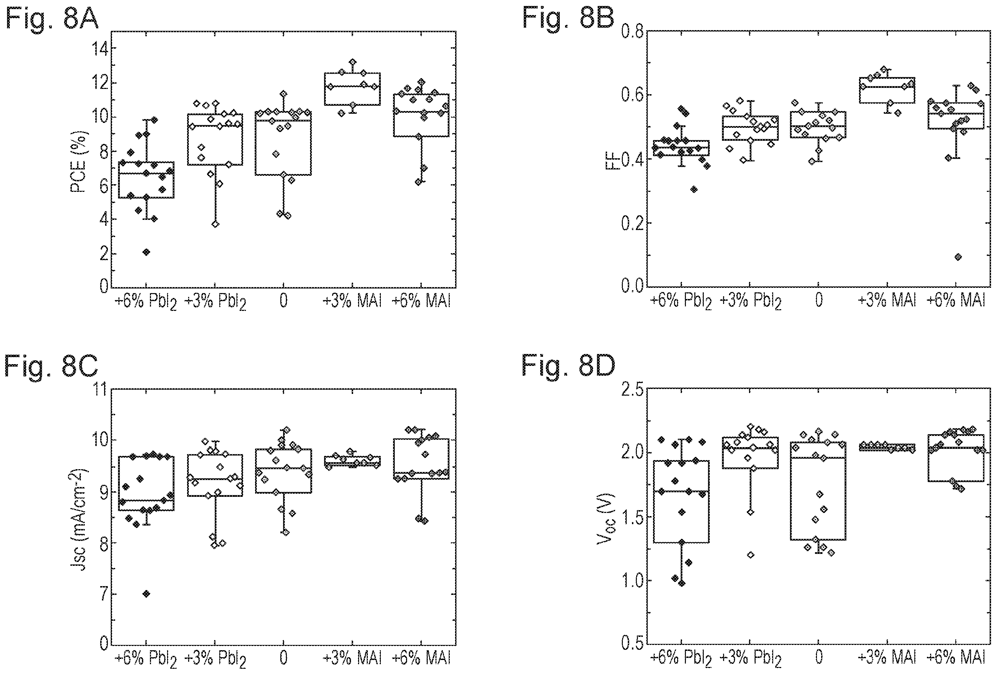

Figures 8A-D show the impact of varying the composition of A to B-site cations of the ACN/MA solvent processed MAPbI₃ perovskite absorber layer, which is incorporated into an all-perovskite tandem solar cell with an FA_{0.83}Cs_{0.17}Pb(Br_{0.7}I_{0.3})₃ front cell and a MAPbI₃ rear cell, with A) Power conversion efficiency B) Fill-factor C) Short-circuit current density D) Open-circuit voltage.

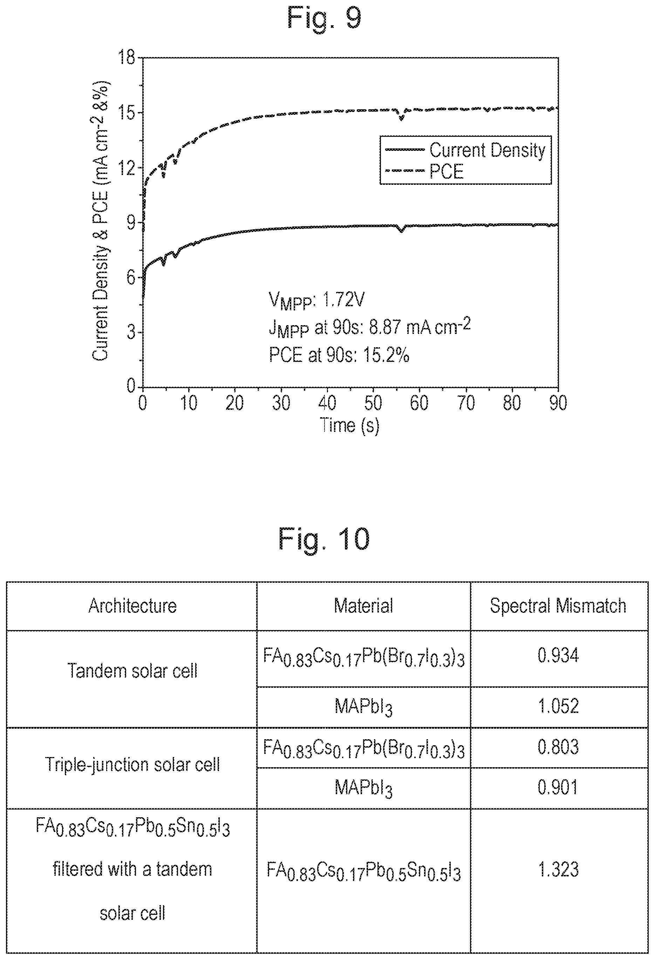

Figure 9 shows the photocurrent density and power conversion efficiency of champion FA_{0.83}Cs_{0.17}Pb(Br_{0.7}I_{0.3})₃/MAPbI₃ dual-junction solar cells measured at the maximum power point for a 90 s time span. A mismatch factor of 1.004 has been applied to the PCE.
Figure 10 shows a table of the calculated mismatch factors for the tandem perovskite solar cell and the triple-junction perovskite solar cell. Mismatch factors were calculated for the following perovskite materials FA_{0.83}Cs_{0.17}Pb(Br_{0.7}I_{0.3})₃, MAPbI₃, and FA_{0.83}Cs_{0.17}Pb_{0.5}Sn_{0.5}I₃. The spectrum and calibration are different for both measurements, since KG2 and KG5 filters were used to mitigate and account for the large intensity spikes in the infrared emission of the xenon arc lamp solar simulator.

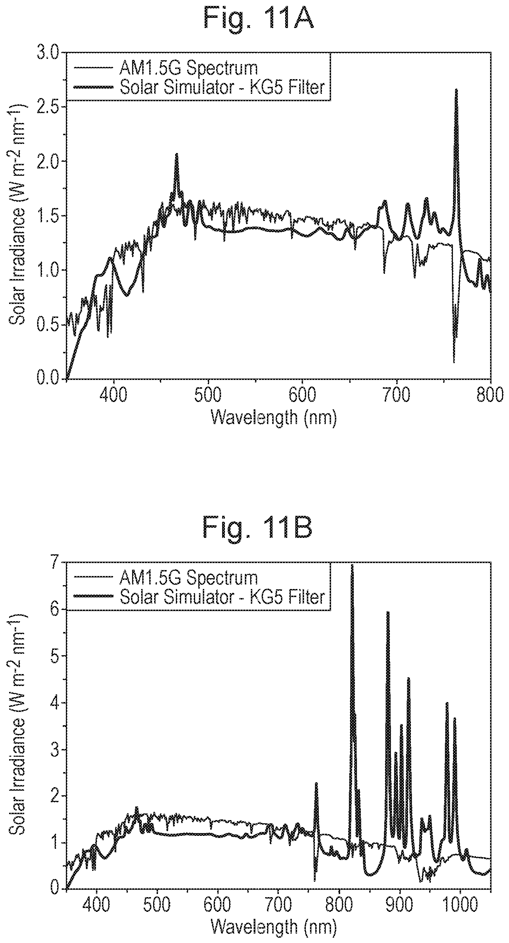

Figures 11A and 11B show the measured solar simulator spectrum compared to the AM1.5G spectrum. Fig. 11A Xenon lamp spectrum where the intensity is set with the KG5 filtered silicon reference cell, used for the measurement of the FA_{0.83}Cs_{0.17}Pb(Br_{0.7}I_{0.3})₃/MAPbI₃ tandem solar cell. Fig. 11B shows the Xenon lamp spectrum with the intensity set by the KG2 filtered reference cell, used for the measurement of the FA_{0.83}Cs_{0.17}Pb(Br_{0.7}I_{0.3})₃/MAPbI₃/MAPb_{0.75}Sn_{0.25}I₃ triple-junction solar cell.

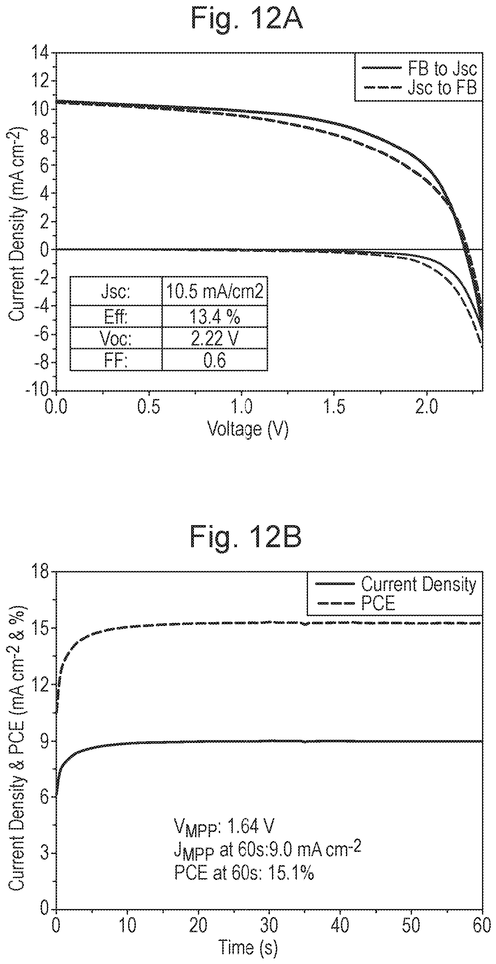

Figures 12A and 12B show device performance of a FA_{0.83}Cs_{0.17}Pb(Br_{0.7}I_{0.3})₃/MAPbI₃ tandem solar cell with the highest open circuit voltage. Fig. 12A shows current-voltage characteristics, measured under simulated air-mass (AM) 1.5 100 mW cm⁻² sun light using a 0.25V/s scan rate. Fig. 12B shows the photocurrent density and power conversion efficiency measured at the maximum power point for a 60 s time span. A mismatch factor of 1.004 has been applied to the PCE.

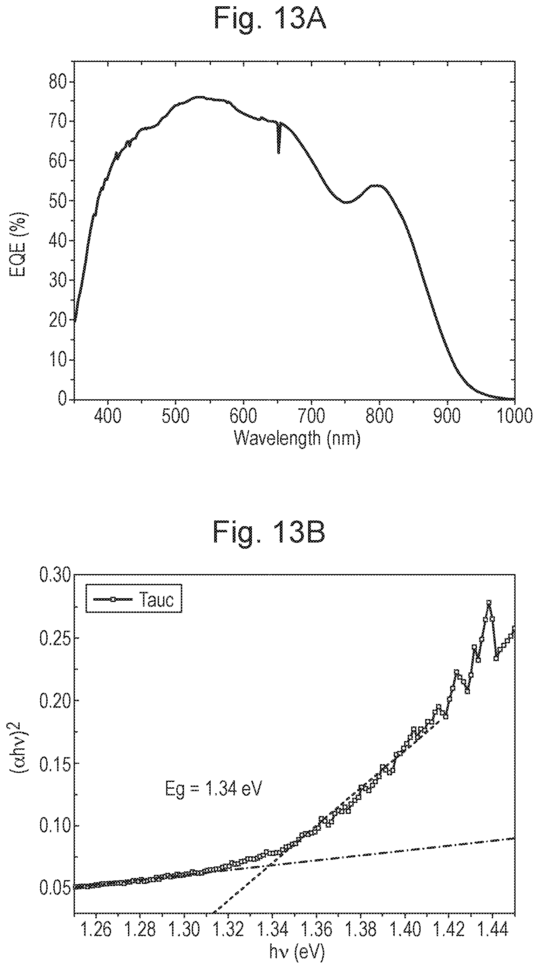

Figures 13A and 13B show the characterization of MAPb_{0.75}Sn_{0.25}I₃ perovskite material. Fig. 13A shows the EQE spectrum for a FTO/SnO₂/PC₆₁BM/MAPb_{0.75}Sn_{0.75}I₃/Spiro(TFSI)₂ solar cell architecture, measured using a 50 Ω resistive load. Fig. 13B shows the Tauc plot of MAPb_{0.75}Sn_{0.25}I₃ perovskite material assuming direct band gap material.

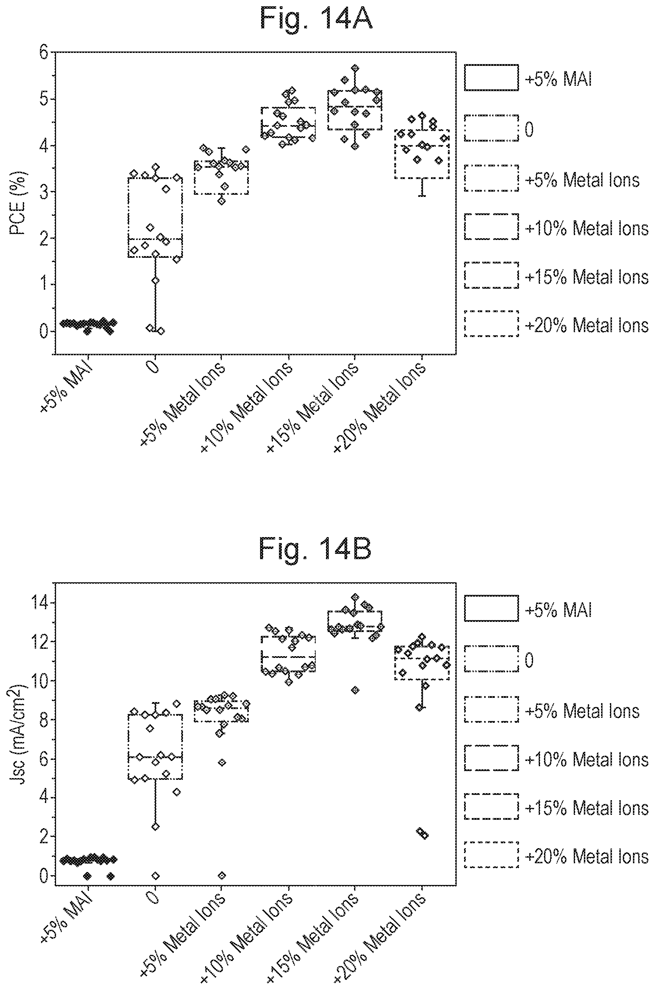

Figures 14A-D show the impact of varying the composition of A to B-site cations of the ACN/MA MAPb_{0.75}Sn_{0.25}I₃ perovskite single junction solar cell on A) power conversion efficiency B) fill-factor C) short-circuit current density D) open-circuit voltage.

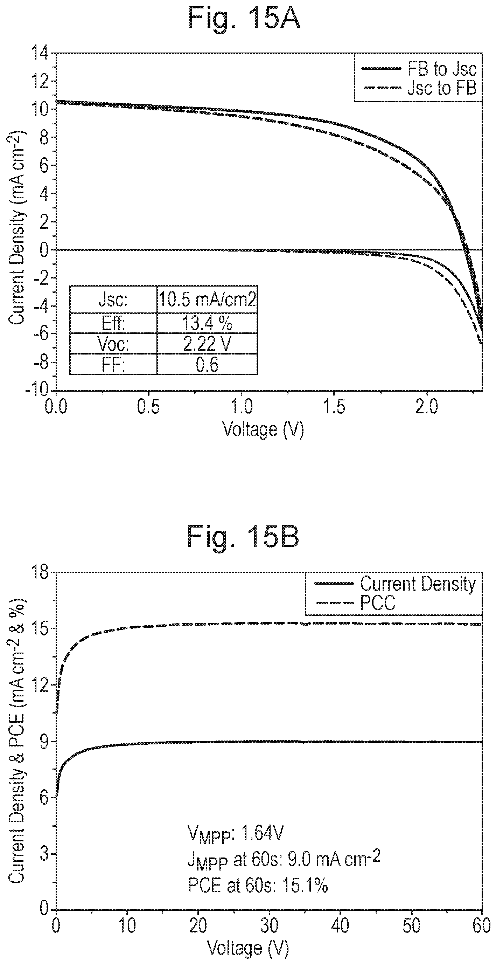

Figures 15A and 15B show the device performance of a FA_{0.83}Cs_{0.17}Pb(Br_{0.7}I_{0.3})₃/MAPbI₃/MAPb_{0.75}Sn_{0.25}I₃ triple-junction solar cell with the highest open circuit voltage. Fig. 15A shows the current-voltage characteristic, measured under simulated air-mass (AM) 1.5 100 mW cm⁻² sun light using a 0.25V/s scan rate. Fig. 15B shows the photocurrent density and power conversion efficiency measured at the maximum power point for a 60s time span. A mismatch factor of 1.323 has been applied to the PCE.

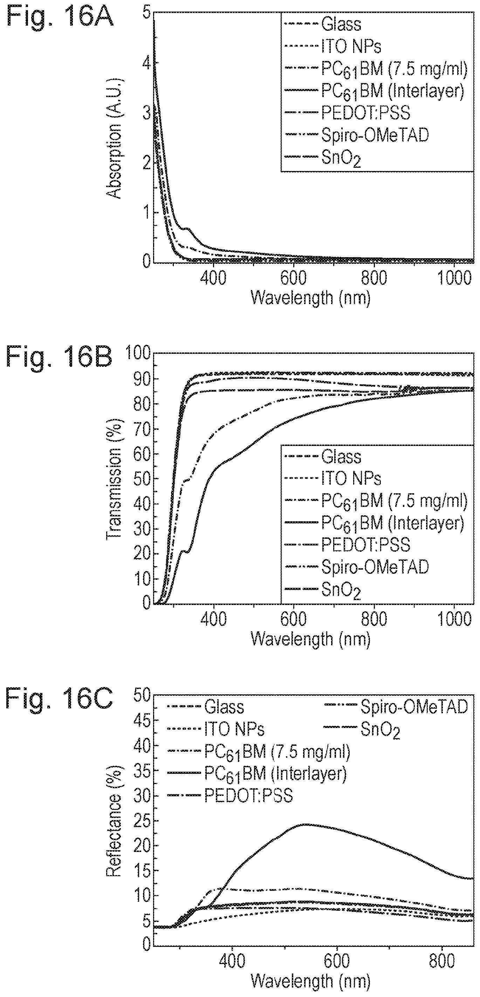

Figures 16A-C show the optical properties of the recombination interlayer and hole and electron accepting layers. Fig. 16A shows the absorption measured from 250nm to 1050nm of glass, indium-tin oxide nanoparticles (ITO NPs), phenyl-C61-butyric acid methyl ester (PC₆₁BM), phenyl-C61-butyric acid methyl ester (PC₆₁BM), poly(3,4-ethylenedioxythiophene) polystyrene sulfonate (PEDOT:PSS), (2,2',7,7'-tetrakis(N,N'-di-p-methoxyphenylamine)-9,9'-spirobifluorene) (Spiro-OMeTAD). Fig. 16B shows the transmission measurement. Fig. 16C shows the reflectance measurement.

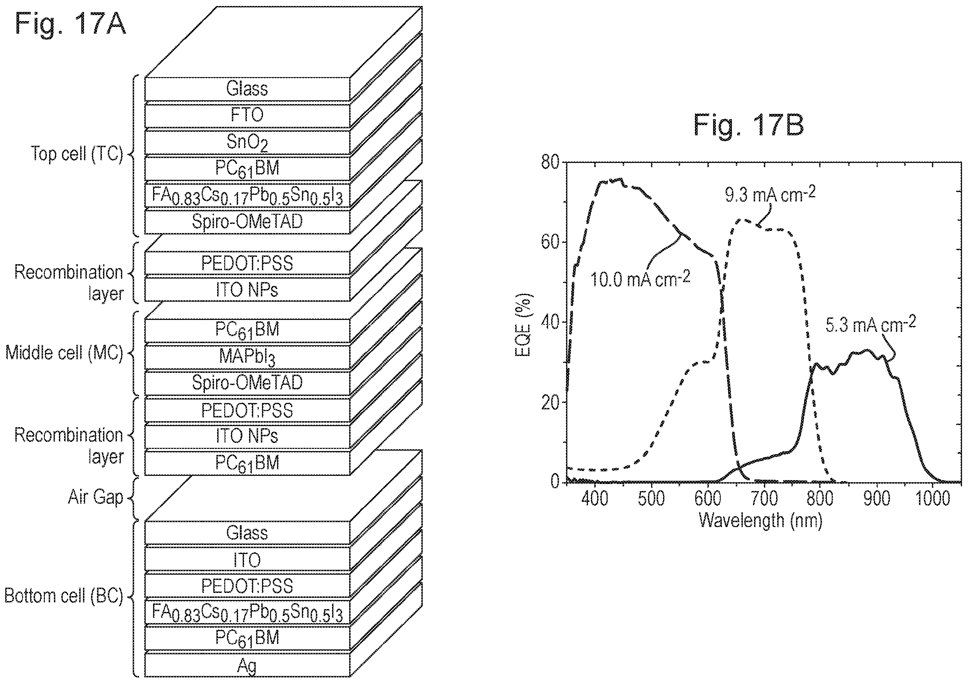

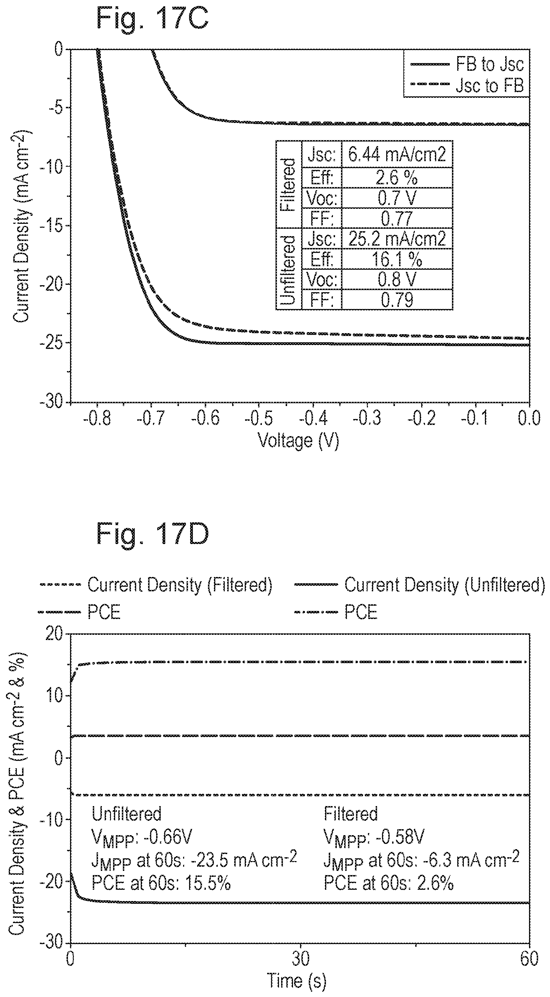

Figures 17A-D show the architecture and device characterization of a FA_{0.83}Cs_{0.17}Pb_{0.5}Sn_{0.5}I₃ filtered with a FA_{0.83}Cs_{0.17}Pb(Br_{0.7}I_{0.3})₃/MAPbI₃ dual-junction solar cell. Fig. 17A is a schematic showing the filtering of the FA_{0.83}Cs_{0.17}Pb_{0.5}Sn_{0.5}I₃ perovskite with an all-solution processed perovskite/perovskite two-terminal (2T) FA_{0.83}Cs_{0.17}Pb(Br_{0.7}I_{0.3})₃/MAPbI₃ tandem perovskite solar cell. Fig. 17B shows the EQE spectrum for a FA_{0.83}Cs_{0.17}Pb_{0.5}Sn_{0.5}I₃ (solid line) filtered with a FA_{0.83}Cs_{0.17} Pb(Br_{0.7}I_{0.3})₃/MAPbI₃ dual-junction solar cell, and the integrated current density for the tandem perovskite solar cell. Also shown is the EQE spectrum for each sub-cell of the FA_{0.83}Cs_{0.17}Pb(Br_{0.7}I_{0.3})₃/MAPbI₃ tandem perovskite solar cell with an opaque electrode, and the integrated current density for the tandem perovskite solar cell. Fig. 17C shows the J-V characteristics for the champion a FA_{0.83}Cs_{0.17}Pb_{0.5}Sn_{0.5}I₃ unfiltered and filtered with a FA_{0.83}Cs_{0.17}Pb(Br_{0.7}I_{0.3})₃/MAPbI₃ dual-junction solar cell fabricated, measured at a 0.25 V/s scan rate. Fig. 17D shows the photocurrent density and power conversion efficiency measured at the maximum power point for a 60s time span of the FA_{0.83}Cs_{0.17}Pb_{0.5}Sn_{0.5}I₃ unfiltered and filtered solar cell. A mismatch factor of 1.323 has been applied to the PCE.

### DETAILED DESCRIPTION OF THE INVENTION

### Definitions

The term "crystalline" as used herein indicates a crystalline compound, which is a compound having an extended 3D crystal structure. A crystalline compound is typically in the form of crystals or, in the case of a polycrystalline compound, crystallites (i.e. a plurality of crystals having particle sizes of less than or equal to 1 µm). The crystals together often form a layer. The crystals of a crystalline material may be of any size. Where the crystals have one or more dimensions in the range of from 1 nm up to 1000 nm, they may be described as nanocrystals.

The terms "organic compound" and "organic solvent" as used herein have their typical meaning in the art and would readily be understood by the skilled person.

The term "crystalline A/M/X material", as used herein, refers to a material with a crystal structure which comprises one or more A ions, one or more M ions, and one or more X ions. A ions and M ions are cations. X ions are anions. A/M/X materials typically do not comprise any further types of ions.

The term "perovskite", as used herein, refers to a material with a three-dimensional crystal structure related to that of CaTiO₃ or a material comprising a layer of material, which layer has a structure related to that of CaTiO₃. The structure of CaTiO₃ can be represented by the formula ABX₃, wherein A and B are cations of different sizes and X is an anion. In the unit cell, the A cations are at (0,0,0), the B cations are at (1/2, 1/2, 1/2) and the X anions are at (1/2, 1/2, 0). The A cation is usually larger than the B cation. The skilled person will appreciate that when A, B and X are varied, the different ion sizes may cause the structure of the perovskite material to distort away from the structure adopted by CaTiO₃ to a lower-symmetry distorted structure. The symmetry will also be lower if the material comprises a layer that has a structure related to that of CaTiO₃. Materials comprising a layer of perovskite material are well known. For instance, the structure of materials adopting the K₂NiF₄-type structure comprises a layer of perovskite material. The skilled person will appreciate that a perovskite material can be represented by the formula [A][B][X]₃, wherein [A] is at least one cation, [B] is at least one cation and [X] is at least one anion. When the perovskite comprise more than one A cation, the different A cations may distributed over the A sites in an ordered or disordered way. When the perovskite comprises more than one B cation, the different B cations may distributed over the B sites in an ordered or disordered way. When the perovskite comprise more than one X anion, the different X anions may distributed over the X sites in an ordered or disordered way. The symmetry of a perovskite comprising more than one A cation, more than one B cation or more than one X cation, will be lower than that of CaTiO₃. For layered perovskites the stoichiometry can change between the A, B and X ions. As an example, the [A]₂[B][X]₄ structure can be adopted if the A cation has a too large an ionic radii to fit within the 3D perovskite structure. The term "perovskite" also includes A/M/X materials adopting a Ruddleson-Popper phase. Ruddleson-Popper phase refers to a perovskite with a mixture of layered and 3D components. Such perovskites can adopt the crystal structure, Aₙ₋₁A'₂MₙX₃ₙ₊₁, where A and A' are different cations and n is an integer from 1 to 8, or from 2 to 6. The term "mixed 2D and 3D" perovskite is used to refer to a perovskite film within which there exists both regions, or domains, of AMX₃ and Aₙ₋₁A'₂MₙX₃ₙ₊₁ perovskite phases.

The term "metal halide perovskite", as used herein, refers to a perovskite, the formula of which contains at least one metal cation and at least one halide anion.

The term "mixed halide perovskite" as used herein refers to a perovskite or mixed perovskite which contains at least two types of halide anion.

The term "mixed cation perovskite" as used herein refers to a perovskite of mixed perovskite which contains at least two types of A cation.

The term "mixed metal perovskite" as used herein refers to a perovskite of mixed perovskite which contains at least two types of metal M cations.

The term "organic-inorganic metal halide perovskite", as used herein, refers to a metal halide perovskite, the formula of which contains at least one organic cation.

The term "monocation", as used herein, refers to any cation with a single positive charge, i.e. a cation of formula A⁺ where A is any moiety, for instance a metal atom or an organic moiety. The term "dication", as used herein, refers to any cation with a double positive charge, i.e. a cation of formula A²⁺ where A is any moiety, for instance a metal atom or an organic moiety. The term "trication", as used herein, refers to any cation with a triple positive charge, i.e. a cation of formula A³⁺ where A is any moiety, for instance a metal atom or an organic moiety. The term "tetracation", as used herein, refers to any cation with a quadruple positive charge, i.e. a cation of formula A⁴⁺ where A is any moiety, for instance a metal atom.

The term "alkyl", as used herein, refers to a linear or branched chain saturated hydrocarbon radical. An alkyl group may be a C₁₋₂₀ alkyl group, a C₁₋₁₄ alkyl group, a C₁₋₁₀ alkyl group, a C₁₋₆ alkyl group or a C₁₋₄ alkyl group. Examples of a C₁₋₁₀ alkyl group are methyl, ethyl, propyl, butyl, pentyl, hexyl, heptyl, octyl, nonyl or decyl. Examples of C₁₋₆ alkyl groups are methyl, ethyl, propyl, butyl, pentyl or hexyl. Examples of C₁₋₄ alkyl groups are methyl, ethyl, i-propyl, n-propyl, t-butyl, s-butyl or n-butyl. If the term "alkyl" is used without a prefix specifying the number of carbons anywhere herein, it has from 1 to 6 carbons (and this also applies to any other organic group referred to herein).

The term "cycloalkyl", as used herein, refers to a saturated or partially unsaturated cyclic hydrocarbon radical. A cycloalkyl group may be a C₃₋₁₀ cycloalkyl group, a C₃₋₈ cycloalkyl group or a C₃₋₆ cycloalkyl group. Examples of a C₃₋₈ cycloalkyl group include cyclopropyl, cyclobutyl, cyclopentyl, cyclohexyl, cyclohexenyl, cyclohex-1,3-dienyl, cycloheptyl and cyclooctyl. Examples of a C₃₋₆ cycloalkyl group include cyclopropyl, cyclobutyl, cyclopentyl, and cyclohexyl.

The term "alkenyl", as used herein, refers to a linear or branched chain hydrocarbon radical comprising one or more double bonds. An alkenyl group may be a C₂₋₂₀ alkenyl group, a C₂₋₁₄ alkenyl group, a C₂₋₁₀ alkenyl group, a C₂₋₆ alkenyl group or a C₂₋₄ alkenyl group. Examples of a C₂₋₁₀ alkenyl group are ethenyl (vinyl), propenyl, butenyl, pentenyl, hexenyl, heptenyl, octenyl, nonenyl or decenyl. Examples of C₂₋₆ alkenyl groups are ethenyl, propenyl, butenyl, pentenyl or hexenyl. Examples of C₂₋₄ alkenyl groups are ethenyl, i-propenyl, n-propenyl, s-butenyl or n-butenyl. Alkenyl groups typically comprise one or two double bonds.

The term "alkynyl", as used herein, refers to a linear or branched chain hydrocarbon radical comprising one or more triple bonds. An alkynyl group may be a C₂₋₂₀ alkynyl group, a C₂₋₁₄ alkynyl group, a C₂₋₁₀ alkynyl group, a C₂₋₆ alkynyl group or a C₂₋₄ alkynyl group. Examples of a C₂₋₁₀ alkynyl group are ethynyl, propynyl, butynyl, pentynyl, hexynyl, heptynyl, octynyl, nonynyl or decynyl. Examples of C₁₋₆ alkynyl groups are ethynyl, propynyl, butynyl, pentynyl or hexynyl. Alkynyl groups typically comprise one or two triple bonds.

The term "aryl", as used herein, refers to a monocyclic, bicyclic or polycyclic aromatic ring which contains from 6 to 14 carbon atoms, typically from 6 to 10 carbon atoms, in the ring portion. Examples include phenyl, naphthyl, indenyl, indanyl, anthrecenyl and pyrenyl groups. The term "aryl group", as used herein, includes heteroaryl groups.

The term "heteroaryl", as used herein, refers to monocyclic or bicyclic heteroaromatic rings which typically contains from six to ten atoms in the ring portion including one or more heteroatoms. A heteroaryl group is generally a 5- or 6-membered ring, containing at least one heteroatom selected from O, S, N, P, Se and Si. It may contain, for example, one, two or three heteroatoms. Examples of heteroaryl groups include pyridyl, pyrazinyl, pyrimidinyl, pyridazinyl, furanyl, thienyl, pyrazolidinyl, pyrrolyl, oxazolyl, oxadiazolyl, isoxazolyl, thiadiazolyl, thiazolyl, isothiazolyl, imidazolyl, pyrazolyl, quinolyl and isoquinolyl.

The term "substituted", as used herein in the context of substituted organic groups, refers to an organic group which bears one or more substituents selected from C₁₋₁₀ alkyl, aryl (as defined herein), cyano, amino, nitro, C₁₋₁₀ alkylamino, di(C₁₋₁₀)alkylamino, arylamino, diarylamino, aryl(C₁₋₁₀)alkylamino, amido, acylamido, hydroxy, oxo, halo, carboxy, ester, acyl, acyloxy, C₁₋₁₀ alkoxy, aryloxy, halo(C₁₋₁₀)alkyl, sulfonic acid, thiol, C₁₋₁₀ alkylthio, arylthio, sulfonyl, phosphoric acid, phosphate ester, phosphonic acid and phosphonate ester. Examples of substituted alkyl groups include haloalkyl, perhaloalkyl, hydroxyalkyl, aminoalkyl, alkoxyalkyl and alkaryl groups. When a group is substituted, it may bear 1, 2 or 3 substituents. For instance, a substituted group may have 1 or 2 substitutents.

The term "halide" as used herein indicates the singly charged anion of an element in group VIII of the periodic table. "Halide" includes fluoride, chloride, bromide and iodide.

The term "halo" as used herein indicates a halogen atom. Exemplary halo species include fluoro, chloro, bromo and iodo species.

As used herein, an amino group is a radical of formula -NR₂, wherein each R is a substituent. R is usually selected from hydrogen, alkyl, alkenyl, cycloalkyl, or aryl, wherein each of alkyl, alkenyl, cycloalkyl and aryl are as defined herein. Typically, each R is selected from hydrogen, C₁₋₁₀ alkyl, C₂₋₁₀ alkenyl, and C₃₋₁₀ cycloalkyl. Preferably, each R is selected from hydrogen, C₁₋₆ alkyl, C₂₋₆ alkenyl, and C₃₋₆ cycloalkyl. More preferably, each R is selected from hydrogen and C₁₋₆ alkyl.

A typical amino group is an alkylamino group, which is a radical of formula -NR₂ wherein at least one R is an alkyl group as defined herein. A C₁₋₆ alkylamino group is an alkylamino group wherein at least one R is an C₁₋₆ alkyl group.

As used herein, an imino group is a radical of formula R₂C=N- or -C(R)=NR, wherein each R is a substituent. That is, an imino group is a radical comprising a C=N moiety, having the radical moiety either at the N atom or attached to the C atom of said C=N bond. R is as defined herein: that is, R is usually selected from hydrogen, alkyl, alkenyl, cycloalkyl, or aryl, wherein each of alkyl, alkenyl, cycloalkyl and aryl are as defined herein. Typically, each R is selected from hydrogen, C₁₋₁₀ alkyl, C₂₋₁₀ alkenyl, and C₃₋₁₀ cycloalkyl. Preferably, each R is selected from hydrogen, C₁₋₆ alkyl, C₂₋₆ alkenyl, and C₃₋₆ cycloalkyl. More preferably, each R is selected from hydrogen and C₁₋₆ alkyl.

A typical imino group is an alkylimino group, which is a radical of formula R₂C=N- or - C(R)=NR wherein at least one R is an alkyl group as defined herein. A C₁₋₆ alkylimino group is an alkylimino group wherein the R substituents comprise from 1 to 6 carbon atoms.

The term "ester" as used herein indicates an organic compound of the formula alkyl-C(=O)-O-alkyl, wherein the alkyl radicals are the same or different and are as defined herein. The alkyl radicals may be optionally substituted.

The term "ether" as used herein indicates an oxygen atom substituted with two alkyl radicals as defined herein. The alkyl radicals may be optionally substituted, and may be the same or different.

As used herein, the term "ammonium" indicates an organic cation comprising a quaternary nitrogen. An ammonium cation is a cation of formula R¹R²R³R⁴N⁺. R¹, R², R³, and R⁴ are substituents. Each of R¹, R², R³, and R⁴ are typically independently selected from hydrogen, or from optionally substituted alkyl, alkenyl, aryl, cycloalkyl, cycloalkenyl and amino; the optional substituent is preferably an amino or imino substituent. Usually, each of R¹, R², R³, and R⁴ are independently selected from hydrogen, and optionally substituted C₁₋₁₀ alkyl, C₂₋₁₀ alkenyl, C₃₋₁₀ cycloalkyl, C₃₋₁₀ cycloalkenyl, C₆₋₁₂ aryl and C₁₋₆ amino; where present, the optional substituent is preferably an amino group; particularly preferably C₁₋₆ amino. Preferably, each of R¹, R², R³, and R⁴ are independently selected from hydrogen, and unsubstituted C₁₋₁₀ alkyl, C₂₋₁₀ alkenyl, C₃₋₁₀ cycloalkyl, C₃₋₁₀ cycloalkenyl, C₆₋₁₂ aryl and C₁₋₆ amino. In a particularly preferred embodiment, R¹, R², R³, and R⁴ are independently selected from hydrogen, C₁₋₁₀ alkyl, and C₂₋₁₀ alkenyl and C₁₋₆ amino. Further preferably, R¹, R², R³, and R⁴ are independently selected from hydrogen, C₁₋₆ alkyl, C₂₋₆ alkenyl and C₁₋₆ amino.

As used herein, the term "iminium" indicates an organic cation of formula (R¹R²C=NR³R⁴)⁺, wherein R¹, R², R³, and R⁴ are as defined in relation to the ammonium cation. Thus, in a particularly preferred embodiment, of the iminium cation, R¹, R², R³, and R⁴ are independently selected from hydrogen, C₁₋₁₀ alkyl, C₂₋₁₀ alkenyl and C₁₋₆ amino. In a further preferable embodiment of the iminium cation, R¹, R², R³, and R⁴ are independently selected from hydrogen, C₁₋₆ alkyl, C₂₋₆ alkenyl and C₁₋₆ amino. Often, the iminium cation is formamidinium, i.e. R¹ is NH₂ and R², R³ and R⁴ are all H.

The term "multi-junction device", as used herein, refers to a single device comprising two or more optoelectronic devices, connected electronically in series with each other and positioned sequentially on top of each other. The optoelectronic device could comprise a perovskite absorber layer sandwiched between a hole and electron accepting layer. A charge recombination layer which may be a tunnel junction, separates each optoelectronic device within the multi-junction device, which are stacked on top of each other in the multi-junction device. It is typically that the band gaps of the optoelectronic semiconductors in the multi-junction device will be different from one another.

Examples of multi -junction devices include a photovoltaic device, a solar cell, a photovoltaic diode, a photo detector, a photodiode, a photosensor, a chromogenic device, a light emitting transistor, a light-sensitive transistor, a phototransistor, a solid state triode, a light-emitting device, a laser or a light-emitting diode. The terms "solar cell" and "photovoltaic diode" are used interchangeably herein. The term "optoelectronic device", as used herein, refers to devices which source, control or detect light. Light is understood to include any electromagnetic radiation. Examples of optoelectronic devices include photovoltaic devices, photodiodes (including solar cells), phototransistors, photomultipliers, photoresistors, and light emitting diodes.

The term "consisting essentially of" refers to a composition comprising the components of which it consists essentially as well as other components, provided that the other components do not materially affect the essential characteristics of the composition. Typically, a composition consisting essentially of certain components will comprise greater than or equal to 95 wt% of those components or greater than or equal to 99 wt% of those components.

The terms "disposing on" or "disposed on", as used herein, refers to the making available or placing of one component on another component. The first component may be made available or placed directly on the second component, or there may be a third component which intervenes between the first and second component. For instance, if a first layer is disposed on a second layer, this includes the case where there is an intervening third layer between the first and second layers. Typically, "disposing on" refers to the direct placement of one component on another.

The term "layer", as used herein, refers to any structure which is substantially laminar in form (for instance extending substantially in two perpendicular directions, but limited in its extension in the third perpendicular direction). A layer may have a thickness which varies over the extent of the layer. Typically, a layer has approximately constant thickness. The "thickness" of a layer, as used herein, refers to the average thickness of a layer. The thickness of layers may easily be measured, for instance by using microscopy, such as electron microscopy of a cross section of a film, or by surface profilometry for instance using a stylus profilometer.

The term "band gap", as used herein, refers to the energy difference between the top of the valence band and the bottom of the conduction band in a material. The skilled person of course is readily able to measure the band gap of a semiconductor (including that of a perovskite) by using well-known procedures which do not require undue experimentation. For instance, the band gap of a semiconductor can be estimated by constructing a photovoltaic diode or solar cell from the semiconductor and determining the photovoltaic action spectrum. Alternatively the band gap can be estimated by measuring the light absorption spectra either via transmission spectrophotometry or by photo thermal deflection spectroscopy. The band gap can be determined by making a Tauc plot, as described in Tauc, J., Grigorovici, R. & Vancu, a. Optical Properties and Electronic Structure of Amorphous Germanium. Phys. Status Solidi 15, 627-637 (1966) where the square of the product of absorption coefficient times photon energy is plotted on the Y-axis against photon energy on the x-axis with the straight line intercept of the absorption edge with the x-axis giving the optical band gap of the semiconductor. Alternatively, the optical band gap may be estimated by taking the onset of the incident photon-to-electron conversion efficiency, as described in [Barkhouse DAR, Gunawan O, Gokmen T, Todorov TK, Mitzi DB. Device characteristics of a 10.1% hydrazineprocessed Cu2ZnSn(Se,S)4 solar cell. Progress in Photovoltaics: Research and Applications 2012; published online DOI: 10.1002/pip.1160.]

The term "semiconductor" or "semiconducting material", as used herein, refers to a material with electrical conductivity intermediate in magnitude between that of a conductor and a dielectric. A semiconductor may be an negative (n)-type semiconductor, a positive (p)-type semiconductor or an intrinsic (i) semiconductor. A semiconductor may have a band gap of from 0.5 to 3.5 eV, for instance from 0.5 to 2.5 eV or from 1.0 to 2.0 eV (when measured at 300 K).

The term "n-type region", as used herein, refers to a region of one or more electron-transporting (i.e. n-type) materials. Similarly, the terms "n-type layer" refers to a layer of an electron-transporting (i.e. an n-type) material. An electron-transporting (i.e. an n-type) material could be a single electron-transporting compound or elemental material, or a mixture of two or more electron-transporting compounds or elemental materials. An electron-transporting compound or elemental material may be undoped or doped with one or more dopant elements.

The term "p-type region", as used herein, refers to a region of one or more hole-transporting (i.e. p-type) materials. Similarly, the term "p-type layer" refers to a layer of a hole-transporting (i.e. a p-type) material. A hole-transporting (i.e. a p-type) material could be a single hole-transporting compound or elemental material, or a mixture of two or more hole-transporting compounds or elemental materials. A hole-transporting compound or elemental material may be undoped or doped with one or more dopant elements.

The term "electrode material", as used herein, refers to any material suitable for use in an electrode. An electrode material will have a high electrical conductivity. The term "electrode" as used herein indicates a region or layer consisting of, or consisting essentially of, an electrode material.

The term "nanoparticle", as used herein, means a microscopic particle whose size is typically measured in nanometres (nm). A nanoparticle typically has a particle size of from 0.1 nm to 500 nm, for instance from 0.5 nm to 500 nm. A nanoparticle may for instance be a particle having size of from 0.1 nm to 300 nm, or for example from 0.5 nm to 300 nm. Often, a nanoparticle has a particle size of from 0.1 nm to 100 nm, for instance from 0.5 nm to 100 nm. A nanoparticle may have a high sphericity, i.e. it may be substantially spherical or spherical. A nanoparticle with a high sphericity may for instance have a sphericity of from 0.8 to 1.0. The sphericity may be calculated as ${π}^{\frac{1}{3}} {\left(6{V}_{p}\right)}^{\frac{2}{3}} / {A}_{p}$ where Vp is the volume of the particle and Ap is the area of the particle. Perfectly spherical particles have a sphericity of 1.0. All other particles have a sphericity of lower than 1.0. A nanoparticle may alternatively be non-spherical. It may for instance be in the form of an oblate or prolate spheroid, and it may have a smooth surface. Alternatively, a non-spherical nanoparticle may be plate-shaped, needle-shaped, tubular or take an irregular shape.

### Process

The invention provides a process for producing a multi-junction device comprising a layer of a crystalline A/M/X material, which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and wherein the process comprises forming the layer of the crystalline A/M/X material by disposing a film-forming solution on a substrate, wherein the film-forming solution comprises:
(a) one or more M cations; and
(b) a solvent;

wherein the solvent comprises
   (i) an aprotic solvent; and
   (ii) an organic amine
and wherein the substrate comprises: a photoactive region comprising a photoactive material, and a charge recombination layer which is disposed on the photoactive region;
wherein the process further comprises a step of producing the substrate by disposing the charge recombination layer on the photoactive region by solution deposition, wherein said step comprises disposing a solvent dispersion of nanoparticles of a transparent conducting oxide on the photoactive region.

Typically, the process involves disposing the film-forming solution on the charge recombination layer. Thus, typically, the substrate comprises the following layers in the following order:
- Charge recombination layer;
- Photoactive region.

Thus, typically, the multi-junction device produced according to the present invention comprises the following layers in the following order:
- Layer of a crystalline A/M/X material;
- Charge recombination layer;
- Photoactive region.

The photoactive material in the substrate may be soluble in dimethylformamide (DMF). Often, at least one component of the charge recombination layer in the substrate is soluble in dimethylformamide (DMF). For instance, both the photoactive material in the substrate and at least one component of the charge recombination layer in the substrate may be soluble in dimethylformamide (DMF). Typically, the photoactive material in the substrate is soluble in dimethylformamide (DMF), dimethysulfoxide (DMSO) or a mixture thereof. Often, at least one component of the charge recombination layer in the substrate is soluble in dimethylformamide (DMF), dimethysulfoxide (DMSO) or a mixture thereof. For instance, both the photoactive material in the substrate and at least one component of the charge recombination layer in the substrate may be soluble in dimethylformamide (DMF), dimethysulfoxide (DMSO) or a mixture thereof.

Both the photoactive material in the substrate and the charge recombination layer in the substrate may be soluble in dimethylformamide (DMF). Typically, both the photoactive material in the substrate and the charge recombination layer in the substrate are soluble in dimethylformamide (DMF), dimethysulfoxide (DMSO) or a mixture thereof.

### Aprotic solvent

Typically, the aprotic solvent does not comprise dimethylformamide (DMF). Preferably, the aprotic solvent does not comprise dimethylformamide, dimethylsulfoxide (DMSO) or mixtures thereof.

The aprotic solvent may be a polar aprotic solvent. Such solvents are known to the skilled person. For instance, the aprotic solvent may comprise a compound selected from the group consisting of chlorobenzene, acetone, butanone, methylethylketone, acetonitrile, propionitrile or a mixture thereof.

The aprotic solvent may be an non-polar aprotic solvent. Such solvents are known to the skilled person. For instance, the aprotic solvent may comprise toluene.

Typically, the aprotic solvent comprises a compound selected from the group consisting of chlorobenzene, acetone, butanone, methyl ethyl ketone, acetonitrile, propionitrile, toluene or a mixture thereof. Preferably, the aprotic solvent comprises acetonitrile. For instance, greater then or equal to 80 vol% of the aprotic solvent may be acetonitrile.

### Organic amine

Typically, the organic amine is an unsubstituted or substituted alkylamine or an unsubstituted or substituted arylamine.

An alkylamine is an organic compound comprising an alkyl group and an amine group, which amine group may be a primary, secondary or tertiary amine group. The alkylamine compound may be a primary amine R^{A}NH₂, wherein R^{A} is an alkyl group which may be substituted or unsubstituted, or a secondary amine R^{A}₂NH, wherein each R^{A} is an alkyl group which may be substituted or unsubstituted, or a tertiary amine R^{A}₃N, wherein each R^{A} is an alkyl group which may be substituted or unsubstituted. Typically, the alkylamine is a primary alkylamine.

Typically, the organic amine is an unsubstituted or substituted (C₁₋₁₀ alkyl) amine. For instance, the alkylamine compound may be a primary amine R^{A}NH₂, wherein R^{A} is unsubstituted or substituted C₁₋₁₀ alkyl, or unsubstituted or substituted C₁₋₈ alkyl, for instance unsubstituted or substituted C₁₋₆ alkyl. For instance, R^{A} may be methyl, ethyl, propyl, isopropyl, butyl (i.e. n-butyl), pentyl (n-pentyl) or hexyl (n-hexyl).

Preferably, the organic amine is an unsubstituted (C₁₋₁₀ alkyl) amine or a (C₁₋₁₀ alkyl) amine substituted with a phenyl group. For instance, the organic amine may be an unsubstituted (C₁₋₈ alkyl) amine, for example an unsubstituted (C₁₋₆ alkyl) amine, for example methylamine, ethylamine, propylamine, butylamine or pentylamine, or hexylamine. The organic amine may be a (C₁₋₈ alkyl) amine substituted with a phenyl group, for instance a (C₁₋₆ alkyl) amine substituted with a phenyl group, for example benzyl amine or phenyl ethyl amine.

The organic amine may therefore be methylamine, ethylamine, propylamine, butylamine or pentylamine, hexylamine, benzyl amine or phenyl ethyl amine, or mixtures thereof. For instance, the organic amine may be methylamine, propylamine or butylamine. Preferably, the organic amine is methylamine.

The solvent may comprise two or more organic amine compounds as defined herein. For instance, the solvent may comprise methylamine, butylamine, phenylethylamine, hexylamine, octylamine, ocatadecylamine, alkylamine, naphthylamine and benzylamine, Methoxypolyethylene glycol amine.

An arylamine is an organic compound comprising an aryl group and an amine group. Typically, an aryl amine is derived from ammonia by replacing one or more of the hydrogen atoms with aryl groups.

The arylamine may comprise an amine group which may be a primary, secondary or tertiary amine group. The arylamine compound may be a primary amine R^{B}NH₂, wherein R^{B} is an aryl group which may be substituted or unsubstituted. For instance, R_{B} may be selected from phenyl, naphthyl, indenyl, indanyl, anthrecenyl and pyrenyl groups. Typically R^{B} is a phenyl group, hence the arylamine may be phenylamine (aniline).

The arylamine may be a secondary amine, for instance a secondary amine of the formula R^{B}R^{A}NH, wherein R^{A} is an alkyl group as described herein and R^{B} is an aryl group as described herein. The arylamine may be tertiary amine, for instance a tertiary amine of the formula R^{B}R^{A}₂N, wherein each R^{A} is an alkyl group as described above and R^{B} is an aryl group as described above.

Typically, the solvent in the process of the invention is produced by adding the organic amine to the aprotic solvent, either as a gaseous organic amine, a liquid organic amine or a solution of an organic amine. Thus, the process may further comprise a step of producing the solvent by adding the organic amine to the aprotic solvent. A gaseous organic amine may be added to a solvent by bubbling the organic amine through the solvent.

The amount of organic amine in the solvent may vary depending on requirements. Typically, the amount of organic amine present in the solvent is sufficient to fully solvate the M cations. When A cations and X anions are also present in the film-forming solution, the amount of organic amine present in the solvent may be sufficient to fully solvate the M cations, the A cations and the X anions. Therefore, typically the solvent comprises the amount of organic amine in an amount sufficient to maintain the film-forming solution at its critical solution point. Preferably, only a small excess of organic amine is present, i.e. just enough amine to dissolve the components should usually be present in the solvent. Typically, the percent by volume of amine in the solvent is less than or equal to 50%, more typically less than 25%, for instance less than 10%.

It is desirable to have a film-forming solution in which the minimum amount of organic amine is used to solvate the M cations, and optionally any A cations and X anions that may be present. Such a solution is able to evenly deposit the M cations, and optionally any A cations and X anions on the substrate without dissolving the underlying layers, for instance the charge recombination layer, the photoactive region or any charge transporting layer (if present).

Typically, the film-forming solution is prepared by a process comprising the following steps:
- Preparing a solution in which the M cations, and optionally any A cations and X anions that may be present are fully solvated in the aprotic solvent by an excess of organic amine;
- Preparing a dispersion of a compound comprising the M cation, and optionally a compound or compounds comprising the A cations and X anions, in the aprotic solvent containing no organic amine;
- Adding the solution to the dispersion until the undissolved compounds in the dispersion become fully dissolved, thereby creating the film-forming solution used in the process of the present invention.

As the skilled person would appreciate, the solubility of the M cations, and optionally any A cations and X anions present, will vary depending on the concentrations and nature of the ions. The method above permits the amount of organic amine to be tailored such that the appropriate amount to fully solvate all ions with minimum excess is used.

Typically, the solution in which the M cations, and optionally any A cations and X anions that may be present, are fully solvated by an excess of organic amine is prepared by a process comprising the following steps:
- preparing a dispersion of a compound comprising the M cation, and optionally a compound or compounds comprising the A cations and X anions, containing no organic amine;
- adding the organic amine to the dispersion until the compound comprising the M cation, and optionally a compound or compounds comprising the A cations and X anions dissolve, typically by bubbling gaseous organic amine through the dispersion.

Typically, the film-forming solution is disposed on the substrate by solution phase deposition, for instance gravure coating, slot dye coating, screen printing, ink jet printing, doctor blade coating, spray coating, roll-to-roll (R2R) processing, or spin-coating. Typically, disposing the film-forming composition on the substrate comprises a step of spin-coating the film-forming solution on the substrate.

Typically, the spin coating is performed at a speed of at least 1000 RPM, for instance at least 2000 RPM, at least 3000 RPM or at least 4000 RPM, for example between 1000 and 10000 RPM, between 2000 and 8000 RPM, between 2500 and 7500 RPM, preferably about 5000 RPM. Typically, the spin coating is performed for a time of at least one second, at least 5 seconds or at least 10 seconds, for example from 1 second to 1 minute, from 10 seconds to 30 seconds, preferably about 20 seconds.

Typically, the process further comprises removing the solvent to form the layer comprising the crystalline A/M/X material. Removing the solvent may comprise heating the solvent, or allowing the solvent to evaporate.

The solvent is usually removed by heating the film-forming solution treated substrate. For instance, the film-forming solution treated substrate may be heated to a temperature of from 30°C to 400°C, for instance from 50°C to 200°C. Preferably, the film-forming solution treated is heated to a temperature of from 50°C to 200°C for a time of from 5 to 200 minutes, preferably from 10 to 100 minutes.

### Post treatment

The process of the present invention may comprise a further step of disposing on the substrate a composition comprising one or more A cations and optionally one or more X anions. The film-forming solution used in the process of the present invention may not comprise any A cations and/or X anions. In this case, the A cations and/or X anions may be added to the substrate in a separate step, so that the crystalline A/M/X material is formed on the substrate. Alternatively, the film-forming solution used in the process of the present invention may comprise A cations and/or X anions, and the further step of disposing a composition comprising one or more A cations and optionally one or more X anions on the substrate is performed as a post treatment step on the layer of the crystalline A/M/X material.

Typically the composition comprising one or more A cations and optionally one or more X anions is a solution. Thus, the process of the present invention may further comprise a step of disposing on the substrate a solution comprising one or more A cations and optionally one or more X anions. The process of the present invention may further comprise a step of disposing on the substrate a composition comprising one or more A cations and one or more X anions, for example a solution comprising one or more A cations and one or more X anions.

The solution comprising one or more A cations and one or more X anions may be formed by dissolving one or more compounds of formula AX in a solvent, wherein A and X are as defined herein. The solvent may be different or the same as the solvent in the film-forming solution. Typically, the solvent is different to the solvent in the film-forming solution. Therefore, the solvent may be a solvent that is orthogonal to the solvent in the film-forming solution. Importantly, the solvent should not dissolve the underlying perovskite film. For instance, the solvent may be isopropanol (2-propanol), ethanol (EtOH), methanol (MeOH), and butanol. The solvent may be toluene. The solvent could also be a mixture of solvents, for instance the above mentioned alcohols with aprotic solvents such as toluene, anisole, chlorobenzene.

Typically, the solution comprising one or more A cations and one or more X anions is spin-coated on to the substrate. Typically, the spin coating is performed at a speed of at least 1000 RPM, for instance at least 2000 RPM, at least 3000 RPM or at least 4000 RPM, for example between 1000 and 10000 RPM, between 4000 and 8000 RPM, preferably about 6000 RPM. Typically, the spin coating is performed for a time of at least one second, at least 5 seconds or at least 10 seconds, for example from 1 second to 1 minute, from 10 seconds to 30 seconds, preferably about 20 seconds.

The solvent is usually removed by heating the film-forming solution treated substrate. For instance, the film-forming solution treated substrate may be heated to a temperature of from 30°C to 400°C, for instance from 50°C to 200°C. Preferably, the film-forming solution treated is heated to a temperature of from 50°C to 200°C for a time of from 5 to 200 minutes, preferably from 10 to 100 minutes.

### Compound of formula [A]ₐ[M]_{b}[X]_{c}

The process of the present invention produces a multi-junction device comprising a layer of a crystalline A/M/X material, which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18. a is often a number from 1 to 4, b is often a number from 1 to 3, and c is often a number from 1 to 8.

Each of a, b and c may or may not be an integer. For instance, a, b or c may not be an integer where the compound adopts a structure having vacancies such that the crystal lattice is not completely filled. The method of the invention provides very good control over stoichiometry of the product and so is well-suited for forming structures where a, b or c is not an integer (for instance a structure having vacancies in one or more of the A, M or X sites). Accordingly, in some embodiments, one or more of a, b and c is a non-integer value. For example, one of a, b and c may be a non-integer value. In one embodiment, a is a non-integer value. In another embodiment, b is a non-integer value. In yet another embodiment, c is a non-integer value.

In other embodiments, each of a, b and c are integer values. Thus, in some embodiments, a is an integer from 1 to 6; b is an integer from 1 to 6; and c is an integer from 1 to 18. a is often an integer from 1 to 4, b is often an integer from 1 to 3, and c is often an integer from 1 to 8.

In the compound of formula [A]ₐ[M]_{b}[X]_{c}, generally:
[A] comprises one or more A cations, which A cations may for instance be selected from alkali metal cations or organic monocations;
[M] comprises one or more M cations which are metal or metalloid cations selected from Pd⁴⁺, W⁴⁺, Re⁴⁺, Os⁴⁺, Ir⁴⁺, Pt⁴⁺, Sn⁴⁺, Pb⁴⁺, Ge⁴⁺, Te⁴⁺, Bi³⁺, Sb³⁺, Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ and Eu²⁺, preferably Sn²⁺, Pb²⁺, Cu²⁺, Ge²⁺, and Ni²⁺; particularly preferably Pb²⁺ and Sn²⁺;
[X] comprises one or more X anions selected from halide anions (e.g. Cl⁻, Br⁻, and I⁻), O²⁻, S²⁻, Se²⁻, and Te²⁻;
a is a number from 1 to 4;
b is a number from 1 to 3; and
c is a number from 1 to 8.

Preferably the compound of formula [A]ₐ[M]_{b}[X]_{c} comprises a perovskite. The compound of formula [A]ₐ[M]_{b}[X]_{c} often comprises a metal halide perovskite.

### [M] cations

[M] comprises one or more M cations which are metal or metalloid cations. [M] may comprise two or more different M cations. [M] may comprise one or more monocations, one or more dications, one or more trications or one or more tetracations.

Typically, the one or more M cations are selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺, Eu²⁺, Bi³⁺, Sb³⁺, Pd⁴⁺, W⁴⁺, Re⁴⁺, Os⁴⁺, Ir⁴⁺, Pt⁴⁺, Sn⁴⁺, Pb⁴⁺, Ge⁴⁺ or Te⁴⁺. Preferably, the one or more M cations are selected from Cu²⁺, Pb²⁺, Ge²⁺ or Sn²⁺.

Typically, [M] comprises one or more metal or metalloid dications. For instance, each M cation may be selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ and Eu²⁺, preferably Sn²⁺, Pb²⁺, Cu²⁺, Ge²⁺, and Ni²⁺; preferably Sn²⁺ and Pb²⁺. In some embodiments, [M] comprises two different M cations, typically where said cations are Sn²⁺ and Pb²⁺.

The film-forming solution used in the process of the present invention comprises: (a) one or more M cations as described herein; and (b) a solvent as described herein. The process of the present invention may comprise a step of forming the film-forming solution by dissolving at least one M precursor in the solvent. As is discussed in more detail below, an M precursor is a compound comprising one or more M cations present in [M]. Where [M] (that is, [M] in the compound of formula [A]ₐ[M]_{b}[X]_{c}) comprises only one type of M cation, only one M precursor is necessary in the process of the invention.

The M precursor typically comprises one or more counter-anions. Thus, typically, the film-forming solution comprises one or more counter-anions. Many such counter-anions are known to the skilled person. The one or more M cations and the one or more counter anions may both be from a first precursor compound, which is dissolved in the solvent as described herein to form the film-forming solution.

The counter-anion may be a halide anion, a thiocyanate anion (SCN⁻), a tetrafluoroborate anion (BF₄⁻) or an organic anion. Preferably, the counter-anion as described herein is a halide anion or an organic anion. The film-forming solution may comprise two or more counter-anions, e.g. two or more halide anions.

Typically, the counter-anion is an anion of formula RCOO⁻, ROCOO⁻, RSO₃⁻, ROP(O)(OH)O⁻ or RO⁻, wherein R is H, substituted or unsubstituted C₁₋₁₀ alkyl, substituted or unsubstituted C₂₋₁₀ alkenyl, substituted or unsubstituted C₂₋₁₀ alkynyl, substituted or unsubstituted C₃₋₁₀ cycloalkyl, substituted or unsubstituted C₃₋₁₀ heterocyclyl or substituted or unsubstituted aryl. For instance R may be H, substituted or unsubstituted C₁₋₁₀ alkyl, substituted or unsubstituted C₃₋₁₀ cycloalkyl or substituted or unsubstituted aryl. Typically R is H substituted or unsubstituted C₁₋₆ alkyl or substituted or unsubstituted aryl. For instance, R may be H, unsubstituted C₁₋₆ alkyl or unsubstituted aryl. Thus, R may be selected from H, methyl, ethyl, propyl, butyl, pentyl, hexyl, cyclopentyl, cyclohexyl and phenyl. Often, (one or more) counter-anions are selected from halide anions (e.g. F⁻, Cl⁻, Br⁻ and I⁻) and anions of formula RCOO⁻, wherein R is H or methyl.

Typically, the counter-anion is F⁻, Cl⁻, Br⁻, I⁻, formate or acetate. Preferably, the counter-anion is Cl⁻, Br⁻, I⁻ or F⁻. More preferably, the counter-anion is Cl⁻, Br⁻ or I⁻.

Typically, the M precursor is a compound of formula MY₂, MY₃, or MY₄, wherein M is a metal or metalloid cation as described herein, and Y is said counter-anion.

Thus, the M precursor may be a compound of formula MY₂, wherein M is Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ or Eu²⁺ and Y is F⁻, Cl⁻, Br⁻, I , formate or acetate. Preferably M is Cu²⁺, Pb²⁺, Ge²⁺ or Sn²⁺ and Y is Cl⁻, Br⁻, I⁻, formate or acetate, preferably Cl⁻, Br⁻ or I⁻.

Typically, the M precursor is lead (II) acetate, lead (II) formate, lead (II) fluoride, lead (II) chloride, lead (II) bromide, lead (II) iodide, tin (II) acetate, tin (II) formate, tin (II) fluoride, tin (II) chloride, tin (II) bromide, tin (II) iodide, germanium (II) acetate, germanium (II) formate, germanium (II) fluoride, germanium (II) chloride, germanium (II) bromide or germanium (II) iodide. In some cases, the first precursor compound comprises lead (II) acetate. In some cases, the first precursor compound comprises lead (II) iodide.

The M precursor is typically a compound of formula MY₂. Preferably, the M precursor is a compound of formula SnI₂, SnBr₂, SnCl₂, PbI₂, PbBr₂ or PbCl₂.

The M precursor may be a compound of formula MY₃, wherein M is Bi³⁺ or Sb³⁺ and Y is F⁻, Cl⁻, Br⁻, I⁻, SCN⁻, BF4⁻, formate or acetate. Preferably M is Bi³⁺ and Y is Cl⁻, Br⁻ or I⁻. In that case, the A/M/X material typically comprises a bismuth or antimony halogenometallate.

The M precursor may be a compound of formula MY₄, wherein M is Pd⁴⁺, W⁴⁺, Re⁴⁺, Os⁴⁺, Ir⁴⁺, Pt⁴⁺, Sn⁴⁺, Pb⁴⁺, Ge⁴⁺ or Te⁴⁺ and Y is F⁻, Cl⁻, Br⁻, I , SCN⁻, BF₄⁻, formate or acetate. Preferably M is Sn⁴⁺, Pb⁴⁺ or Ge⁴⁺ and Cl⁻, Br⁻ or I⁻. In that case, the A/M/X material typically comprises a hexahalometallate.

Typically, the total concentration of [M] cations in the film-forming solution is between 0.01 and 10 M, for instance between 0.1 and 5 M, 0.25 and 2.5 M, 0.5 and 1.5 M, preferably between 0.75 and 1.25 M.

### [A] cations and [X] anions

In general, said one or more A cations are monocations. [A] typically comprises one or more A cations which may be organic and/or inorganic monocations. For instance, [A] may comprise at least two A cations which may be organic and/or inorganic monocations. Thus, the compound of formula [A]ₐ[M]_{b}[X]_{c} may be a mixed cation perovskite. [A] may comprise at least one A cation which is an organic cation and at least one A cation which is an inorganic cation. [A] may comprise at least two A cations which are both organic cations. [A] may comprise at least two A cations which are both inorganic cations.

Where an A species is an inorganic monocation, A is typically an alkali metal monocation (that is, a monocation of a metal found in Group 1 of the periodic table), for instance Li⁺, Na⁺, K⁺, Rb⁺, Cs⁺, for example Cs⁺ or Rb⁺. Typically, [A] comprises at least one organic monocation. Where an A species is an organic monocation, A is typically an ammonium cation, for instance methylammonium, or an iminium cation, for instance formamidimium.

Each A cation may be selected from: an alkali metal cation, for instance Li+, Na+, K+, Rb+, Cs+; a cation of the formula [R₁R₂R₃R₄N]⁺, wherein each of R₁, R₂, R₃, R₄ is independently selected from hydrogen, unsubstituted or substituted C₁₋₂₀ alkyl, and unsubstituted or substituted C₆₋₁₂ aryl, and at least one of R₁, R₂, R₃ and R₄ is not hydrogen; a cation of the formula [R₅R₆N=CH-NR₇R₈]⁺, wherein each of R₅, R₆, R₇ and R₈ is independently selected from hydrogen, unsubstituted or substituted C₁-₂₀ alkyl, and unsubstituted or substituted C₆₋₁₂ aryl; and C₁₋₁₀ alkylamammonium, C₂₋₁₀ alkenylammonium, C₁₋₁₀ alkyliminium, C₃₋₁₀ cycloalkylammonium and C₃₋₁₀ cycloalkyliminium, each of which is unsubstituted or substituted with one or more substituents selected from amino, C₁₋₆ alkylamino, imino, C₁₋₆ alkylimino, C₁₋₆ alkyl, C₂₋₆ alkenyl, C₃₋₆ cycloalkyl and C₆₋₁₂ aryl.

Preferably, each A cation is selected from Cs⁺, Rb⁺, methylammonium [(CH₃NH₃)⁺], ethylammonium [(CH₃CH₂NH₃)⁺], propylammonium [(CH₃CH₂CH₂NH₃)⁺]. Butylammonium [(CH₃CH₂CH₂CH₂NH₃)⁺], pentylammoium [(CH₃CH₂CH₂CH₂CH₂NH₃)⁺], hexylammonium [(CH₃CH₂CH₂CH₂CH₂CH₂NH₃)⁺], heptylammonium [(CH₃CH₂CH₂CH₂CH₂CH₂CH₂NH₃)⁺], octylammonium [(CH₃CH₂CH₂CH₂CH₂CH₂CH₂CH₂NH₃)⁺], tetramethylammonium [(N(CH₃)₄)⁺], formamidinium [(H₂N-C(H)=NH₂)⁺], 1-aminoethan-1-iminium [(H₂N-C(CH₃)=NH₂)⁺] and guanidinium [(H₂N-C(NH₂)=NH₂)⁺].

[A] usually comprises one, two or three A monocations. [A] may comprises a single cation selected from methylammonium [(CH₃NH₃)⁺], ethylammonium [(CH₃CH₂NH₃)⁺], propylammonium [(CH₃CH₂CH₂NH₃)+], dimethylammonium [(CH₃)₂NH⁺], tetramethylammonium [(N(CH₃)₄)⁺], formamidinium [(H₂N-C(H)=NH₂)⁺], 1-aminoethan-1-iminium [(H₂N-C(CH₃)=NH₂)⁺], guanidinium [(H₂N-C(NH₂)=NH₂)⁺], Cs⁺ and Rb⁺. For instance [A] may comprise a single cation that is methylammonium [(CH₃NH₃)⁺].

Alternatively, [A] may comprise two cations selected from this group, for instance Cs⁺ and formamidinium [(H₂N-C(H)=NH₂)⁺], or for instance Cs⁺ and Rb⁺, or for instance methylammonium [(CH₃NH₃)⁺] and formamidinium [(H₂N-C(H)=NH₂)⁺].

Typically, in the process of the present invention, [A] comprises a cation of the formula [R₁NH₃]⁺, wherein R₁ is unsubstituted C₁₋₁₀ alkyl and the organic amine comprises an unsubstituted (C₁₋₁₀ alkyl) amine. The identity of the organic amine in the solvent may be matched to the alkylamine which, when protonated, corresponds to the cation A. Therefore, the C₁₋₁₀ alkyl group on the A cation of formula [R₁NH₃]⁺ and the C₁₋₁₀ alkyl group on the unsubstituted (C₁₋₁₀ alkyl) amine may be the same. For example, the A cation may be methylammonium and the organic amine may comprise methylamine, or the A cation may be ethylammonium and the organic amine may comprise ethylamine, or the A cation may be propylammonium and the organic cation may comprise propylamine, or the A cation may be butylammonium and the organic amine may comprise butylamine, or the A cation may be pentylammonium and the organic amine may comprise pentylamine, or the A cation may be hexylammonium and the organic amine may comprise hexylamine, or the A cation may be heptylammonium and the organic amine may comprise heptylamine, or the A cation may be octylammonium and the organic amine may comprise octylamine. In a preferred embodiment, [A] comprises methylammonium and the organic amine comprises methylamine.

[X] comprises one or more X anions. Typically, [X] comprises one or more halide anions, i.e. an anion selected from F⁻, Br⁻, Cl⁻ and I⁻. Typically, each X anion is a halide. [X] typically comprises one, two or three X anions and these are generally selected from Br⁻, Cl⁻ and I⁻. Typically, [X] comprises two or more different halide anions. [X] may for instance consist of two X anions, such as Cl and Br, or Br and I, or Cl and I. Therefore, the compound of formula [A]ₐ[M]_{b}[X]_{c} often comprises a mixed halide perovskite. When [A] comprises one or more organic cations, the compound of formula [A]ₐ[M]_{b}[X]_{c} may be an organic-inorganic metal halide perovskite.

The film-forming solution may further comprise one or more A cations as described herein. Accordingly, it may be preferred that the film-forming solution comprises each of the one or more A cations present in [A]. The process of the present invention may comprise a step of forming the film-forming solution by dissolving at least one A precursor in the solvent. As is discussed in more detail below, an A precursor is a compound comprising one or more A cations present in [A]. Where [A] (that is, [A] in the compound of formula [A]ₐ[M]_{b}[X]_{c}) comprises only one type of A cation, only one A precursor is necessary in the process of the invention.

The film-forming solution may further comprise one or more X anions as described herein. As regards the source of X anions in the process of the invention, it may not be necessary to provide a separate X precursor in the process of the invention. This is because in some embodiments, the A precursor (or where the process involves a plurality of A precursors, at least one of them) and/or the M precursor (or where the process involves a plurality of M precursors, at least one of them) is salt comprising one or more X anions, for instance a halide salt. In a preferred embodiment, the A precursor (or where present the plurality of A precursors) and the M precursor (or where present the plurality of M precursors) together comprise each of the X cations present in [X].

A further X anion, for instance fluoride (F⁻) or chloride (Cl⁻), may be added to the film forming solution as a "dopant", for instance by adding SnF₂ or SnCl₂ respectively to the film forming solution as an additive. Pb:Sn perovskites in particular can benefit from adding further SnF₂ to the solution.

The film-forming solution typically further comprises one or more A cations as described herein and one or more X anions as described herein. In this embodiment, the film forming solution comprises one or more A cations, one or more M cations and one or more X anions. Thus, in one embodiment the film-forming solution may comprise all of the ions required to make the compound of formula [A]ₐ[M]_{b}[X]_{c}.

The A cations and X anions may both be from the same precursor compound or compounds, which are dissolved in the solvent as described herein to form the film-forming solution. Preferably, the A/X precursor compound is a compound of formula [A][X] wherein: [A] comprises the one or more A cations as described herein; and [X] comprises the one or more X anions as described herein. The A/X precursor compound is typically a compound of formula AX, wherein X is a halide anion and the A cation is as defined herein. When more than one A cation or more than one X anion is present in the compound of formula [A]ₐ[M]_{b}[X]_{c}, more than one compound of formula AX may be dissolved in the film-forming solution.

The A/X precursor compound (or compounds) may, for example, be selected from CH₃NH₃Cl, CH₃NH₃Br, CH₃NH₃I, CH₃CH₂NH₃Cl, CH₃CH₂NH₃Br, CH₃CH₂NH₃I, CH₃CH₂CH₂NH₃Cl, CH₃CH₂CH₂NH₃Br, CH₃CH₂CH₂NH₃I, N(CH₃)₄Cl, N(CH₃)₄Br, N(CH₃)₄I, (H₂N-C(H)=NH2)Cl, (H₂N-C(H)=NH2)Br, (H₂N-C(H)=NH2)I, (H₂N-C(CH₃)=NH₂)Cl, (H₂N-C(CH₃)=NH₂)Br, (H₂N-C(CH₃)=NH₂)I, (H₂N-C(NH₂)=NH₂)Cl, (H₂N-C(NH₂)=NH₂)Br, (H₂N-C(NH₂)=NH₂)I, CsCl, CsBr, CsI, RbCl, RbBr and RbI.

In one embodiment, the film-forming solution comprises an excess of A cations to M cations. In this context, the term "excess" means that the molar ratio of one ion to another is greater than that required by the stoichiometry in the target compound of formula [A]ₐ[M]_{b}[X]_{c}. Typically, the ratio of A cations to M cations in the film-forming solution is from 1:1 to 5:1, for instance from 1:1 to 4:1, 1:1 to 3:1, 1:1 to 2:1, 1:1 to 1.5:1, 1:1 to 1.25:1 or 1:1 to 1.1:1.

In one embodiment, the film-forming solution comprises an excess of M cations to A cations. Typically, the ratio of M cations to A cations in the film-forming solution is from 1:1 to 5:1, for instance from 1:1 to 4:1, 1:1 to 3:1, 1:1 to 2:1, 1:1 to 1.5:1, 1:1 to 1.25:1 or 1:1 to 1.2:1. This is preferred when the compound of formula [A]ₐ[M]_{b}[X]_{c} comprises two M cations, preferably wherein [M] comprises Pb²⁺ and Sn²⁺.

Thus, typically, the total concentration of [A] cations in the film-forming solution is between 0.01 and 10 M, for instance between 0.1 and 5 M, 0.25 and 2.5 M, 0.5 and 1.5 M, preferably between 0.6 and 1.4 M.

Typically, the total concentration of X anions depends on the total concentration of A and/or M cations. For instance, when an A/X precursor compound and/or an M precursor compound comprising one or more X anions are used, the total concentration of X anions will depend on the total amount of A/X precursor compound and/or an M precursor compound present, as described above.

### Compound of formula [A]ₐ[M]_{b}[X]_{c} - further detail

Typically, a = 1, b = 1 and c = 3. Thus, the compound of formula [A]ₐ[M]_{b}[X]_{c} may be a compound of formula [A][M][X]₃, wherein [A], [M] and [X] are as described herein. Typically, the crystalline A/M/X material comprises: a perovskite of formula (I):

[A][M][X]₃ (I)

wherein: [A] comprises one or more A cations which are monocations; [M] comprises one or more M cations which are metal or metalloid dications; and [X] comprises one or more anions which are halide anions.

In some embodiments, the perovskite of formula (I) comprises a single A cation, a single M cation and a single X cation. i.e., the perovskite is a perovskite of the formula (IA):

AMX₃ (IA)

wherein A, M and X are as defined above. In a preferred embodiment, A is selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M is Pb²⁺ or Sn²⁺ and X is selected from Br⁻, Cl⁻ and I⁻.

For instance, the crystalline A/M/X material may comprise, or consist essentially of, a perovskite compound of formula (IA) selected from APbI₃, APbBr₃, APbCl₃, ASnI₃, ASnBr₃ and ASnCl₃, wherein A is a cation as described herein.

For instance, the crystalline A/M/X material may comprise, or consist essentially of, a perovskite compound of formula (IA) selected from CH₃NH₃PbI₃, CH₃NH₃PbBr₃, CH₃NH₃PbCl₃, CH₃NH₃SnI₃, CH₃NH₃SnBr₃, CH₃NH₃SnCl₃, CsPbI₃, CsPbBr₃, CsPbCl₃, CsSnI₃, CsSnBr₃, CsSnCl₃, (H₂N-C(H)=NH₂)PbI₃, (H₂N-C(H)=NH₂)PbBr₃, (H₂N-C(H)=NH₂)PbCl₃, (H₂N-C(H)=NH₂)SnI₃, (H₂N-C(H)=NH₂)SnBr₃ and (H₂N-C(H)=NH₂)SnCl₃, in particular CH₃NH₃PbI₃ or CH₃NH₃PbBr₃, preferably CH₃NH₃PbI₃.

In one embodiment, the perovskite is a perovskite of the formula (IB):

[A^{I}ₓA^{II}₁₋ₓ]MX₃ (IB)

wherein A^{I} and A^{II} are as defined above with respect to A, wherein M and X are as defined above and wherein x is greater than 0 and less than 1. In a preferred embodiment, A^{I} and A^{II} are each selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M is Pb²⁺ or Sn²⁺ and X is selected from Br⁻, Cl⁻ and I⁻. A^{I} and A^{II} may for instance be (H₂N-C(H)=NH₂)⁺ and Cs⁺ respectively, or they may be (CH₃NH₃)⁺ and (H₂N-C(H)=NH₂)⁺ respectively. Alternatively, they may be Cs⁺ and Rb⁺ respectively.

For instance, the crystalline A/M/X material may comprise, or consist essentially of, a perovskite compound of formula (IB) selected from (CsₓRb₁₋ₓ)PbBr₃, (CsₓRb₁₋ₓ)PbCl₃, (CsₓRb₁₋ₓ)PbI₃, [(CH₃NH₃)ₓ(H₂N-C(H)=NH₂)₁₋ₓ]PbCl₃, [(CH₃NH₃)ₓ(H₂N-C(H)=NH₂)₁₋ₓ]PbBr₃, [(CH₃NH₃)ₓ(H₂N-C(H)=NH₂)₁₋ₓ]PbI₃, [(CH₃NH₃)ₓCs₁₋ₓ]PbCl₃, [(CH₃NH₃)ₓCs₁₋ₓ]PbBr₃, [(CH₃NH₃)ₓCs₁₋ₓ]PbI₃, [(H₂N-C(H)=NH₂)ₓCs₁₋ₓ]PbCl₃, [(H₂N-C(H)=NH₂)ₓCs₁₋ₓ]PbBr₃, [(H₂N-C(H)=NH₂)ₓCs₁₋ₓ]PbI₃,
[(CH₃NH₃)ₓ(H₂N-C(H)=NH₂)₁₋ₓ]SnCl₃, [(CH₃NH₃)ₓ(H₂N-C(H)=NH₂)₁₋ₓ]SnBr₃, [(CH₃NH₃)ₓ(H₂N-C(H)=NH₂)₁₋ₓ]SnI₃, [(CH₃NH₃)ₓCs₁₋ₓ]SnCl₃, [(CH₃NH₃)ₓCs₁₋ₓ]SnBr₃, [(CH₃NH₃)ₓCs₁₋ₓ]SnI₃, [(H₂N-C(H)=NH₂)ₓCs₁₋ₓ]SnCl₃, [(H₂N-C(H)=NH₂)ₓCs₁₋ₓ]SnBr₃, and[(H₂N-C(H)=NH₂)ₓCs₁₋ₓ]SnI₃,where x is greater than 0 and less than 1, for instance x may be from 0.01 to 0.99 or from 0.05 to 0.95 or 0.1 to 0.9.

In one embodiment, the perovskite is a perovskite compound of the formula (IC):

AM[X^{I}_{y}X^{II}_{1-y}]₃ (IC)

wherein A and M are as defined above, wherein X^{I} and X^{II} are as defined above in relation to X and wherein y is greater than 0 and less than 1. In a preferred embodiment, A is selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M is Pb²⁺ or Sn²⁺; and X^{I} and X^{II} are each selected from Br⁻, Cl⁻ and I⁻.

For instance, the crystalline A/M/X material may comprise, or consist essentially of, a perovskite compound of formula (IC) selected from APb[Br_{y}I_{1-y}]₃, APb[Br_{y}Cl_{1-y}]₃, APb[I_{y}Cl_{1-y}]₃, ASn[Br_{y}I_{1-y}]₃, ASn[Br_{y}Cl_{1-y}]₃, ASn[I_{y}Cl_{1-y}]₃, where y is greater than 0 and less than 1, and wherein A is a cation as described herein. y may be from 0.01 to 0.99. For instance, y may be from 0.05 to 0.95 or 0.1 to 0.9.

For instance, the crystalline A/M/X material may comprise, or consist essentially of, a perovskite compound of formula (IC) selected from CH₃NH₃Pb[Br_{y}I_{1-y}]₃, CH₃NH₃Pb[Br_{y}Cl_{1-y}]₃, CH₃NH₃Pb[I_{y}Cl_{1-y}]₃, CH₃NH₃Sn[Br_{y}I_{1-y}]₃, CH₃NH₃Sn[Br_{y}Cl_{1-y}]₃, CH₃NH₃Sn[I_{y}Cl_{1-y}]₃, CsPb[Br_{y}I_{1-y}]₃, CsPb[Br_{y}Cl_{1-y}]₃, CsPb[I_{y}Cl_{1-y}]₃, CsSn[Br_{y}I_{1-y}]₃, CsSn[Br_{y}Cl_{1-y}]₃, CsSn[I_{y}Cl_{1-y}]₃, (H₂N-C(H)=NH₂)Pb[Br_{y}I_{1-y}]₃, (H₂N-C(H)=NH₂)Pb[Br_{y}Cl_{1-y}]₃, (H₂N-C(H)=NH₂)Pb[I_{y}Cl_{1-y}]₃, (H₂N-C(H)=NH₂)Sn[Br_{y}I_{1-y}]₃, (H₂N-C(H)=NH₂)Sn[Br_{y}Cl_{1-y}]₃, and (H₂N-C(H)=NH₂)Sn[I_{y}Cl_{1-y}]₃, where y is greater than 0 and less than 1, for instance y may be from 0.01 to 0.99 or from 0.05 to 0.95 or 0.1 to 0.9.

In a preferred embodiment, the perovskite is a perovskite of the formula (ID):

[A^{I}ₓA^{II}₁₋ₓ]M[X^{I}_{y}X^{II}_{1-y}]₃ (ID)

wherein A^{I} and A^{II} are as defined above with respect to A, M is as defined above, X^{I} and X^{II} are as defined above in relation to X and wherein x and y are both greater than 0 and less than 1. In a preferred embodiment, A^{I} and A^{II} are each selected from ((CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M is Pb²⁺ or Sn²⁺;and X^{I} and X^{II} are each selected from Br⁻, Cl⁻ and I⁻.

For instance, the crystalline A/M/X material may comprise, or consist essentially of, a perovskite compound of formula (ID) selected from (CsₓRb₁₋ₓ)Pb(Br_{y}Cl_{1-y})₃, (CsₓRb₁₋ₓ)Pb(Br_{y}I_{1-y})₃, and (CsₓRb₁₋ₓ)Pb(Cl_{y}I_{1-y})₃, [(CH₃NH₃)ₓ(H₂N-C(H)=NH₂)₁₋ₓ]Pb[Br_{y}I_{1-y}]₃, [(CH₃NH₃)ₓ(H₂N-C(H)=NH₂)₁₋ₓ]Pb[Br_{y}Cl_{1-y}]₃, [(CH₃NH₃)ₓ(H₂N-C(H)=NH₂)₁₋ₓ]Pb[I_{y}Cl_{1-y}]₃, [(CH₃NH₃)ₓCs₁₋ₓ]Pb[Br_{y}I_{1-y}]₃, [(CH₃NH₃)ₓCs₁₋ₓ]Pb[Br_{y}Cl_{1-y}]₃, [(CH₃NH₃)ₓCs₁₋ₓ]Pb[I_{y}Cl_{1-y}]₃, [(H₂N-C(H)=NH₂)ₓCs₁₋ₓ]Pb[Br_{y}I_{1-y}]₃, [(H₂N-C(H)=NH₂)ₓCs₁₋ₓ]Pb[Br_{y}Cl_{1-y}]₃, [(H₂N-C(H)=NH₂)ₓCs₁₋ₓ]Pb[I_{y}Cl_{1-y}]₃, [(CH₃NH₃)ₓ(H₂N-C(H)=NH₂)₁₋ₓ]Sn[Br_{y}I_{1-y}]₃, [(CH₃NH₃)ₓ(H₂N-C(H)=NH₂)₁₋ₓ]Sn[Br_{y}Cl_{1-y}]₃, [(CH₃NH₃)ₓ(H₂N-C(H)=NH₂)₁₋ₓ]Sn[I_{y}Cl_{1-y}]₃, [(CH₃NH₃)ₓCs₁₋ₓ]Sn[Br_{y}I_{1-y}]₃, [(CH₃NH₃)ₓCs₁₋ₓ]Sn[Br_{y}Cl_{1-y}]₃, [(CH₃NH₃)ₓCs₁₋ₓ]Sn[I_{y}Cl_{1-y}]₃, [(H₂N-C(H)=NH₂)ₓCs₁₋ₓ]Sn[Br_{y}I_{1-y}]₃, [(H₂N-C(H)=NH₂)ₓCs₁₋ₓ]Sn[Br_{y}Cl_{1-y}]₃, and [(H₂N-C(H)=NH₂)ₓCs₁₋ₓ]Sn[I_{y}Cl_{1-y}]₃, where x and y are both greater than 0 and less than 1, for instance x and y may both be from 0.01 to 0.99 or from 0.05 to 0.95 or 0.1 to 0.9.

In one embodiment, the perovskite is a perovskite of the formula (IE):

A[M^{I}_{z}M^{II}_{1-z}]X₃ (IE)

wherein M^{I} and M^{II} are as defined above with respect to M, A and X are as defined above, and wherein z is greater than 0 and less than 1. In a preferred embodiment, A is selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M^{I} is Pb²⁺ and M^{II} is Sn²⁺; and X is selected from Br⁻, Cl⁻ and I⁻.

For instance, the crystalline A/M/X material may comprise, or consist essentially of, a perovskite compound of formula (IE) selected from CH₃NH₃[Pb_{z}Sn_{1-z}]Cl₃, CH₃NH₃[Pb_{z}Sn_{1-z}]Br₃, CH₃NH₃[Pb_{z}Sn_{1-z}]I₃, Cs[Pb_{z}Sn_{1-z}]Cl₃, Cs[Pb_{z}Sn_{1-z}]Br₃, Cs[Pb_{z}Sn_{1-z}]I₃, (H₂N-C(H)=NH₂)[Pb_{z}Sn_{1-z}]Cl₃, (H₂N-C(H)=NH₂)[Pb_{z}Sn_{1-z}]Br₃, and (H₂N-C(H)=NH₂)[Pb_{z}Sn_{1-z}]I₃, where z is greater than 0 and less than 1, for instance z may be from 0.01 to 0.99 or from 0.05 to 0.95 or 0.1 to 0.9.

In one embodiment, the perovskite is a perovskite of the formula (IF):

[A^{I}ₓA^{II}₁₋ₓ][M^{I}_{z}M^{II}_{1-z}]X₃ (IF)

wherein A^{I} and A^{II} are as defined above with respect to A, M^{I} and M^{II} are as defined above with respect to M, and X is as defined above and wherein x and z are both greater than 0 and less than 1. In a preferred embodiment, A^{I} and A^{II} are each selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M^{I} is Pb²⁺ and M^{II} is Sn²⁺; and X is selected from Br⁻, Cl⁻ and I⁻. A^{I} and A^{II} may for instance be (H₂N-C(H)=NH₂)⁺ and Cs⁺ respectively, or they may be (CH₃NH₃)⁺ and (H₂N-C(H)=NH₂)⁺ respectively. Alternatively, they may be Cs⁺ and Rb⁺ respectively.

For instance, the crystalline A/M/X material may comprise, or consist essentially of, a perovskite compound of formula (IF) selected from [(CH₃NH₃)ₓ(H₂N-C(H)=NH₂)₁₋ₓ][Pb_{z}Sn_{1-z}]Cl₃, [(CH₃NH₃)ₓ(H₂N-C(H)=NH₂)₁₋ₓ][Pb_{z}Sn_{1-z}]Br₃, [(CH₃NH₃)ₓ(H₂N-C(H)=NH₂)₁₋ₓ][Pb_{z}Sn_{1-z}]I₃, [(CH₃NH₃)ₓCs₁₋ₓ][Pb_{z}Sn_{1-z}]Cl₃, [(CH₃NH₃)ₓCs₁₋ₓ][Pb_{z}Sn_{1-z}]Br₃, [(CH₃NH₃)ₓCs₁₋ₓ][Pb_{z}Sn_{1-z}]I₃, [(H₂N-C(H)=NH₂)ₓCs₁₋ₓ][Pb_{z}Sn_{1-z}]Cl₃, [(H₂N-C(H)=NH₂)ₓCs₁₋ₓ][Pb_{z}Sn_{1-z}]Br₃, [(H₂N-C(H)=NH₂)ₓCs₁₋ₓ][Pb_{z}Sn_{1-z}]I₃, where x and z are bothgreater than 0 and less than 1, for instance x and z may each be from 0.01 to 0.99 or from 0.05 to 0.95 or 0.1 to 0.9.

In one embodiment, the perovskite is a perovskite compound of the formula (IG):

A[M^{I}_{z}M^{II}_{1-z}][X^{I}_{y}X^{II}_{1-y}]₃ (IG)

wherein A is as defined above, M^{I} and M^{II} are as defined above with respect to M, and wherein X^{I} and X^{II} are as defined above in relation to X and wherein y and z are both greater than 0 and less than 1. In a preferred embodiment, A is selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M^{I} is Pb²⁺ and M^{II} is Sn²⁺; and X^{I} and X^{II} are each selected from Br⁻, Cl⁻ and I⁻.

For instance, the crystalline A/M/X material may comprise, or consist essentially of, a perovskite compound of formula (IG) selected from A[Pb_{z}Sn_{1-z}][Br_{y}I_{1-y}]₃, A[Pb_{z}Sn_{1-z}][Br_{y}Cl_{1-y}]₃, A[Pb_{z}Sn_{1-z}][I_{y}Cl_{1-y}]₃, where y and z are both greater than 0 and less than 1, and wherein A is a cation as described herein. y and z may each be from 0.01 to 0.99. For instance, y and z may each be from 0.05 to 0.95 or 0.1 to 0.9.

For instance, the crystalline A/M/X material may comprise, or consist essentially of, a perovskite compound of formula (IG) selected from CH₃NH₃[Pb_{z}Sn_{1-z}][Br_{y}I_{1-y}]₃, CH₃NH₃[Pb_{z}Sn_{1-z}][Br_{y}Cl_{1-y}]₃, CH₃NH₃[Pb_{z}Sn_{1-z}][I_{y}Cl_{1-y}]₃, Cs[Pb_{z}Sn_{1-z}][Br_{y}I_{1-y}]₃, Cs[Pb_{z}Sn₁₋₂][Br_{y}Cl_{1-y}]₃, Cs[Pb_{z}Sn_{1-z}][I_{y}Cl_{1-y}]₃, (H₂N-C(H)=NH₂)[Pb_{z}Sn_{1-z}][Br_{y}I_{1-y}]₃, (H₂N-C(H)=NH₂)[Pb_{z}Sn_{1-z}][Br_{y}Cl_{1-y}]₃, and (H₂N-C(H)=NH₂)[Pb_{z}Sn_{1-z}][I_{y}Cl_{1-y}]₃, where y and z are both greater than 0 and less than 1, for instance y and z may each be from 0.01 to 0.99 or from 0.05 to 0.95 or 0.1 to 0.9.

In a preferred embodiment, the perovskite is a perovskite of the formula (IH):

[A^{I}ₓA^{II}₁₋ₓ] [M^{I}_{z}M^{II}_{1-z}] [X^{I}_{y}X^{II}_{1-y}]₃ (IH)

wherein A^{I} and A^{II} are as defined above with respect to A, M^{I} and M^{II} are as defined above with respect to M, X^{I} and X^{II} are as defined above in relation to X and wherein x, y and z are each greater than 0 and less than 1. In a preferred embodiment, A^{I} and A^{II} are each selected from ((CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M^{I} is Pb²⁺ and M^{II} is Sn²⁺; and X^{I} and X^{II} are each selected from Br⁻, Cl⁻ and I⁻.

For instance, the crystalline A/M/X material may comprise, or consist essentially of, a perovskite compound of formula (IH) selected from [(CH₃NH₃)ₓ(H₂N-C(H)=NH₂)₁₋ₓ][Pb_{z}Sn_{1-z}][Br_{y}I_{1-y}]₃, [(CH₃NH₃)ₓ(H₂N-C(H)=NH₂)₁₋ₓ][Pb_{z}Sn_{1-z}][Br_{y}Cl_{1-y}]₃, (CH₃NH₃)ₓ(H₂N-C(H)=NH₂)₁₋ₓ][Pb_{z}Sn_{1-z}][I_{y}Cl_{1-y}]₃, [(CH₃NH₃)ₓCs₁₋ₓ][Pb_{z}Sn_{1-z}][Br_{y}I_{1-y}]₃, [(CH₃NH₃)ₓCs₁₋ₓ][Pb_{z}Sn_{1-z}][Br_{y}Cl_{1-y}]₃, [(CH₃NH₃)ₓCs₁₋ₓ][Pb_{z}Sn_{1-z}][I_{y}Cl_{1-y}]₃, [(H₂N-C(H)=NH₂)ₓCs₁₋ₓ][Pb_{z}Sn_{1-z}][Br_{y}I_{1-y}]₃, [(H₂N-C(H)=NH₂)ₓCs₁₋ₓ][Pb_{z}Sn_{1-z}][Br_{y}Cl_{1-y}]₃, and [(H₂N-C(H)=NH₂)ₓCs₁₋ₓ][Pb_{z}Sn_{1-z}][I_{y}Cl_{1-y}]₃, where x, y and z are each greater than 0 and less than 1, for instance x, y and z may each be from 0.01 to 0.99 or from 0.05 to 0.95 or 0.1 to 0.9.

In one embodiment, a = 2, b = 1 and c = 4. In that embodiment, the crystalline A/M/X material comprises a compound (a "2D layered perovskite") of formula (II):

[A]₂[M][X]₄ (II)

wherein: [A] comprises one or more A cations which are monocations; [M] comprises one or more M cations which are metal or metalloid dications; and [X] comprises one or more X anions which are halide anions. In this embodiment, the A and M cations, and the X anions, are as defined above.

In another embodiment, a = 2, b = 1 and c = 6. In that embodiment, the crystalline A/M/X material may in that case comprise a hexahalometallate of formula (III):

[A]₂[M][X]₆ (III)

wherein: [A] comprises one or more A cations which are monocations; [M] comprises one or more M cations which are metal or metalloid tetracations; and [X] comprises one or more X anions which are halide anions.

The hexahalometallate of formula (III) may in a preferred embodiment be a mixed monocation hexahalometallate. In a mixed monocation hexahalometallate, [A] comprises at least two A cations which are monocations; [M] comprises at least one M cation which is a metal or metalloid tetracation (and typically [M] comprises a single M cation which is a metal or metalloid tetracation); and [X] comprises at least one X anion which is a halide anion (and typically [X] comprises a single halide anion or two types of halide anion). In a mixed metal hexahalometallate, [A] comprises at least one monocation (and typically [A] is a single monocation or two types of monocation); [M] comprises at least two metal or metalloid tetracations (for instance Ge⁴⁺ and Sn⁴⁺); and [X] comprises at least one halide anion (and typically [X] is a single halide anion or two types of halide anion). In a mixed halide hexahalometallate, [A] comprises at least one monocation (and typically [A] is a single monocation or two types of monocation); [M] comprises at least one metal or metalloid tetracation (and typically [M] is a single metal tetra cation); and [X] comprises at least two halide anions, for instance Br⁻ and Cl⁻ or Br⁻ and I⁻.

[A] may comprise at least one A monocation selected from any suitable monocations, such as those described above for a perovskite. In the case of a hexahalometallate, each A cation is typically selected from Li⁺, Na⁺, K⁺, Rb⁺, Cs⁺, NH₄⁺ and monovalent organic cations. Monovalent organic cations are singly positively charged organic cations, which may, for instance, have a molecular weight of no greater than 500 g/mol. For instance, [A] may be a single A cation which is selected from Li⁺, Na⁻, K⁺, Rb⁺, Cs⁺, NH₄⁺ and monovalent organic cations. [A] preferably comprises at least one A cation which is a monocation selected from Rb⁺, Cs⁺, NH₄⁺ and monovalent organic cations. For instance, [A] may be a single inorganic A monocation selected from Li⁺, Na⁺, K⁺, Rb⁺, Cs⁺ and NH₄⁺. In another embodiment, [A] may be at least one monovalent organic A cation. For instance, [A] may be a single monovalent organic A cation. In one embodiment, [A] is (CH₃NH₃)⁺. In another embodiment, [A] is (H₂N-C(H)=NH₂)⁺.

Preferably, [A] comprises two or more types of A cation. [A] may be a single A monocation, or indeed two A monocations, each of which is independently selected from K⁺, Rb⁺, Cs⁺, NH₄⁺, (CH₃NH₃)⁺, (CH₃CH₂NH₃)⁺, (CH₃CH₂CH₂NH₃)⁺, (N(CH₃)₄)⁺, (N(CH₂CH₃)₄)⁺, (N(CH₂CH₂CH₃)₄)⁺, (H₂N-C(H)=NH₂)⁺ and (H₂N-C(CH₃)=NH₂)⁺.

[M] may comprise one or more M cations which are selected from suitable metal or metalloid tetracations. Metals include elements of groups 3 to 12 of the Periodic Table of the Elements and Ga, In, Tl, Sn, Pb, Bi and Po. Metalloids include Si, Ge, As, Sb, and Te. For instance, [M] may comprise at least one M cation which is a metal or metalloid tetracation selected from Ti⁴⁺, V⁴⁺, Mn⁴⁺, Fe⁴⁺, Co⁴⁺, Zr⁴⁺, Nb⁴⁺, Mo⁴⁺, Ru⁴⁺, Rh⁴⁺, Pd⁴⁺, Hf⁴⁺, Ta⁴⁺, W⁴⁺, Re⁴⁺, Os⁴⁺, Ir⁴⁺, Pt⁴⁺, Sn⁴⁺, Pb⁴⁺, Po⁴⁺, Si⁴⁺, Ge⁴⁺, and Te⁴⁺. Typically, [M] comprises at least one metal or metalloid tetracation selected from Pd⁴⁺, W⁴⁺, Re⁴⁺, Os⁴⁺, Ir⁴⁺, Pt⁴⁺, Sn⁴⁺, Pb⁴⁺, Ge⁴⁺, and Te⁴⁺. For instance, [M] may be a single metal or metalloid tetracation selected from Pd⁴⁺, W⁴⁺, Re⁴⁺, Os⁴⁺, Ir⁴⁺, Pt⁴⁺, Sn⁴⁺, Pb⁴⁺, Ge⁴⁺, and Te⁴⁺.

Typically, [M] comprises at least one M cation which is a metal or metalloid tetracation selected from Sn⁴⁺, Te⁴⁺, Ge⁴⁺ and Re⁴⁺. In one embodiment [M] comprises at least one M cation which is a metal or metalloid tetracation selected from Pb⁴⁺, Sn⁴⁺, Te⁴⁺, Ge⁴⁺ and Re⁴⁺. For instance, [M] may comprise an M cation which is at least one metal or metalloid tetracation selected from Pb⁴⁺, Sn⁴⁺, Te⁴⁺ and Ge⁴⁺. Preferably, [M] comprises at least one metal or metalloid tetracation selected from Sn⁴⁺, Te⁴⁺, and Ge⁴⁺. As discussed above, the hexahalometallate compound may be a mixed-metal or a single-metal hexahalometallate. Preferably, the hexahalometallate compound is a single-metal hexahalometallate compound. More preferably, [M] is a single metal or metalloid tetracation selected from Sn⁴⁺, Te⁴⁺, and Ge⁴⁺. For instance, [M] may be a single metal or metalloid tetracation which is Te⁴⁺. For instance, [M] may be a single metal or metalloid tetracation which is Ge⁴⁺. Most preferably, [M] is a single metal or metalloid tetracation which is Sn⁴⁺.

[X] may comprise at least one X anion which is a halide anion. [X] therefore comprises at least one halide anion selected from F⁻, Cl⁻, Br⁻ and I⁻. Typically, [X] comprises at least one halide anion selected from Cl⁻, Br⁻ and I⁻. The hexahalometallate compound may be a mixed-halide hexahalometallate or a single-halide hexahalometallate. If the hexahalometallate is mixed, [X] comprises two, three or four halide anions selected from F⁻, Cl⁻, Br⁻ and I⁻. Typically, in a mixed-halide compound, [X] comprises two halide anions selected from F⁻, Cl⁻, Br⁻ and I⁻.

In some embodiments, [A] is a single monocation and [M] is a single metal or metalloid tetracation. Thus, the crystalline A/M/X material may, for instance, comprise a hexahalometallate compound of formula (IIIA)

A₂M[X]₆ (IIIA)

wherein: A is a monocation; M is a metal or metalloid tetracation; and [X] is at least one halide anion. [X] may be one, two or three halide anions selected from F⁻, Cl⁻, Br⁻ and I⁻, and preferably selected from Cl⁻, Br⁻ and I⁻. In formula (IIIA), [X] is preferably one or two halide anions selected from Cl⁻, Br⁻ and I⁻.

The crystalline A/M/X material may, for instance, comprise, or consist essentially of, a hexahalometallate compound of formula (IIIB)

A₂MX_{6-y}X'_{y} (IIIB)

wherein: A is a monocation (i.e. the second cation); M is a metal or metalloid tetracation (i.e. the first cation); X and X' are each independently a (different) halide anion (i.e. two second anions); and y is from 0 to 6. When y is 0 or 6, the hexahalometallate compound is a single-halide compound. When y is from 0.01 to 5.99 the compound is a mixed-halide hexahalometallate compound. When the compound is a mixed-halide compound, y may be from 0.05 to 5.95. For instance, y may be from 1.00 to 5.00.

The hexahalometallate compound may, for instance, be A₂SnF_{6-y}Cl_{y}, A₂SnF_{6-y}Br_{y}, A₂SnF_{6-y}I_{y}, A₂SnCl_{6-y}Br_{y}, A₂SnCl_{6-y}I_{y}, A₂SnBr_{6-y}I_{y}, A₂TeF_{6-y}Cl_{y}, A₂TeF_{6-y}Br_{y}, A₂TeF_{6-y}I_{y}, A₂TeCl_{6-y}Br_{y}, A₂TeCl_{6-y}I_{y}, A₂TeBr_{6-y}I_{y}, A₂GeF_{6-y}Cl_{y}, A₂GeF_{6-y}Br_{y}, A₂GeF_{6-y}I_{y}, A₂GeCl_{6-y}Br_{y}, A₂GeCl_{6-y}I_{y}, A₂GeBr_{6-y}I_{y}, A₂ReF_{6-y}Cl_{y}, A₂ReF_{6-y}Br_{y}, A₂ReF_{6-y}I_{y}, A₂ReCl_{6-y}Br_{y}, A₂ReCl_{6-y}I_{y} or A₂ReBr_{6-y}I_{y}, wherein: A is K⁺, Rb⁺, Cs⁺, (R¹NH₃)⁺, (NR²₄)⁺, or (H₂N-C(R¹)=NH₂)⁺, wherein R¹ is H, a substituted or unsubstituted C₁₋₂₀ alkyl group or a substituted or unsubstituted aryl group, and R² is a substituted or unsubstituted C₁₋₁₀ alkyl group; and y is from 0 to 6. Optionally, y is from 0.01 to 5.99. If the hexahalometallate compound is a mixed-halide compound, y is typically from 1.00 to 5.00. A may be as defined above. For instance, A may be Cs⁺, NH₄⁺, (CH₃NH₃)⁺, (CH₃CH₂NH₃)⁺, (N(CH₃)₄)⁺, (N(CH₂CH₃)₄)⁺, (H₂N-C(H)=NH₂)⁺ or (H₂N-C(CH₃)=NH₂)⁺, for instance Cs⁺, NH₄⁺, or (CH₃NH₃)⁺.

The hexahalometallate compound may typically be A₂SnF_{6-y}Cl_{y}, A₂SnF_{6-y}Br_{y}, A₂SnF_{6-y}I_{y}, A₂SnCl_{6-y}Br_{y}, A₂SnCl_{6-y}I_{y}, or A₂SnBr_{6-y}I_{y}, wherein: A is K⁺, Rb⁺, Cs⁺, (R¹NH₃)⁺, (NR²₄)⁺, or (H₂N-C(R¹)=NH₂)⁺, or A is as defined herein, wherein R¹ is H, a substituted or unsubstituted C₁₋₂₀ alkyl group or a substituted or unsubstituted aryl group, or R² is a substituted or unsubstituted C₁₋₁₀ alkyl group; and y is from 0 to 6.

In another embodiment, the hexahalometallate compound is A₂GeF_{6-y}Cl_{y}, A₂GeF_{6-y}Br_{y}, A₂GeF_{6-y}I_{y}, A₂GeCl_{6-y}Br_{y}, A₂GeCl_{6-y}I_{y}, or A₂GeBr_{6-y}I_{y}, wherein: A is K⁺, Rb⁺, Cs⁺, (R¹NH₃)⁺, (NR²₄)⁺, or (H₂N-C(R¹)=NH₂)⁺, or A is as defined herein, wherein R¹ is H, a substituted or unsubstituted C₁₋₂₀ alkyl group or a substituted or unsubstituted aryl group, and R² is a substituted or unsubstituted C₁₋₁₀ alkyl group; and y is from 0 to 6.

The hexahalometallate compound may, for instance, be A₂TeF_{6-y}Cl_{y}, A₂TeF_{6-y}Br_{y}, A₂TeF_{6-y}I_{y}, A₂TeCl_{6-y}Br_{y}, A₂TeCl_{6-y}I_{y}, or A₂TeBr_{6-y}I_{y}, wherein: A is K⁺, Rb⁺, Cs⁺, (R¹NH₃)⁺, (NR²₄)⁺, or (H₂N-C(R¹)=NH₂)⁺, or A is as defined herein, wherein R¹ is H, a substituted or unsubstituted C₁₋₂₀ alkyl group or a substituted or unsubstituted aryl group, and R² is a substituted or unsubstituted C₁₋₁₀ alkyl group; and y is from 0 to 6 or y is as defined herein.

Often, y will be from 1.50 to 2.50. For instance, y may be from 1.80 to 2.20. This may occur if the compound is produced using two equivalents of AX' and one equivalent of MX₄, as discussed below.

In some embodiments, all of the ions are single anions or cations. Thus, the crystalline A/M/X material may comprise, or consist essentially of, a hexahalometallate compound of formula (IIIC)

A₂MX₆ (IIIC)

wherein: A is a monocation; M is a metal or metalloid tetracation; and X is a halide anion. A, M and X may be as defined herein.

The hexahalometallate compound may be A₂SnF₆, A₂SnCl₆, A₂SnBr₆, A₂SnI₆, A₂TeF₆, A₂TeCl₆, A₂TeBr₆, A₂TeI₆, A₂GeF₆, A₂GeCl₆, A₂GeBr₆, A₂GeI₆, A₂ReF₆, A₂ReCl₆, A₂ReBr₆ or A₂ReI₆, wherein: A is K⁺, Rb⁺, Cs⁺, (R¹NH₃)⁺, (NR²₄)⁺, or (H₂N-C(R¹)=NH₂)⁺, wherein R¹ is H, a substituted or unsubstituted C₁₋₂₀ alkyl group or a substituted or unsubstituted aryl group, and R² is a substituted or unsubstituted C₁₋₁₀ alkyl group. A may be as defined herein. Preferably, the hexahalometallate compound is Cs₂SnI₆, Cs₂SnBr₆, Cs₂SnBr_{6-y}I_{y}, Cs₂SnCl_{6-y}I_{y}, Cs₂SnCl_{6-y}Br_{y}, (CH₃NH₃)₂SnI₆, (CH₃NH₃)₂SnBr₆, (CH₃NH₃)₂SnBr_{6-y}I_{y}, (CH₃NH₃)₂SnCl_{6-y}I_{y}, (CH₃NH₃)₂SnCl_{6-y}Br_{y}, (H₂N-C(H)=NH₂)₂SnI₆, (H₂N-C(H)=NH₂)₂SnBr₆, (H₂N-C(H)=NH₂)₂SnBr_{6-y}I_{y}, (H₂N-C(H)=NH₂)₂SnCl_{6-y}I_{y} or (H₂N-C(H)=NH₂)₂SnCl_{6-y}Br_{y} wherein y is from 0.01 to 5.99. For example, the hexahalometallate compound may be (CH₃NH₃)₂SnI₆, (CH₃NH₃)₂SnBr₆, (CH₃NH₃)₂SnCl₆, (H₂N-C(H)=NH₂)₂SnI₆, (H₂N-C(H)=NH₂)₂SnBr₆ or (H₂N-C(H)=NH₂)₂SnCl₆. The hexahalometallate compound may be Cs₂SnI₆, Cs₂SnBr₆, Cs₂SnCl_{6-y}Br_{y}, (CH₃NH₃)₂SnI₆, (CH₃NH₃)₂SnBr₆, or (H₂N-C(H)=NH₂)₂SnI₆.

The crystalline A/M/X material may comprise a bismuth or antimony halogenometallate. For instance, the crystalline A/M/X material may comprise a halogenometallate compound comprising: (i) one or more monocations ([A]) or one or more dications ([B]); (ii) one or more metal or metalloid trications ([M]); and (iii) one or more halide anions ([X]). The compound may be a compound of formula BBiX₅, B₂BiX₇ or B₃BiX₉ where B is (H₃NCH₂NH₃)²⁺, (H₃N(CH₂)₂NH₃)²⁺, (H₃N(CH₂)₃NH₃)²⁺, (H₃N(CH₂)₄NH₃)²⁺, (H₃N(CH₂)₅NH₃)²⁺, (H₃N(CH₂)₆NH₃)²⁺, (H₃N(CH₂)₇NH₃)²⁺, (H₃N(CH₂)₈NH₃)²⁺ or (H₃N-C₆H₄-NH₃)²⁺ and X is I⁻, Br⁻ or Cl⁻, preferably I⁻.

In yet further embodiments, the crystalline A/M/X materials may be double perovskites. Such compounds are defined in WO 2017/037448. Typically, the compound is a double perovskite compound of formula (IV):

[A]₂[B⁺][B³⁺][X]₆ (IV);

wherein: [A] comprises one or more A cations which are monocations, as defined herein; [B⁺] and [B³⁺] are equivalent to [M] where M comprises one or more M cations which are monocations and one or more M cations which are trications; and [X] comprises one or more X anions which are halide anions.

The one or more M cations which are monocations comprised in [B⁺] are typically selected from metal and metalloid monocations. Preferably, the one or more M cations which are monocations are selected from Li⁺, Na⁺, K⁺, Rb⁺, Cs⁺, Cu⁺, Ag⁺, Au⁺ and Hg⁺. More preferably, the one or more M cations which are monocations are selected from Cu⁺, Ag⁺ and Au⁺. Most preferably, the one or more M cations which are monocations are selected from Ag⁺ and Au⁺. For instance, [B⁺] may be one monocation which is Ag⁺ or [B⁺] may be one monocation which is Au⁺.

The one or more M cations which are trications comprised in [B³⁺] are typically selected from metal and metalloid trications. Preferably, the one or more M cations which are trications are selected from Bi³⁺, Sb³⁺, Cr³⁺, Fe³⁺, Co³⁺, Ga³⁺, As³⁺, Ru³⁺, Rh³⁺, In³⁺, Ir³⁺ and Au³⁺. More preferably, the one or more M cations which are trications are selected from Bi³⁺ and Sb³⁺. For instance, [B³⁺] may be one trication which is Bi³⁺ or [B³⁺] may be one trication which is Sb³⁺. Bismuth has relatively low toxicity compared with heavy metals such as lead. In some embodiments, the one or more M cations which are monocations (in [B⁺]) are selected from Cu⁺, Ag⁺ and Au⁺ and the one or more M cations which are trications (in [B³⁺]) are selected from Bi³⁺ and Sb³⁺.

An exemplary double perovskite is Cs₂BiAgBr₆.

Typically, where the compound is a double perovskite it is a compound of formula (IVa):

A₂B⁺B³⁺[X]₆ (IVa);

wherein: the A cation is as defined herein; B⁺ is an M cation which is a monocation as defined herein; B³⁺ is an M cation which is a trication as defined herein; and [X] comprises one or more X anions which are halide anions, for instance two or more halide anions, preferably a single halide anion.

In yet another embodiment, the compound may be a layered double perovskite compound of formula (V):

[A]₄[B⁺][B³⁺][X]₈ (V);

wherein: [A], [B⁺], [B³⁺] and [X] are as defined above. In some embodiments, the layered double perovskite compound is a double perovskite compound of formula (Va):

   A₄B⁺B³⁺[X]₈ (Va);
wherein: the A cation is as defined herein; B⁺ is an M cation which is a monocation as defined herein; B³⁺ is an M cation which is a trication as defined herein; and [X] comprises one or more X anions which are halide anions, for instance two or more halide anions, preferably a single halide anion or two kinds of halide anion.

In yet another embodiment, the compound may be a compound of formula (VI):

[A]₄[M][X]₆ (VI);

wherein: [A], [M] and [X] are as defined above (in relation to, for instance, compounds of formula (I) or (II)). However, preferably the compound is not a compound of formula (VI). Where the compound is a compound of formula (VI), the compound may preferably be a compound of formula (VIA)

   [A^{I}A^{II}]₄[M][X]₆ (VIA);
that is, a compound wherein [A] comprises two types of A monoacation. In other preferred embodiments, the compound of formula (VI) may be a compound of formula (VIB):

   [A]₄[M][X^{I}X^{II}]₆ (VIB);
that is, a compound of formula (VI) wherein [X] comprises two types of X anion. In yet other preferred embodiments, the compound of formula (VI) may be a compound of formula (VIC):

   [A^{I}A^{II}]₄[M][X^{I}X^{II}]₆ (VIC);
that is, a compound of formula (VI) wherein [A] comprises two types of A monoacation and [X] comprises two types of X anion. In formulae (VIa), (VIb) and (VIc), each of : [A], [M] and [X] are as defined above (in relation to, for instance, compounds of formula (I) or (II)).

In another embodiment, a = 1, b = 1 and c = 4. In that embodiment, the crystalline A/M/X material may in that case comprise a compound of formula (VII):

[A][M][X]₄ (VII)

wherein: [A] comprises one or more A cations which are monocations; [M] comprises one or more M cations which are metal or metalloid trications; and [X] comprises one or more X anions which are halide anions. The A monocations and M trications are as defined herein. An exemplary compound of formula (VII) is AgBiI₄.

It should be understood that the invention also encompasses processes for producing variants of the above-described structures (I), (II), (III), (IV), (V), (VI) and (VII) where one or more of the relevant a, b and c values are non-integer values.

Preferably, the compound of formula [A]ₐ[M]_{b}[X]_{c} is a compound of formula [A][M][X]₃, a compound of formula [A]₄[M][X]₆ or a compound of formula [A]₂[M][X]₆. For example, in preferred embodiments the compound of formula [A]ₐ[M]_{b}[X]_{c} is a compound of formula (I), for instance a compound of formula (IA), (IB), (IC), (ID), (IE), (IF), (IG), (IH), (IIIA), or a compound of formula (IIIB),(IIIC), (VIA), (VIB), or (VIC). Generally, the compound of formula [A]ₐ[M]_{b}[X]_{c} is a compound of formula (I), for instance a compound of formula (IA), (IB), (IC), (ID), (IE), (IF), (IG) or (IH).

In some embodiments, the compound of formula [A]ₐ[M]_{b}[X]_{c} is a compound wherein [A] comprises two or more different A cations. For examples, [A] may contain two types of cation. In some embodiments, the compound of formula [A]ₐ[M]_{b}[X]_{c} is a compound wherein [X] comprises two or more different X anions. For example, [X] may contain two types of anion, e.g. halide anions. In some embodiments, the compound of formula [A]ₐ[M]_{b}[X]_{c} is a compound wherein [M] comprises two or more different M cations. For example, [X] may contain two types of anion, e.g. Sn²⁺ and Pb²⁺.

In one aspect of each of these embodiments, the compound of formula [A]ₐ[M]_{b}[X]_{c} is a compound wherein [A] comprises two or more different A cations *and* wherein [X] comprises two or more different X anions. For example, [A] may contain two types of A cation and [X] may contain two types of X anion (e.g. two types of halide anion).

In one aspect of each of these embodiments, the compound of formula [A]ₐ[M]_{b}[X]_{c} is a compound wherein [A] comprises two or more different A cations *and* wherein [M] comprises two or more different M cations. For example, [A] may contain two types of A cation and [M] may contain two types of M cation (e.g. Sn²⁺ and Pb²⁺).

In one aspect of each of these embodiments, the compound of formula [A]ₐ[M]_{b}[X]_{c} is a compound wherein [X] comprises two or more different X anions *and* wherein [M] comprises two or more different M cations. For example, [X] may contain two types of X anion (e.g. two types of halide anion) and [M] may contain two types of M cation (e.g. Sn²⁺ and Pb²⁺).

In one aspect of each of these embodiments, the compound of formula [A]ₐ[M]_{b}[X]_{c} is a compound wherein [A] comprises two or more different A cations *and* wherein [X] comprises two or more different X anions *and* wherein [M] comprises two or more different M cations. For example, [A] may contain two types of A cation, [X] may contain two types of X anion (e.g. two types of halide anion) and [M] may contain two types of M cation (e.g. Sn²⁺ and Pb²⁺).

### Charge-transporting layers

The substrate may comprise one or more further layers. For instance, the substrate may further comprise a layer of a charge transporting material. Preferably the layer of a charge transporting material is disposed on the charge recombination layer. Typically, the layer of a charge transporting material is disposed directly on the charge recombination layer. Alternatively, there may be an intervening layer between the layer of a charge transporting material and the charge recombination layer. Hence, the substrate may comprise the following layers in the following order:
- Layer of a charge transporting material (typically an n-type material as described herein, but this may alternatively be a p-type material);
- Charge recombination layer;
- Photoactive region.

Typically, the layer of a crystalline A/M/X material is disposed directly on the layer of a charge transporting material. Alternatively, there may be is an intervening layer between the layer of a charge transporting material and the layer of a crystalline A/M/X material. Typically, the layer of a charge transporting material is disposed directly on the charge recombination layer, and the layer of a crystalline A/M/X material is disposed directly on the layer of a charge transporting material. Hence, the multi-junction device produced according to the present invention may comprise a the following layers in the following order:
- Layer of a crystalline A/M/X material;
- Layer of a charge transporting material (typically an n-type material as described herein, but this may alternatively be a p-type material);
- Charge recombination layer;
- Photoactive region.

In one embodiment, the layer of a charge transporting material is a layer of an electron transporting (n-type) material. In another embodiment, the layer of a charge transporting material is a layer of a hole transporting (p-type) material. Typically, the layer of a charge transporting material is a layer of an electron transporting (n-type) material.

Typically, the charge transporting material is soluble in dimethylformamide. Thus, the charge transporting material may be soluble in dimethylformamide (DMF), dimethysulfoxide (DMSO) or a mixture thereof.

Typically, the layer of a charge transporting material has a thickness of less than 1000 nm, or less than 500 nm, or less than 250 nm, preferably less than 100 nm. For instance, the layer of a charge transporting material may have a thickness of from 1 to 500 nm, for instance from 5 to 250 nm, or from 10 to 75 nm.

Examples of electron transporting (n-type) materials are known to the skilled person. A suitable n-type material may be an organic or inorganic material. A suitable inorganic n-type material may be selected from a metal oxide, a metal sulphide, a metal selenide, a metal telluride, a perovskite, amorphous Si, an n-type group IV semiconductor, an n-type group III-V semiconductor, an n-type group II-VI semiconductor, an n-type group I-VII semiconductor, an n-type group IV-VI semiconductor, an n-type group V-VI semiconductor, and an n-type group II-V semiconductor, any of which may be doped or undoped. More typically, the n-type material is selected from a metal oxide, a metal sulphide, a metal selenide, and a metal telluride.

Thus, the n-type layer may comprise an inorganic material selected from oxide of titanium, tin, zinc, niobium, tantalum, tungsten, indium, gallium, neodymium, palladium, or cadmium, or an oxide of a mixture of two or more of said metals. For instance, the n-type layer may comprise TiO₂, SnO₂, ZnO, Nb₂O₅, Ta₂O₅, WO₃, W₂O₅, In₂O₃, Ga₂O₃, Nd₂O₃, PbO, or CdO. Other suitable n-type materials that may be employed include sulphides of cadmium, tin, copper, or zinc, including sulphides of a mixture of two or more of said metals. For instance, the sulphide may be FeS₂, CdS, ZnS, SnS, BiS, SbS, or Cu₂ZnSnS₄.

The n-type layer may for instance comprise a selenide of cadmium, zinc, indium, or gallium or a selenide of a mixture of two or more of said metals; or a telluride of cadmium, zinc, cadmium or tin, or a telluride of a mixture of two or more of said metals. For instance, the selenide may be Cu(In,Ga)Se₂. Typically, the telluride is a telluride of cadmium, zinc, cadmium or tin. For instance, the telluride may be CdTe.

The n-type layer may for instance comprise an inorganic material selected from oxide of titanium (e.g. TiO₂), tin (e.g. SnO₂), zinc (e.g. ZnO), niobium, tantalum, tungsten, indium, gallium, neodymium, palladium, cadmium, or an oxide of a mixture of two or more of said metals; a sulphide of cadmium, tin, copper, zinc or a sulphide of a mixture of two or more of said metals; a selenide of cadmium, zinc, indium, gallium or a selenide of a mixture of two or more of said metals; or a telluride of cadmium, zinc, cadmium or tin, or a telluride of a mixture of two or more of said metals.

Examples of other semiconductors that may be suitable n-type materials, for instance if they are n-doped, include group IV elemental or compound semiconductors; amorphous Si; group III-V semiconductors (e.g. gallium arsenide); group II-VI semiconductors (e.g. cadmium selenide); group I-VII semiconductors (e.g. cuprous chloride); group IV-VI semiconductors (e.g. lead selenide); group V-VI semiconductors (e.g. bismuth telluride); and group II-V semiconductors (e.g. cadmium arsenide).

Other n-type materials may also be employed, including organic and polymeric electron-transporting materials, and electrolytes. Suitable examples include, but are not limited to a fullerene or a fullerene derivative (for instance C₆₀, C₇₀, phenyl-C₆₁-butyric acid methyl ester (PCBM), PC₇₁BM (i.e. phenyl C₇₁ butyric acid methyl ester), bis[C₆₀]BM (i.e. bis-C₆₀ butyric acid methyl ester), and 1',1",4',4"-Tetrahydro-di[1,4]methanonaphthaleno[1,2:2',3',56,60:2",3"][5,6]fullerene-C₆₀ (ICBA)), an organic electron transporting material comprising perylene or a derivative thereof, or poly{[N,N0-bis(2-octyldodecyl)-naphthalene-1,4,5,8-bis(dicarboximide)-2,6-diyl]-alt-5,50-(2,20-bithiophene)} (P(NDI2OD-T2)).

Preferably, the n-type material is phenyl-C61-butyric acid methyl ester (PCBM).

Examples of hole transporting (p-type) materials are known to the skilled person. The p-type material may be a single p-type compound or elemental material, or a mixture of two or more p-type compounds or elemental materials, which may be undoped or doped with one or more dopant elements.

The p-type material may comprise an inorganic or an organic p-type material. Typically, the p-type material is an organic p-type material.

Suitable p-type materials may be selected from polymeric or molecular hole transporters. The p-type material may for instance comprise spiro-OMeTAD (2,2',7,7'-tetrakis-(N,N-di-p-methoxyphenylamine)9,9'-spirobifluorene)), P3HT (poly(3-hexylthiophene)), PCPDTBT (Poly[2,1,3-benzothiadiazole-4,7-diyl[4,4-bis(2-ethylhexyl)-4H-cyclopenta[2,1-b:3,4-b']dithiophene-2,6-diyl]]), PVK (poly(N-vinylcarbazole)), HTM-TFSI (1-hexyl-3-methylimidazolium bis(trifluoromethylsulfonyl)imide), Li-TFSI (lithium bis(trifluoromethanesulfonyl)imide), spiro-OMETAD⁺-bis(trifluoromethanesulfonyl)imide⁻ (spiro(TFSI)₂), tBP (tert-butylpyridine), m-MTDATA (4,4',4"-tris(methylphenylphenylamino)triphenylamine), MeOTPD (N,N,N',N'-tetrakis(4-methoxyphenyl)-benzidine), BP2T (5,5'-di(biphenyl-4-yl)-2,2'-bithiophene), Di-NPB *(N,N'-*Di-[(1-naphthyl)-*N,N*'-diphenyl]-1,1'-biphenyl)-4,4'-diamine), α-NPB (N,N'-di(naphthalen-1-yl)-N,N'-diphenyl-benzidine), TNATA (4,4',4"-tris-(N-(naphthylen-2-yl)-N-phenylamine)triphenylamine), BPAPF (9,9-bis[4-(N,N-bis-biphenyl-4-yl-amino)phenyl]-9H-fluorene), spiro-NPB (N2,N7-Di-1-naphthalenyl-N2,N7-diphenyl-9,9'-spirobi[9H-fluorene]-2,7-diamine), 4P-TPD (4,4-bis-(N,N-diphenylamino)-tetraphenyl), polyTPD (i.e. Poly[N,N'-bis(4-butylphenyl)-N,N'-bisphenylbenzidine]), PTAA (i.e. poly(triaryl amine), also known as poly[bis(4-phenyl)(2,4,6-trimethylphenyl)amine]) or PEDOT:PSS. The p-type material may comprise carbon nanotubes. Usually, the p-type material is selected from spiro-OMeTAD, P3HT, PCPDTBT, spiro(TFSI)₂ and PVK. Preferably, the p-type material is spiro-OMeTAD or spiro(TFSI)₂.

Suitable p-type materials also include molecular hole transporters, polymeric hole transporters and copolymer hole transporters. The p-type material may for instance be a molecular hole transporting material, a polymer or copolymer comprising one or more of the following moieties: thiophenyl, phenelenyl, dithiazolyl, benzothiazolyl, diketopyrrolopyrrolyl, ethoxydithiophenyl, amino, triphenyl amino, carbozolyl, ethylene dioxythiophenyl, dioxythiophenyl, or fluorenyl.

The p-type material may be doped, for instance with tertbutyl pyridine and LiTFSI. The p-type material may be doped to increase the hole-density. The p-type material may for instance be doped with NOBF₄ (Nitrosonium tetrafluoroborate), to increase the hole-density.

In other embodiments, the p-type layer may comprise an inorganic hole transporter. For instance, the p-type layer may comprise an inorganic hole transporter comprising an oxide of nickel (e.g. NiO), vanadium, copper or molybdenum; CuI, CuBr, CuSCN, Cu₂O, CuO or CIS; a perovskite; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped. The p-type layer may be a compact layer of said inorganic hole transporter.

The p-type material may be an inorganic p-type material, for instance a material comprising an oxide of nickel, vanadium, copper or molybdenum; CuI, CuBr, CuSCN, Cu₂O, CuO or CIS; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped. The p-type material may for instance comprise an inorganic hole transporter selected from CuI, CuBr, CuSCN, Cu₂O, CuO and CIS.

In one embodiment, the invention comprises a step forming the substrate by disposing a layer of a charge transporting material as described herein on the charge recombination layer. Typically, a composition comprising a the charge transporting material is disposed on the charge recombination layer, preferably a solution comprising the charge transporting material. The solution is comprising the charge transporting material is typically disposed on the charge recombination layer by solution phase deposition, for instance gravure coating, slot dye coating, screen printing, ink jet printing, doctor blade coating, spray coating, roll-to-roll (R2R) processing, or spin-coating, preferably by spin-coating.

Typically, the solvent in the solution comprising the charge transporting is selected from chlorobenzene, chloroform, anisole, toluene, tetrahydrofuran, xylene or mixtures thereof. For instance, the step forming the substrate by disposing a layer of a charge transporting material on the charge recombination layer may comprise:
- preparing a solution of the charge transporting material, preferably a solution of an electron transporting (n-type) material in chlorobenzene, chloroform or a mixture thereof, more preferably wherein the electron transporting (n-type) material is PCBM;
- disposing the charge transporting material is on the charge recombination layer by spin coating.

### Charge recombination layer

The process of the present invention further comprises a step of producing the substrate by disposing the charge recombination layer on the photoactive region by solution deposition, wherein said step comprises disposing a solvent dispersion of nanoparticles of a transparent conducting oxide on the photoactive region.

The charge recombination layer comprises nanoparticles of a transparent conducting oxide. The nanoparticles create ohmic contact between both electron and hole transporting layers thus allowing for efficient charge transfer into the recombination layer. Further, such nanoparticles are easily processed using solution-based methods to form the substrate.

The nanoparticles of the transparent conducting oxide may comprise indium zinc oxide (IZO), indium tin oxide (ITO), aluminium zinc oxide (AZO), indium cadmium oxide, fluorine doped tin oxide (FTO), antimony doped tin oxide, antimony doped titanium dioxide, niobium doped tin oxide, niobium doped titanium dioxide, barium stannate, strontium vanadate, and calcium vanadate. Preferably, the nanoparticles of the transparent conducting oxide comprises indium tin oxide (ITO). Therefore, the nanoparticles of a transparent conducting oxide may be nanoparticles of indium tin oxide. Preferably, the nanoparticles of a transparent conducting oxide are nanoparticles of indium tin oxide having a size less than 500 nm, preferably less than 250 nm, more preferably less than 100 nm. Typically the size of the nanoparticles can be determined by dynamic light scattering within solution, or transmission electron microscopy of dried films.

The nanoparticles of the transparent conducting oxide may be disposed in a matrix material. The matrix material may be an inorganic or organic matrix material. It is often a dielectric matrix material, for instance an inorganic or organic dielectric matrix material. Alternatively, it may be an electron-transporting matrix material. Usually, the matrix material is an organic matrix material. Typically, the organic matrix material is an electron-transporting organic matrix material. Suitable examples include, but are not limited to a fullerene or a fullerene derivative (for instance C₆₀ or Phenyl-C61-butyric acid methyl ester (PCBM)), an organic electron transporting material comprising perylene or a derivative thereof, or poly{[N,N0-bis(2-octyldodecyl)-naphthalene-1,4,5,8-bis(dicarboximide)-2,6-diyl]-alt-5,50-(2,20-bithiophene)} (P(NDI2OD-T2)). Preferably, the organic matrix material comprises [6,6]-phenyl-C61-butyric acid methyl ester (PCBM).

Typically, the charge recombination layer further comprises a conducting polymer. For instance, the charge recombination layer may comprise p-doped polyTPD, Poly triarylamine (PTAA), polythiophene. Typically, the conducting polymer comprises poly(3,4-ethylenedioxythiophene) (PEDOT) or a derivative thereof. For instance, the conducting polymer may comprise poly(3,4-ethylenedioxythiophene) and polystyrene sulfonate (PEDOT:PSS) or poly(3,4-ethylenedioxythiophene)-tetramethacrylate (PEDOT:TMA). Preferably the conducting polymer comprises poly(3,4-ethylenedioxythiophene) and polystyrene sulfonate (PEDOT:PSS).

The charge recombination layer may comprise nanoparticles of a transparent conducting oxide and a conducting polymer. For instance the charge recombination layer may comprise indium tin oxide (ITO) nanoparticles and poly(3,4-ethylenedioxythiophene) and polystyrene sulfonate (PEDOT:PSS). The nanoparticles of a transparent conducting oxide may be evenly distributed in the conducting polymer of the charge recombination layer. Alternatively, the nanoparticles of a transparent conducting oxide and the conducting polymer may form two distinct sub-layers within the charge recombination layer.

Typically, the charge recombination layer has a thickness of less than 1000 nm, for instance less than 750 nm, less than 250 nm, preferably less than 100 nm. For instance, the charge recombination layer may have a thickness of from 5 to 500 nm, from 10 to 250 nm, from 20 to 150 nm, preferably from 25 to 125 nm. In some embodiments, for instance when the charge recombination layer is a tunnel junction, the charge recombination layer has a thickness of less than 50 nm, for instance less than 30 nm, for example less than or equal to 20 nm, or for instance less than or equal to 10 nm.

The charge recombination layer may be a tunnel junction. A tunnel junction is generally a very thin film, for instance a film having a thickness of less than or equal to 20 nm, for instance less than or equal to 10 nm. The film typically comprises a very thin layer of a highly-doped n-type material interfaced with a very thin layer of a highly-doped p-type material. This enables charges to tunnel through the junction.

Accordingly, in one embodiment, the charge recombination layer is a tunnel junction. Typically, the tunnel junction has a thickness of less than 30 nm, for instance less than or equal to 20nm, or less than or equal to 10 nm. The tunnel junction typically comprises, and more typically consists of, a first sub-layer disposed on a second sub-layer, wherein one of the first and second sub-layers is an n-type material and the other of the first and second sub- layers is a p-type material. The n-type material may comprise any of the n-type materials described herein. The n-type material is generally doped with a dopant. The p-type material may comprise any of the p-type materials described herein. Generally, the p-type material is doped with a dopant. Dopants for doping n- and p- type materials in tunnel junctions are known in the art.

In the present invention, disposing the charge recombination layer on the photoactive region comprises a step of disposing a solvent dispersion of nanoparticles of a transparent conducting oxide on the photoactive region.

Typically, the solvent is chosen to be orthogonal to those used for the underlying layers, for instance the photoactive region and/or the charge transporting layer, if present. A solvent is orthogonal to another solvent when it does not dissolve the layer of material deposited from the other solvent. For instance, the solvent may be a polar solvent, for instance a polar protic solvent such as an alcohol. It may for instance be isopropanol (2-propanol), methanol, or ethanol. It may be a polar aprotic solvent, for instance, acetone, acetonitrile, methylethylketone.

Typically, the solvent dispersion of nanoparticles of a transparent conducting oxide is a dispersion of indium tin oxide nanoparticles in isopropanol.

Typically, the indium tin oxide nanoparticles comprise less than 75 weight % of the solvent dispersion (total weight of solvent plus nanoparticles), for instance less than 50 weight % of the solvent dispersion. For instance, the indium tin oxide nanoparticles may comprise between 0.001 and 50 weight % of the solvent dispersion, between 0.1 and 10 weight % of the solvent dispersion, between 0.5 and 5 weight % of the solvent dispersion, preferably about 1 weight % of the solvent dispersion.

The solvent dispersion of nanoparticles of a transparent conducting oxide may be disposed on the photoactive region by roll-to-roll (R2R) processing, blade coating, inkjet printing or spin-coating. Typically, the solvent dispersion of nanoparticles of a transparent conducting oxide is disposed on the photoactive region by spin-coating. In one embodiment, the solvent dispersion of nanoparticles of a transparent conducting oxide is spin-coated directly onto the photoactive region. Typically, the spin coating is performed at a speed of at least 1000 RPM, for instance at least 2000 RPM, at least 3000 RPM, at least 4000 RPM or at least 5000 RPM, for example between 2000 and 10000 RPM, between 4000 and 8000 RPM preferably about 6000 RPM. Typically, the spin coating is performed for a time of at least one second, at least 5 seconds or at least 10 seconds, for example from 1 second to 1 minute, from 10 seconds to 30 seconds, preferably about 20 seconds.

Thus, the step of producing the substrate by disposing the charge recombination layer on the photoactive region by solution deposition may comprise spin coating a solvent dispersion of indium tin oxide nanoparticles in isopropanol on to the substrate (photoactive region) at a speed of about 6000 RPM for about 20 seconds.

The charge recombination layer may further comprise a matrix material. The matrix material may be an inorganic or organic matrix material. It may be a dielectric matrix material, for instance an inorganic or organic dielectric matrix material. It is often however an electron-transporting matrix material. Usually, the matrix material is an organic matrix material, as described herein. Accordingly, the solvent dispersion of nanoparticles may further comprise a matrix material, for instance an organic matrix material, as described herein. The matrix material may for instance be a dielectric matrix material, or it may be an electron-transporting matrix material. The matrix material may be organic or inorganic, but is typically organic, for instance an organic electron-transporting matrix material. Disposing the charge recombination layer on the photoactive region may comprise disposing a solvent dispersion of nanoparticles of a transparent conducting oxide and the matrix material, e.g. an organic matrix material, on the photoactive region.

The matrix material and the nanoparticles may be disposed together (e.g. as described above) or separately, in the process of the invention. When they are disposed separately, one option is first to dispose the nanoparticles, e.g. as a solvent dispersion of the nanoparticles, and subsequently to dispose the matrix material, e.g. as a solution or dispersion of the matrix material in a solvent. The matrix material may then percolate into the disposed nanoparticles such that the nanoparticles are dispersed in the matrix material.

When a conducting polymer is present in the charge recombination layer, disposing the charge recombination layer on the photoactive region may comprise disposing a conducting polymer as described above on the photoactive region, and disposing a solvent dispersion of nanoparticles of a transparent conducting oxide on the photoactive region. Preferably, the conducting polymer comprises poly(3,4-ethylenedioxythiophene) and polystyrene sulfonate (PEDOT:PSS). Typically, the conducting polymer is dispersed in a solvent. For example, the conducting polymer may be dispersed in an alcohol, water, a mixture of one or more alcohols and water, or a mixture of alcohols, for instance it may be dispersed in isopropanol (2-propanol), ethanol (EtOH), methanol (MeOH), or water or a mixture thereof. Thus, disposing the charge recombination layer on the photoactive region may comprise disposing a dispersion of poly(3,4-ethylenedioxythiophene) and polystyrene sulfonate (PEDOT:PSS) in isopropanol (2-propanol), ethanol (EtOH), methanol (MeOH), water or a mixture thereof on the photoactive region.

The conducting polymer may be disposed on the photoactive region by roll-to-roll (R2R) processing, blade coating, inkjet printing or spin-coating. Usually, the conducting polymer is disposed on the photoactive region by spin-coating. In one embodiment, the conducting polymer is spin-coated directly onto the photoactive region. Typically, the spin coating is performed at a speed of at least 1000 RPM, for instance at least 2000 RPM, at least 3000 RPM, at least 4000 RPM or at least 5000 RPM, for example between 2000 and 10000 RPM, between 4000 and 8000 RPM preferably about 6000 RPM. Typically, the spin coating is performed for a time of at least one second, at least 5 seconds or at least 10 seconds, for example from 1 second to 1 minute, from 10 seconds to 30 seconds, preferably about 20 seconds.

Typically, disposing the charge recombination layer on the photoactive region comprises two steps:
1) disposing a conducting polymer on the photoactive region;
2) disposing the solvent dispersion of nanoparticles of a transparent conducting oxide on the photoactive region.

Typically, both the solvent dispersion of the nanoparticles and the conducting polymer are disposed on the photoactive region by spin-coating. The steps of spin-coating the solvent dispersion of the nanoparticles and (if present) the conducting polymer on the photoactive region may be combined with one or more annealing steps. Typically, the annealing is performed at a temperature of at least 20°C, for instance temperature in the range of 20 to 150°C, for instance 30 to 120°C, 40 to 110°C, 60 to 100°C, 70 to 90°C, preferably about 80°C. Typically the annealing is performed for a period of from 1 to 120 minutes, for instance from 2 to 60 minutes, 3 to 45 minutes, 4 to 30 minutes, from 5 to 15 minutes or about 10 minutes. Thus, the annealing may be performed at a temperature of 20 to 150°C for a period of from 1 to 120 minutes, for instance at a temperature of 60 to 100°C for a period of from 4 to 30 minutes, preferably at about 80°C for about 10 minutes.

In one embodiment, disposing the charge recombination layer on the photoactive region comprises the following steps:
1. disposing a conducting polymer (optionally by spin coating) by disposing a solvent dispersion of the conducting polymer on the photoactive region, preferably wherein the conducting polymer comprises poly(3,4-ethylenedioxythiophene) and polystyrene sulfonate (PEDOT:PSS);
2. optionally annealing the conducting polymer disposed on the photoactive region, preferably at about 80°C for about 10 minutes;
3. disposing the solvent dispersion of nanoparticles of a transparent conducting oxide on the photoactive region (optionally by spin coating), preferably wherein the nanoparticles are nanoparticles of indium tin oxide (ITO);
4. optionally annealing the nanoparticles of a transparent conducting oxide on the photoactive region, preferably at about 80°C for about 10 minutes.

Disposing the charge recombination layer on the photoactive region may comprise simultaneously disposing a conducting polymer and disposing the solvent dispersion of nanoparticles of a transparent conducting oxide on the photoactive region. For instance, the conducting polymer and the nanoparticles of a transparent conducting oxide may be present in the same solvent dispersion. The dispersion comprising the conducting polymer and the nanoparticles of a transparent conducting oxide may be disposed on the photoactive region by spin coating, as described above.

### Photoactive region

The photoactive material in the photoactive region in the substrate may comprise any suitable photoactive material known to the skilled person. For instance, the photoactive material in the photoactive region may comprise silicon, Cu(In,Ga)Se₂ (CIGS), Cu₂ZnSn(S,Se)₄ (CZTSSe), CuInS (CIS) metal chalcogenide nanocrystals such as PbS, PbSe or PbS₁₋ₓSeₓ, chalcogenide thin films such as CdTe, or CdTe₁₋ₓSeₓ, or CdTe₁₋ₓSₓ, or a crystalline A/M/X material. Typically, the photoactive material in the photoactive region in the substrate comprises a crystalline A/M/X material, which crystalline A/M/X material comprises a compound of formula [A]ₐ[M]_{b}[X]_{c} as described herein.

For instance, the photoactive material in the photoactive region may comprise a compound of formula [A]ₐ[M]_{b}[X]_{c}, wherein said compound is a compound of formula (IA), (IB), (IC), (ID), (IE), (IF), (IG), (IH), (IIIA), (IIIB),(IIIC), (VIA), (VIB), or (VIC) as described herein. Typically, the photoactive material in the photoactive region comprises a compound of formula [A]ₐ[M]_{b}[X]_{c}, wherein said compound is a compound of formula (I), for instance a compound of formula (IA), (IB), (IC), (ID), (IE), (IF), (IG) or (IH).

For instance, the photoactive material in the photoactive region may comprise a compound of formula (IA):

AMX₃ (IA)

wherein A, M and X are as defined above. In a preferred embodiment, A is selected from (CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M is Pb²⁺ or Sn²⁺ and X is selected from Br⁻, Cl⁻ and I⁻.

For instance, the photoactive material in the photoactive region may comprise, or consist essentially of, a perovskite compound of formula (IA) selected from APbI₃, APbBr₃, APbCl₃, ASnI₃, ASnBr₃ and ASnCl₃, wherein A is a cation as described herein.

For instance, the photoactive material in the photoactive region may comprise, or consist essentially of, a perovskite compound of formula (IA) selected from CH₃NH₃PbI₃, CH₃NH₃PbBr₃, CH₃NH₃PbCl₃, CH₃NH₃SnI₃, CH₃NH₃SnBr₃, CH₃NH₃SnCl₃, CsPbI₃, CsPbBr₃, CsPbCl₃, CsSnI₃, CsSnBr₃, CsSnCl₃, (H₂N-C(H)=NH₂)PbI₃, (H₂N-C(H)=NH₂)PbBr₃, (H₂N-C(H)=NH₂)PbCl₃, (H₂N-C(H)=NH₂)SnI₃, (H₂N-C(H)=NH₂)SnBr₃ and (H₂N-C(H)=NH₂)SnCl₃, in particular CH₃NH₃PbI₃ or CH₃NH₃PbBr₃, preferably CH₃NH₃PbI₃.

For instance, the photoactive material in the photoactive region may comprise a compound of formula (ID):

[A^{I}ₓA^{II}₁₋ₓ]M[X^{I}_{y}X^{II}_{1-y}]₃ (ID)

wherein A^{I} and A^{II} are as defined above with respect to A, M is as defined above, X^{I} and X^{II} are as defined above in relation to X and wherein x and y are both greater than 0 and less than 1. In a preferred embodiment, A^{I} and A^{II} are each selected from ((CH₃NH₃)⁺, (CH₃CH₂NH₃)⁺, (CH₃CH₂CH₂NH₃)⁺, (N(CH₃)₄)⁺, (H₂N-C(H)=NH₂)⁺, (H₂N-C(CH₃)=NH₂)⁺, (H₂N-C(NH₂)=NH₂)⁺, Cs⁺ and Rb⁺; M is Pb²⁺ or Sn²⁺;and X^{I} and X^{II} are each selected from Br⁻, Cl⁻ and I⁻.

For instance, the photoactive material in the photoactive region may comprise, or consist essentially of, a perovskite compound of formula (ID) selected from [(CH₃NH₃)ₓ(H₂N-C(H)=NH₂)₁₋ₓ]Pb[Br_{y}I_{1-y}]₃, [(CH₃NH₃)ₓ(H₂N-C(H)=NH₂)₁₋ₓ]Pb[Br_{y}Cl_{1-y}]₃, [(CH₃NH₃)ₓ(H₂N-C(H)=NH₂)₁₋ₓ]Pb[I_{y}Cl_{1-y}]₃, [(CH₃NH₃)ₓCs₁₋ₓ]Pb[Br_{y}I_{1-y}]₃, [(CH₃NH₃)ₓCs₁₋ₓ]Pb[Br_{y}Cl_{1-y}]₃, [(CH₃NH₃)ₓCs₁₋ₓ]Pb[I_{y}Cl_{1-y}]₃, [(H₂N-C(H)=NH₂)ₓCs₁₋ₓ]Pb[Br_{y}I_{1-y}]₃, [(H₂N-C(H)=NH₂)ₓCs₁₋ₓ]Pb[Br_{y}Cl_{1-y}]₃, [(H₂N-C(H)=NH₂)ₓCs₁₋ₓ]Pb[I_{y}Cl_{1-y}]₃, [(CH₃NH₃)ₓ(H₂N-C(H)=NH₂)₁₋ₓ]Sn[Br_{y}I_{1-y}]₃, [(CH₃NH₃)ₓ(H₂N-C(H)=NH₂)₁₋ₓ]Sn[Br_{y}Cl_{1-y}]₃, [(CH₃NH₃)ₓ(H₂N-C(H)=NH₂)₁₋ₓ]Sn[I_{y}Cl_{1-y}]₃, [(CH₃NH₃)ₓCs₁₋ₓ]Sn[Br_{y}I_{1-y}]₃, [(CH₃NH₃)ₓCs₁₋ₓ]Sn[Br_{y}Cl_{1-y}]₃, [(CH₃NH₃)ₓCs₁₋ₓ]Sn[I_{y}Cl_{1-y}]₃, [(H₂N-C(H)=NH₂)ₓCs₁₋ₓ]Sn[Br_{y}I_{1-y}]₃, [(H₂N-C(H)=NH₂)ₓCs₁₋ₓ]Sn[Br_{y}Cl_{1-y}]₃, and [(H₂N-C(H)=NH₂)xCs₁₋ₓ]Sn[I_{y}Cl_{1-y}]₃, where x and y are both greater than 0 and less than 1, for instance x and y may both be from 0.01 to 0.99 or from 0.05 to 0.95 or 0.1 to 0.9. Preferably, the photoactive material in the photoactive region comprises a perovskite compound of formula [(H₂N-C(H)=NH₂)ₓCs₁₋ₓ]Pb[Br_{y}I_{1-y}]₃ wherein x and y are both from 0.1 to 0.9.

The crystalline A/M/X material deposited on the substrate and the crystalline A/M/X material in the photoactive region may be different or the same. Typically, the crystalline A/M/X material deposited on the substrate and the crystalline A/M/X material in the photoactive region are different. For instance, the crystalline A/M/X material in the photoactive region may comprise, or consist essentially of, a compound of formula (IA), (IB), (IC), (ID), (IE), (IF), (IG), (IH), (IIIA), (IIIB),(IIIC), (VIA), (VIB), or (VIC) as described herein, preferably a compound of formula (I), for instance a compound of formula (IA), (IB), (IC), (ID), (IE), (IF), (IG) or (IH) as described herein, and the crystalline A/M/X material deposited on the substrate may comprise, or consist essentially of, a different compound of formula (IA), (IB), (IC), (ID), (IE), (IF), (IG), (IH), (IIIA), (IIIB),(IIIC), (VIA), (VIB), or (VIC) as described herein, preferably a compound of formula (I), for instance a compound of formula (IA), (IB), (IC), (ID), (IE), (IF), (IG) or (IH) as described herein.

For instance, the crystalline A/M/X material in the photoactive region may comprise, or consist essentially of, a compound of formula (IA), and the crystalline A/M/X material deposited on the substrate may comprise, or consist essentially of, a compound of formula (IB), (IC), (ID), (IE), (IF), (IG), (IH), (IIIA), (IIIB),(IIIC), (VIA), (VIB), or (VIC) as described herein, for instance a compound of formula (IB), (IC), (ID), (IE), (IF), (IG) or (IH) as described herein, preferably a compound of formula (ID), (IE) or (IF) as described herein.

For example, the crystalline A/M/X material in the photoactive region may comprise, or consist essentially of, a compound of formula APbI₃, APbBr₃, APbCl₃, ASnI₃, ASnBr₃ or ASnCl₃, wherein A is a cation as described herein, preferably APbI₃, more preferably CH₃NH₃PbI₃, and the crystalline A/M/X material deposited on the substrate may comprise, or consist essentially of, a compound of formula CH₃NH₃[Pb_{z}Sn_{1-z}]Cl₃, CH₃NH₃[Pb_{z}Sn_{1-z}]Br₃, CH₃NH₃[Pb_{z}Sn_{1-z}]I₃, Cs[Pb_{z}Sn_{1-z}]Cl₃, Cs[Pb_{z}Sn_{1-z}]Br₃, Cs[Pb_{z}Sn_{1-z}]I₃, (H₂N-C(H)=NH₂)[Pb_{z}Sn_{1-z}]Cl₃, (H₂N-C(H)=NH₂)[Pb_{z}Sn_{1-z}]Br₃, or (H₂N-C(H)=NH₂)[Pb_{z}Sn_{1-z}]I₃, where z is greater than 0 and less than 1, for instance z may be from 0.01 to 0.99 or from 0.05 to 0.95 or 0.1 to 0.9, or of formula [(CH₃NH₃)ₓ(H₂N-C(H)=NH₂)₁₋ₓ][Pb_{z}Sn_{1-z}]Cl₃, [(CH₃NH₃)ₓ(H₂N-C(H)=NH₂)₁₋ₓ][Pb_{z}Sn_{1-z}]Br₃, [(CH₃NH₃)ₓ(H₂N-C(H)=NH₂)₁₋ₓ][Pb_{z}Sn_{1-z}]I₃, [(CH₃NH₃)ₓCs₁₋ₓ][Pb_{z}Sn_{1-z}]Cl₃, [(CH₃NH₃)ₓCs₁₋ₓ][Pb_{z}Sn_{1-z}]Br₃, [(CH₃NH₃)ₓCs₁₋ₓ][Pb_{z}Sn_{1-z}]I₃, [(H₂N-C(H)=NH₂)ₓCs₁₋ₓ][Pb_{z}Sn_{1-z}]Cl₃, [(H₂N-C(H)=NH₂)ₓCs₁₋ₓ][Pb_{z}Sn_{1-z}]Br₃, or [(H₂N-C(H)=NH₂)ₓCs₁₋ₓ][Pb_{z}Sn_{1-z}]I₃, where x and z are both greater than 0 and less than 1, for instance x and z may each be from 0.01 to 0.99 or from 0.05 to 0.95 or 0.1 to 0.9, preferably a compound of formula CH₃NH₃[Pb_{z}Sn_{1-z}]I₃ or [(CH₃NH₃)ₓ(H₂N-C(H)=NH₂)₁₋ₓ][Pb_{z}Sn_{1-z}]I₃ wherein x, y and z are each from 0.05 to 0.95 or 0.1 to 0.9.

The photoactive material in the photoactive region may comprise a perovskite compound of formula:

Cs_{z}(H₂N-C(H)=NH₂)_{(1-z)}[M][X]₃

wherein: [M] is as defined above, and for instance, may comprise Pb, Sn, or a mixture of Pb and Sn; [X] is one or more different halide anions, for instance two or more different halide anions; and z is from 0.01 to 0.99. For instance, the perovskite may be a compound of formula Cs_{z}(H₂N-C(H)=NH₂)_{(1-z)}[PbₓSn₁₋ₓ]I₃, Cs_{z}(H₂N-C(H)=NH₂)_{(1-z)}[PbₓSn₁₋ₓ]Br₃ or Cs_{z}(H₂N-C(H)=NH₂)_{(1-z)}[PbₓSn₁₋ₓ]I_{y}Br_{3(1-y)}, wherein z is as defined above and x is from 0 to 1 (and may for instance be 0.5) and y is from 0.01 to 0.99.

The photoactive material in the photoactive region may comprise a compound of formula:

Cs_{z}(H₂N-C(H)=NH₂)_{(1-z)}[M]X_{3y}X'_{3(1-y)}

wherein: [M] is as defined above, and for instance, may comprise Pb, Sn, or a mixture of Pb and Sn; X is a first halide anion selected from I⁻, Br⁻, Cl⁻ and F⁻; X' is a second halide anion which is different from the first halide anion and is selected from I⁻, Br⁻, Cl⁻ and F⁻; z is from 0.01 to 0.99; and y is from 0.01 to 0.99. For instance, the perovskite may be a compound of formula Cs_{z}(H₂N-C(H)=NH₂)_{(1-z)}PbBr_{3y}I_{3(1-y)}.

The crystalline A/M/X material in the photoactive region may comprise, or consist essentially of, a compound of formula (ID), and the crystalline A/M/X material deposited on the substrate may comprise, or consist essentially of, a compound of formula (IA), (IB), (IC), (IE), (IF), (IG), (IH), (IIIA), (IIIB),(IIIC), (VIA), (VIB), or (VIC) as described herein, for instance a compound of formula (IA), (IB), (IC), (IE), (IF), (IG) or (IH) as described herein, preferably a compound of formula (IA), (IE) or (IF) as described herein.

For example, the crystalline A/M/X material in the photoactive region may comprise, or consist essentially of, a compound of formula [(CH₃NH₃)ₓ(H₂N-C(H)=NH₂)₁₋ₓ]Pb[Br_{y}I_{1-y}]₃, [(CH₃NH₃)_{X}(H₂N-C(H)=NH₂)₁₋ₓ]Pb[Br_{y}Cl_{1-y}]₃, [(CH₃NH₃)ₓ(H₂N-C(H)=NH₂)₁₋ₓ]Pb[I_{y}Cl_{1-y}]₃, [(CH₃NH₃)ₓCs₁₋ₓ]Pb[Br_{y}I_{1-y}]₃, [(CH₃NH₃)ₓCs₁₋ₓ]Pb[Br_{y}Cl_{1-y}]₃, [(CH₃NH₃)ₓCs₁₋ₓ]Pb[I_{y}Cl_{1-y}]₃, [(H₂N-C(H)=NH₂)ₓCs₁₋ₓ]Pb[Br_{y}I_{1-y}]₃, [(H₂N-C(H)=NH₂)ₓCs₁₋ₓ]Pb[Br_{y}Cl_{1-y}]₃, [(H₂N-C(H)=NH₂)ₓCs₁₋ₓ]Pb[I_{y}Cl_{1-y}]₃, [(CH₃NH₃)ₓ(H₂N-C(H)=NH₂)₁₋ₓ]Sn[Br_{y}I_{1-y}]₃, [(CH₃NH₃)ₓ(H₂N-C(H)=NH₂)₁₋ₓ]Sn[Br_{y}Cl_{1-y}]₃, [(CH₃NH₃)ₓ(H₂N-C(H)=NH₂)₁₋ₓ]Sn[I_{y}Cl_{1-y}]₃, [(CH₃NH₃)ₓCs₁₋ₓ]Sn[Br_{y}I_{1-y}]₃, [(CH₃NH₃)ₓCs₁₋ₓ]Sn[Br_{y}Cl_{1-y}]₃, [(CH₃NH₃)ₓCs₁₋ₓ]Sn[I_{y}Cl_{1-y}]₃, [(H₂N-C(H)=NH₂)ₓCs₁₋ₓ]Sn[Br_{y}I_{1-y}]₃, [(H₂N-C(H)=NH₂)ₓCs₁₋ₓ]Sn[Br_{y}Cl_{1-y}]₃, or [(H₂N-C(H)=NH₂)xCs₁₋ₓ]Sn[I_{y}Cl_{1-y}]₃, where x and y are both greater than 0 and less than 1, for instance x and y may both be from 0.01 to 0.99 or from 0.05 to 0.95 or 0.1 to 0.9, preferably a compound of formula [(CH₃NH₃)ₓCs₁₋ₓ]Pb[Br_{y}I_{1-y}]₃, where x and y are from 0.05 to 0.95 or 0.1 to 0.9, and the crystalline A/M/X material deposited on the substrate may comprise, or consist essentially of, a compound of formula APbI₃, APbBr₃, APbCl₃, ASnI₃, ASnBr₃ or ASnCl₃, wherein A is a cation as described herein, preferably APbI₃, more preferably CH₃NH₃PbI₃; or CH₃NH₃[Pb_{z}Sn_{1-z}]Cl₃, CH₃NH₃[Pb_{z}Sn_{1-z}]Br₃, CH₃NH₃[Pb_{z}Sn_{1-z}]I₃, Cs[Pb_{z}Sn_{1-z}]Cl₃, Cs[Pb_{z}Sn_{1-z}]Br₃, Cs[Pb_{z}Sn_{1-z}]I₃, (H₂N-C(H)=NH₂)[Pb_{z}Sn_{1-z}]Cl₃, (H₂N-C(H)=NH₂)[Pb_{z}Sn_{1-z}]Br₃, and (H₂N-C(H)=NH₂)[Pb_{z}Sn_{1-z}]I₃, where z is greater than 0 and less than 1, for instance z may be from 0.01 to 0.99 or from 0.05 to 0.95 or 0.1 to 0.9, preferably CH₃NH₃[Pb_{z}Sn_{1-z}]I₃ where z is from 0.05 to 0.95 or 0.1 to 0.9.

Alternatively, the crystalline A/M/X material deposited on the substrate and the crystalline A/M/X material in the photoactive region may both be compounds of the same formula ((IA), (IB), (IC), (ID), (IE), (IF), (IG), (IH), (IIIA), (IIIB),(IIIC), (VIA), (VIB), or (VIC) as described herein) but have a different chemical composition (for instance one may be CH₃NH₃PbI₃ and the other may be CH₃NH₃PbBr₃, or one may be CH₃NH₃PbI₃ and the other may be CH₃NH₃SnI₃).

Typically, the photoactive region comprises one or more charge transporting layers, for instance two charge transporting layers. The charge transporting layers may be layers of an electron transporting (n-type) material, as described herein, or layers of a hole transporting (p-type) material, as described herein. Typically, the photoactive region comprises two charge transporting layers wherein one of the charge transporting layers is a layer of an electron transporting (n-type) material as described herein, and the other charge transporting layer is a layer of a hole transporting (p-type) material as described herein.

Preferably, the photoactive region comprises a layer of an electron transporting (n-type) material, wherein said electron transporting material comprises PCBM, and the other charge transporting layer is a layer of a hole transporting (p-type) material, wherein said hole transporting material comprises spiro-OMeTAD or spiro(TFSI)₂.

Hence, the photoactive region may comprise the following layers in the following order:
- Layer of a charge transporting material, preferably a layer of a hole transporting (p-type) material, more preferably wherein said hole transporting material comprises spiro-OMeTAD;
- Layer of a photoactive material as described herein;
- Layer of a charge transporting material, preferably a layer of an electron transporting (n-type) material, more preferably wherein said electron transporting material comprises PCBM.

The layer of an electron-transporting (n-type) material may for instance comprise a layer of an organic n-type material and a layer of an inorganic n-type material. Often the layer of the organic n-type material (which may be as defined further herein, e.g. it may be PCBM) is disposed on a layer of an inorganic n-type material (which also may be as further defined herein, and may for instance be SnO₂). The layer of an electron-transporting (n-type) material typically has this structure when it is in contact with an electrode, for instance when it is in contact with a first electrode which comprises a transparent conducting oxide (such as, for instance, fluorine doped tin oxide (FTO) or indium doped tin oxide (ITO)). Typically, the inorganic n-type layer of the layer of the electron-transporting material (which it often SnO₂) is in contact with the transparent conducting oxide, for instance with FTO. Indeed, the present inventors have found that such an inorganic n-type layer improves the electronic contact of the organic n-type layer with the transparent conducting oxide. Similarly, the inventors have found that the organic n-type layer (e.g. PCBM) makes more stable electronic contact to the photoactive material than an inorganic n-type layer, particularly when the photoactive material is a crystalline A/M/X material as defined herein. They have also found that that having a double n-layer helps inhibit pinholes in the n-layer. Thus, the present invention typically employs two n-type layers in between the electrode which comprises a transparent conducting oxide and the photoactive material. The inventors have found in particular that SnO₂ improves the electronic contact of PCBM with FTO, and that the double SnO₂/PCBM n-type layer is improved compared to SnO₂ alone because PCBM makes more stable electronic contact to a perovskite photoactive material.

Typically, the photoactive region, comprising the layer of a photoactive material and optionally the layers of charge transporting material, has a total thickness of from 10 to 5000 nm, for instance from 50 to 3000 nm, from 100 to 2000 nm, from 200 to 1500 nm, preferably from 250 to 1250 nm. Typically, when any layers of charge transporting material are present, they have an individual thickness of less than 200 nm, for instance less than 150 nm or less than 100 nm, from 1 to 100 nm, typically from 10 to 75 nm typically 30 to 60 nm.

The layer of a photoactive material in the photoactive region may also be produced using the aprotic solvent/organic amine solvent system as used in the process of the present invention. For instance, the process of the present invention may further comprise a step of producing the substrate by disposing a layer of a crystalline A/M/X material, which crystalline A/M/X material comprises a compound of formula [A]ₐ[M]_{b}[X]_{c} as described herein; wherein the process comprises forming the layer of the crystalline A/M/X material by disposing a film-forming solution on a substrate layer, for instance an n-type or p-type layer in the substrate, wherein the film-forming solution comprises:
(a) one or more M cations; and
(b) a solvent;
wherein the solvent comprises
(i) an aprotic solvent; and
(ii) an organic amine.

Alternatively, the layer of a photoactive material in the photoactive region may be produced according to other methods known to the skilled person. For instance, the process of the present invention may further comprise a step of producing the substrate by disposing a layer of a crystalline A/M/X material, which crystalline A/M/X material comprises a compound of formula [A]ₐ[M]_{b}[X]_{c} as described herein; wherein the process comprises forming the layer of the crystalline A/M/X material by conventional high boiling point solvent deposition methods, for instance by disposing (e.g. by spin coating) a solution of the A/M/X precursor compounds in DMF, DMSO or a mixture thereof, onto the substrate precursor.

### Triple-junction device

In one embodiment, the substrate comprises two separate photoactive regions as described herein, wherein each photoactive region comprises a photoactive material. By two separate photoactive regions it is meant that the substrate comprises two photoactive regions that are not in direct physical contact with each other. When the substrate comprises two separate photoactive regions, the layer of a crystalline A/M/X material formed on the substrate forms a part of a third photoactive region. Thus, the multi-junction device produced according to the process of the present invention may comprise three photoactive regions. Thus, the multi-junction device produced according to the process of the present invention may be a triple-junction device. Typically, at least two of the photoactive regions in the multi-junction device are formed using a film-forming solution as defined herein, with reference to the process of the invention.

In this embodiment, a further charge recombination layer, as described herein, may be disposed between the two photoactive regions in the substrate. Thus, the substrate may comprise two photoactive regions, separated by the further charge recombination layer. For instance, the substrate may comprise the following layers in the following order:
- optional charge transporting layer, preferably a layer of an electron transporting (n-type) material;
- charge recombination layer;
- photoactive region;
- charge recombination layer;
- photoactive region.

Each photoactive region may be as described above. For instance each photoactive region may comprise one or more charge transporting layers as described herein, for instance two charge transporting layers. The charge transporting layers may be layers of an electron transporting (n-type) material, as described herein, or layers of a hole transporting (p-type) material, as described herein. Typically, each photoactive region comprises two charge transporting layers wherein one of the charge transporting layers is a layer of an electron transporting (n-type) material as described herein, and the other charge transporting layer is a layer of a hole transporting (p-type) material as described herein. These layers are generally disposed either side (above and below, respectively) of a layer of a photoactive material as described herein.

Preferably, each photoactive region comprises a layer of an electron transporting (n-type) material, wherein said electron transporting material comprises PCBM, and the other charge transporting layer is a layer of a hole transporting (p-type) material, wherein said hole transporting material comprises spiro-OMeTAD.

The layer of the electron transporting material in one of the photoactive regions may comprise a layer of an organic n-type material and a layer of an inorganic n-type material. Often the layer of the organic n-type material (e.g. PCBM) is disposed on a layer of an inorganic n-type material (e.g. SnO₂). The layer of an electron-transporting (n-type) material typically has this structure when it is in contact with an electrode, for instance when it is in contact with a first electrode which comprises a transparent conducting oxide (such as, for instance, fluorine doped tin oxide, FTO).

Hence, each photoactive region may comprise the following layers in the following order:
- Layer of a charge transporting material, preferably a layer of a hole transporting (p-type) material, more preferably wherein said hole transporting material comprises spiro-OMeTAD;
- Layer of a photoactive material as described herein;
- Layer of a charge transporting material, preferably a layer of an electron transporting (n-type) material, more preferably wherein said electron transporting material comprises PCBM, or comprises PCBM and SnO₂.

Each photoactive material in each photoactive region may comprise a crystalline A/M/X material, which crystalline A/M/X material comprises a compound of formula [A]ₐ[M]_{b}[X]_{c} as described herein. For instance, each photoactive material in the photoactive region may comprise a compound of formula [A]ₐ[M]_{b}[X]_{c}, wherein said compound is a compound of formula (IA), (IB), (IC), (ID), (IE), (IF), (IG), (IH), (IIIA), (IIIB),(IIIC), (VIA), (VIB), or (VIC) as described herein. Typically, each photoactive material in the photoactive region comprises a compound of formula [A]ₐ[M]_{b}[X]_{c}, wherein said compound is a compound of formula (I), for instance a compound of formula (IA), (IB), (IC), (ID), (IE), (IF), (IG) or (IH).

The crystalline A/M/X materials in the two photoactive regions may be the same crystalline A/M/X material or different crystalline A/M/X materials as described herein. Preferably, at least two of the crystalline A/M/X materials selected from the crystalline A/M/X material deposited on the substrate and the crystalline A/M/X materials in the two photoactive regions are different. In one embodiment, all three of the crystalline A/M/X materials selected from the crystalline A/M/X material deposited on the substrate and the crystalline A/M/X materials in the two photoactive regions are different.

For example, the layer of a photoactive material in one photoactive region may comprise a compound of formula ID, the layer of a photoactive material in the other photoactive region may comprise a compound of formula IA, and the crystalline A/M/X material deposited on the substrate may comprise a compound of formula IE.

Preferably, at least one of the layers of crystalline A/M/X material in one of the photoactive regions is deposited using the aprotic solvent/organic amine solvent system as used in the process of the present invention. In one embodiment, each layer of photoactive material in each of the photoactive regions may be deposited using the aprotic solvent/organic amine solvent system as used in the process of the present invention.

Alternatively, one of the layers of photoactive material in one of the photoactive regions is produced according to other methods known to the skilled person. For instance, the layer of a photoactive material may be deposited by conventional high boiling point solvent deposition methods, for instance by spin coating a solution of the A/M/X precursor compounds in DMF, DMSO or a mixture thereof.

### Electrodes

The substrate typically comprises a first electrode. The first electrode may comprise a metal (for instance silver, gold, aluminium or tungsten) or a transparent conducting oxide (for instance fluorine doped tin oxide (FTO) or indium doped tin oxide (ITO)). Typically, the first electrode comprises a transparent conducting oxide. The thickness of the layer of a first electrode is typically from 5 nm to 100 nm.

The substrate typically comprises:
i) a first electrode, preferably wherein the first electrode comprises a transparent conducting oxide,
ii) a photoactive region, said photoactive region preferably comprising a crystalline A/M/X material which crystalline A/M/X material comprises a compound of formula [A]ₐ[M]_{b}[X]_{c} as described herein,
iii) a charge recombination layer as described herein disposed on the photoactive region, and
iv) optionally, a layer of a charge transporting material as described herein disposed on the charge recombination layer.

For manufacture of a triple-junction device, the substrate typically comprises
i) a first electrode, preferably wherein the first electrode comprises a transparent conducting oxide,
ii) a photoactive region, said photoactive region preferably comprising a crystalline A/M/X material which crystalline A/M/X material comprises a compound of formula [A]ₐ[M]_{b}[X]_{c} as described herein,
iii) a charge recombination layer as described herein disposed on the photoactive region,
iv) a photoactive region, said photoactive region preferably comprising a crystalline A/M/X material which crystalline A/M/X material comprises a compound of formula [A]ₐ[M]_{b}[X]_{c} as described herein,
v) a charge recombination layer as described herein disposed on the photoactive region, and
vi) optionally, a layer of a charge transporting material as described herein disposed on the charge recombination layer.

The first electrode may be deposited on a layer of a transparent material, for instance a layer of glass. The layer of a transparent material may be treated with an anti-reflective coating. Typically, the anti-reflective coating comprises magnesium fluoride (MgF₂).

The process may further comprise: disposing a second electrode on the layer of the crystalline A/M/X material disposed on the substrate.

The second electrode may be as defined above for the first electrode. Typically, the second electrode comprises, or consists essentially of, a metal for instance an elemental metal. Examples of metals which the second electrode material may comprise, or consist essentially of, include silver, gold, copper, aluminium, platinum, palladium, or tungsten. The second electrode may be disposed by vacuum evaporation. The thickness of the layer of a second electrode material is typically from 1 to 250 nm, preferably from 5 nm to 100 nm.

Preferably, the process comprises disposing a layer of a charge transporting material as described herein on the layer of the crystalline A/M/X material disposed on the substrate, and disposing the second electrode on the charge transporting material. The layer of a charge transporting material may be a layer of an electron transporting (n-type) material, as described herein, or a layer of a hole transporting (p-type) material, as described herein. Typically, the layer of a charge transporting material disposed on the layer of the crystalline A/M/X material is a layer of a hole transporting (p-type) material as described herein, preferably wherein said hole transporting material comprises spiro-OMeTAD.

Thus the multi-junction device produced by the process of the present invention may comprise the following layers in the following order:
- First electrode;
- Photoactive region;
- Charge recombination layer;
- Optional layer of charge transporting material, preferably a layer of an electron transporting (n-type) material, preferably wherein said electron transporting material comprises PCBM;
- Layer of crystalline A/M/X material as described herein;
- Optional layer of charge transporting material, preferably a layer of a hole transporting (p-type) material, preferably wherein said hole transporting material comprises spiro-OMeTAD;
- Second electrode.

In the case of a triple-junction device produced by the process of the present invention, the triple-junction device may comprise the following layers in the following order:
- First electrode;
- Photoactive region;
- Charge recombination layer;
- Photoactive region;
- Charge recombination layer;
- Optional layer of charge transporting material, preferably a layer of an electron transporting (n-type) material, preferably wherein said electron transporting material comprises PCBM;
- Layer of crystalline A/M/X material as described herein;
- Optional layer of charge transporting material, preferably a layer of a hole transporting (p-type) material, preferably wherein said hole transporting material comprises spiro-OMeTAD;
- Second electrode.

In one embodiment, at least two of the photoactive regions in the multi-junction device are formed using a film-forming solution as described herein. In this embodiment, the process of the invention may comprise forming the layer of the crystalline A/M/X material by disposing a film-forming solution on a substrate, wherein the substrate comprises: one photoactive region comprising a photoactive material, and a charge recombination layer which is disposed on the photoactive region by solution-deposition, then further steps of:
- Optionally forming a layer of a charge transporting material as described herein on the layer of the crystalline A/M/X material disposed on the substrate, preferably wherein the charge transporting material comprises a hole-transporting (p-type) material;
- forming a further charge recombination layer as described herein;
- forming a further photoactive region by depositing a layer of a crystalline A/M/X material using the film-forming solution as described herein; and optionally forming one or more charge transport layers, as described herein;
- forming the second electrode.

Such a device may therefore comprising the following layers in the following order:
- First electrode;
- Photoactive region;
- Charge recombination layer;
- Optional layer of charge transporting material, preferably a layer of an electron transporting (n-type) material, preferably wherein said electron transporting material comprises PCBM;
- Layer of crystalline A/M/X material as described herein;
- Optional layer of charge transporting material, preferably a layer of a hole transporting (p-type) material, preferably wherein said hole transporting material comprises spiro-OMeTAD;
- Charge recombination layer;
- Optional layer of charge transporting material, preferably a layer of an electron transporting (n-type) material, preferably wherein said electron transporting material comprises PCBM;
- Layer of crystalline A/M/X material as described herein;
- Optional layer of charge transporting material, preferably a layer of a hole transporting (p-type) material, preferably wherein said hole transporting material comprises spiro-OMeTAD;
- Second electrode.

### Multi-junction device

Also described herein is a multi-junction device which is obtainable or obtained by the process of the present invention. The multi-junction device may comprise any of the features described above in relation to the process for producing a multi-junction device. For instance, the multi-junction device may comprise any of the combination of layer sequences and materials as set out above. Also, the crystalline A/M/X material(s) may each be as further defined anywhere herein.

Also described herein is a multi-junction device comprising:
(a) at least two photoactive regions, wherein at least one of the photoactive regions comprises a layer of a crystalline A/M/X material which crystalline A/M/X material comprises a compound of formula [A]ₐ[M]_{b}[X]_{c},
   wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and
(b) a charge recombination layer which comprises nanoparticles of a transparent conducting oxide.

The nanoparticles of a transparent conducting oxide may be any nanoparticles of a transparent conducting oxide as described herein. For instance, the nanoparticles of a transparent conducting oxide may be indium tin oxide (ITO) nanoparticles, preferably ITO nanoparticles having a size of less than 100 nm.

Also described herein is a multi-junction device comprising:
(a) at least two photoactive regions, wherein at least one of the photoactive regions comprises a layer of a crystalline A/M/X material which crystalline A/M/X material comprises a compound of formula [A]ₐ[M]_{b}[X]_{c}, wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and
(b) a charge recombination layer which comprises a conducting polymer.

In the multi-junction devices described above, [A], [M] and [X] may all be as described herein. Each A/M/X material may be as further defined herein. Also, each photoactive region may be as further defined herein, for instance each one, may further comprise a layer of an n-type material and a layer of a p-type material, which n-type and p-type materials may be as further defined herein.

The conducting polymer may be any conducting polymer as described herein. For instance, the conducting polymer may comprise poly(3,4-ethylenedioxythiophene) and polystyrene sulfonate (PEDOT:PSS).

In the multi-junction devices described above, the charge recombination layer typically comprises nanoparticles of a transparent conducting oxide and a conducting polymer, both of which may be as further defined anywhere herein. Thus, the charge recombination layer may comprise (i) nanoparticles of indium tin oxide (ITO) and (ii) a polymer which comprises poly(3,4-ethylenedioxythiophene) and polystyrene sulfonate.

In the multi-junction devices above, two of the photoactive regions may comprise a layer of a crystalline A/M/X material as described herein. In one embodiment, the multi-junction devices above comprise at least three photoactive regions. Preferably each photoactive region comprises a layer of a crystalline A/M/X material as described herein. Each crystalline A/M/X material may comprise, or consist essentially of, a compound of formula (IA), (IB), (IC), (ID), (IE), (IF), (IG), (IH), (IIIA), (IIIB),(IIIC), (VIA), (VIB), or (VIC) as described herein, preferably a compound of formula (I), for instance a compound of formula (IA), (IB), (IC), (ID), (IE), (IF), (IG) or (IH) as described herein. Each photoactive region may further comprise n-type and p-type layers as further defined herein.

Also described herein is a multi-junction device comprising
(a) at least three photoactive regions, wherein each one of the photoactive regions comprises a layer of a crystalline A/M/X material which crystalline A/M/X material comprises a compound of formula [A]ₐ[M]_{b}[X]_{c},
   wherein: [A] comprises one or more A cations; [M] comprises one or more M cations which are metal or metalloid cations; [X] comprises one or more X anions; a is a number from 1 to 6; b is a number from 1 to 6; and c is a number from 1 to 18; and
(b) at least one charge recombination layer disposed between the photoactive regions.

In the multi-junction device comprising three photoactive regions, [A], [M] and [X] may all be as described herein.

Typically, at least two charge recombination layers are disposed between the photoactive regions. For instance, the multi-junction device may comprise the following layers in the following order:
- Photoactive region;
- Charge recombination layer;
- Photoactive region;
- Charge recombination layer;
- Photoactive region.

Typically, at least one of the charge recombination layers comprises a conducting polymer or nanoparticles of a transparent conducting oxide. For instance, each one of the charge recombination layers comprises a conducting polymer or nanoparticles of a transparent conducting oxide.

Typically, at least one of the charge recombination layers comprises nanoparticles of a transparent conducting oxide and a conducting polymer. For instance, each one of the charge recombination layers may comprise nanoparticles of a transparent conducting oxide and a conducting polymer. The nanoparticles of a transparent conducting oxide and the conducting polymer may be as described herein, for example the nanoparticles of a transparent conducting oxide may be indium tin oxide (ITO) nanoparticles, preferably ITO nanoparticles having a size of less than 100 nm, and the conducting polymer may comprise poly(3,4-ethylenedioxythiophene) and polystyrene sulfonate (PEDOT:PSS). Thus, each one of the charge recombination layer or layers may comprise (i) nanoparticles of indium tin oxide (ITO) and (ii) a polymer which comprises poly(3,4-ethylenedioxythiophene) and polystyrene sulfonate.

In the multi-junction devices described above, at least two of the crystalline A/M/X materials may be different from each other. In one embodiment, more than two of the crystalline A/M/X materials are different from one other. For instance, in a multi-junction device in which three crystalline A/M/X materials are present, all three crystalline A/M/X materials may be different from each other. The crystalline A/M/X material in each photoactive region may comprise, or consist essentially of, a compound of formula (IA), (IB), (IC), (ID), (IE), (IF), (IG), (IH), (IIIA), (IIIB),(IIIC), (VIA), (VIB), or (VIC) as described herein, preferably a compound of formula (I), for instance a compound of formula (IA), (IB), (IC), (ID), (IE), (IF), (IG) or (IH) as described herein. Each photoactive region may further comprise at least one, preferably two, charge transporting layers, for instance an n-type layer and a p-type layer as further defined herein.

The multi-junction devices described above may further comprise a first electrode and a second electrode as described herein, wherein the photoactive regions and the charge recombination layer or layers are disposed between the first electrode and the second electrode. Preferably, the first electrode comprises a transparent conducting oxide and the second electrode comprises elemental metal.

Typically, the multi-junction devices described herein are selected from the group consisting of an optoelectronic device, a photovoltaic device, a solar cell, a photo detector, a photodiode, a photosensor, a chromogenic device, a transistor, a light-sensitive transistor, a phototransistor, a solid state triode, a battery, a battery electrode, a capacitor, a super-capacitor, a light-emitting device, a light-emitting diode and a laser. For instance, the multi-junction device may be an optoelectronic device. Examples of optoelectronic devices include photovoltaic devices, photodiodes (including solar cells), phototransistors, photomultipliers, photoresistors, and light emitting devices. Preferably, the multi-junction device is a photovoltaic device or a light-emitting device.

### Examples

The advantages of the invention will hereafter be described with reference to some specific examples.

Herein, an acetonitrile/methylamine (ACN/MA) composite solvent is employed, which was previously introduced by Noel et al.(N. K. Noel, S. N. Habisreutinger, B. Wenger, M. T. Klug, M. T. Hörantner, M. B. Johnston, R. J. Nicholas, D. T. Moore, H. J. Snaith, Energy Environ. Sci. 2017, 10, 145) to enable the sequential processing of perovskite absorber layers upon underlying perovskite devices. This all-solution processed architecture has the potential of being applied to the manufacturing of large area films on both rigid and flexible substrates, using deposition techniques such as roll-to-roll (R2R) processing, blade coating or inkjet printing. An all-solution processed tandem architecture is presented, reaching over 15% stabilized power conversion efficiency (PCE), and delivering an open circuit voltage (V_{oc}) of 2.18 V. Furthermore, we show that the mixed-metal Sn/Pb perovskite MAPb_{0.75}Sn_{0.25}I₃, can also be processed via the ACN/MA solvent system, where the reducing nature of MA obviates the need to use SnF₂ to achieve respectable efficiencies, allowing u a scanned PCE of over 11% (stabilized 10.5%) to be obtained employing an n-i-p architecture. Using a mixed-metal MAPb_{0.75}Sn_{0.25}I₃ perovskite material to extend the light absorption of the multi-junction to 925 nm, the first monolithic triple-junction perovskite solar is presented with an open circuit voltage (V_{oc}) of 2.83 V. An optical and electronic model is utilized to validate the experimental results, and reveal the optical losses existing within this specific architecture. A triple junction perovskite solar cell is then modeled, using electronic characteristics of currently feasible 1.94/1.57/1.24 eV perovskite materials, showing the possibility of achieving a triple junction device with a 24.3% PCE and corresponding V_{OC} of 3.15 V.

### Results and discussion

All-perovskite monolithic 2T tandems and multi-junction solar cells require a tunnel junction (TJ) or recombination layer to provide a means to create an electronic series connection between the different sub-cells. In turn, photo-voltage generated from each sub-cell sum resulting in high voltage devices. However, due to charge conservation, the current density flowing out of each sub-cell must match, and hence the current will be limited by the lowest current density generated from any sub-junction. Thus, in order to maximize the photocurrent density in a 2T monolithic tandem, both sub-cells should generate equal current density, which can be achieved through carefully tuning the band gap and thickness of each junction. Recombination layers between the sub cells must fulfill stringent requirements. Firstly, they must to enable ohmic contact to the charge extraction layers, and facilitate recombination of collected electrons and holes without introducing resistive losses. Secondly, they must be as optically transparent as possible to avoid parasitic absorption of light. Thirdly, deposition of the recombination layer should not damage any of the layers beneath, which is typically achieved via introducing "buffer layers" when sputtering, or by using orthogonal solvents for solution processing. Lastly, this interlayer must be a sufficient barrier to solvent penetration to prevent any re-dissolution of underlying perovskite or other electronic layers when subsequently processing another perovskite layer.

Here, a recombination layer and an n-i-p perovskite solar cell architecture are developed that meet these constraints. For the recombination layer, a combination of a PEDOT:PSS layer followed by a ITO nanoparticles layer is found to work well. In the first instance, a "wide band gap", purely lead-based perovskite tandem cell is developed by processing a ~1.94 eV (as determined by a Tauc plot which we show in Fig. 5) top cell on top of 1.57 eV bottom cell. The wide band-gap junction is processed first, and hence do not have to overtly consider solvent orthogonality issues. A conventional solution processing route is therefore followed to fabricate FA_{0.83}Cs_{0.17}Pb(Br_{0.7}I_{0.3})₃ with 2% (molarity with respect to the Pb) potassium (K⁺) additive (see Z. Tang, T. Bessho, F. Awai, T. Kinoshita, M. M. Maitani, R. Jono, T. N. Murakami, H. Wang, T. Kubo, S. Uchida, H. Segawa, Sci. Rep. 2017, 7, 12183; J. K. Nam, S. U. Chai, W. Cha, Y. J. Choi, W. Kim, M. S. Jung, J. Kwon, D. Kim, J. H. Park, Nano Lett. 2017, 17, 2028; M. Muzammal uz Zaman, M. Imran, A. Saleem, A. H. Kamboh, M. Arshad, N. A. Khan, P. Akhter, Phys. B Condens. Matter 2017, 522, 57; T. Bu, X. Liu, Y. Zhou, J. Yi, X. Huang, L. Luo, J. Xiao, Z. Ku, Y. Peng, F. Huang, Y.-B. Cheng, J. Zhong, Energy Environ. Sci. 2017, 10, 2509; M. Abdi-Jalebi, Z. Andaji-Garmaroudi, S. Cacovich, C. Stavrakas, B. Philippe, J. M. Richter, M. Alsari, E. P. Booker, E. M. Hutter, A. J. Pearson, S. Lilliu, T. J. Savenije, H. Rensmo, G. Divitini, C. Ducati, R. H. Friend, S. D. Stranks, Nature, 2018, 555, 497-501) As has been previously described, a deposition technique utilizing hydrohalic acidic additives is employed to fabricate highly ordered perovskite materials with grains reaching micron sizes in diameter (Fig. 6) (D. P. McMeekin, Z. Wang, W. Rehman, F. Pulvirenti, J. B. Patel, N. K. Noel, M. B. Johnston, S. R. Marder, L. M. Herz, H. J. Snaith, Adv. Mater. 2017, 1607039). Highly crystalline perovskite materials with low energetic disorder have been shown to suppress halide segregation (W. Rehman, R. L. Milot, G. E. Eperon, C. Wehrenfennig, J. L. Boland, H. J. Snaith, M. B. Johnston, L. M. Herz, Adv. Mater. 2015, n/a). Furthermore, as recent the reports referenced above suggest, potassium is utilized as an additive to suppress ionic migration and reduce the anomalous hysteretic behavior intrinsically present in perovskite solar cells (H. J. Snaith, A. Abate, J. M. Ball, G. E. Eperon, T. Leijtens, N. K. Noel, S. D. Stranks, J. T.-W. Wang, K. Wojciechowski, W. Zhang, J. Phys. Chem. Lett. 2014, 5, 1511). For this absorber material, in single junction perovskite solar cells, open-circuit voltages of up to 1.27 V and a stabilized power conversion efficiency of 10.9 % are obtained, which are shown in Fig. 7.

For the bottom cell, which is processed on top of the wide-gap cell, the issue of dissolution of the underlying perovskite film must be considered. If one of the standard DMF/DMSO solvent based routes is employed, the underlying perovskite film may be completely solvated and discolored, making it evident that the recombination layer is not impermeable to DMF or DMSO. These high boiling point solvents remain on the surface long enough to slowly percolate through solution-processed interlayers, re-dissolve the underlying perovskite layer, thus limiting their usefulness in all-solution processed tandem solar cells. An ACN/MA based composite solvent system for processing perovskite films has been developed previously, which has several distinct advantages (D. P. McMeekin, Z. Wang, W. Rehman, F. Pulvirenti, J. B. Patel, N. K. Noel, M. B. Johnston, S. R. Marder, L. M. Herz, H. J. Snaith, Adv. Mater. 2017, 1607039). Firstly, it is much more volatile than DMF, enabling very rapid drying. Secondly, the solvation strength can be tuned by varying the amount of methylamine incorporated. The right amount of MA is chosen to enable complete dissolution of the salts, but with minimal excess. It was found that having an excess amount of MA in solution can have a detrimental impact to the device. Unwanted pinholes in the interlayers may result in methylamine percolating and re-dissolving the perovskite underlayer. Thus, by carefully tuning the MA content in the solutions to obtain a solution at its critical solubility point, the chance of re-dissolving the underlayer is minimised. This solubility point is found by slowly adding a ACN/MA perovskite solution to a neat ACN perovskite dispersion, until the mixture becomes a full perovskite solution. Through this route, a robust and reliable protocol for fabrication of all-perovskite multi-junction solar cells was obtained.

To achieve optimal results, careful tuning of the B-site metal ion content was needed for both MAPbI₃ and MAPb_{0.75}Sn_{0.25}I₃ perovskite material processed via the ACN/MA solvent route. In Fig. 1A, a series of scanning electron microscope (SEM) top view images of an MAPbI₃ perovskite film, processed with the ACN/MA solvent system, various non-stoichiometric compositions fabricated on top of the FA_{0.83}Cs_{0.17}Pb(Br_{0.7}I_{0.3})₃ top-cell (TC) on a phenyl-C₆₁-butyric acid methyl ester (PC₆₁BM) layer are shown. The effects of the non-stoichiometric perovskite precursor solutions have been previously discussed,(see C. Roldán-Carmona, P. Gratia, I. Zimmermann, G. Grancini, P. Gao, M. Graetzel, M. K. Nazeeruddin, Energy Environ. Sci. 2015, 8, 3550; M. Yang, Z. Li, M. O. Reese, O. G. Reid, D. H. Kim, S. Siol, T. R. Klein, Y. Yan, J. J. Berry, M. F. A. M. van Hest, K. Zhu, Nat. Energy 2017, 2, 17038; D. Bi, W. Tress, M. I. Dar, P. Gao, J. Luo, C. Renevier, K. Schenk, A. Abate, F. Giordano, J.-P. Correa Baena, J.-D. Decoppet, S. M. Zakeeruddin, M. K. Nazeeruddin, M. Gra tzel, A. Hagfeldt, Sci. Adv. 2016, 2, e1501170; Q. Chen, H. Zhou, T.-B. Song, S. Luo, Z. Hong, H.-S. Duan, L. Dou, Y. Liu, Y. Yang, Nano Lett. 2014, 14, 4158; T. J. Jacobsson, J.-P. Correa-Baena, E. Halvani Anaraki, B. Philippe, S. D. Stranks, M. E. F. Bouduban, W. Tress, K. Schenk, J. Teuscher, J.-E. Moser, H. Rensmo, A. Hagfeldt, J. Am. Chem. Soc. 2016, 138, 10331) however the research community has yet to unanimously agree on which precise non-stoichiometry is ideal. Some studies have shown that excess organic ammonium, lead to performance gains, while other studies showed the benefits of having excess PbI₂ in the precursor solution. However, it is clear that these small stoichiometric changes do impact the perovskite in various ways, ranging from effects on morphology, luminescence, trap passivation and stability.

In Fig. 1A a series of top-view SEM images with various A-site to B-site compositional tuning of the ACN-MA precursor solution, when processed on top of the existing solar cell, ranging from 6% excess MAI to 6% excess PbI₂ are shown. An impact on the morphology and surface coverage for precursor solutions with different compositions was observed.

In an all-solution processed tandem architecture, it is imperative to eliminate the presence of pinholes, to prevent dissolving underlying layers. In Fig. 8, the tandem solar cell performance for devices processed with the differing range of compositions are shown. The ideal composition for maximizing the single junction cell efficiency includes 3% excess MAI, and complete tandem solar cells were fabricated with this composition.

In Fig. 1B and Fig. 1C, a schematic of a 2T tandem along with a corresponding scanning electron microscopy SEM cross-section image is shown. The solar cells are fabricated with the conventional n-i-p architecture, and it was found that a recombination layer composed of PEDOT:PSS followed by indium tin oxide (ITO) nanoparticles works remarkably well, sandwiched between a 2,2',7,7'-tetrakis(N,N'-di-p-methoxyphenylamine)-9,9'-spirobifluorene (spiro-OMeTAD) p-type charge extraction layer and n-doped PC₆₁BM electron transporter.

In Fig. 1D, the forward and backwards current-density voltage (J-V) characteristics of one of the highest-performing two-terminal tandem solar cells measured under a simulated air mass (AM) 1.5 solar irradiation with a power density of 100 mW cm⁻² are shown. A detailed description of how the mismatch factor was calculated may be found below.

In this work, the recombination layer comprises PEDOT:PSS and indium tin oxide (ITO) nanoparticle (NP) sublayers. A high conductivity PEDOT:PSS (Heraus H1000) solution is diluted with isopropanol (IPA) and directly spin-coated on the spiro-OMeTAD layer, which acts as both a recombination layer and solvent barrier. An ITO layer is then spin-coated on from a solvent dispersion of ITO nanoparticles (>100nm). The fabricated ITO nanoparticle layer may be porous and non-continuous. However, these nanoparticles, improve the recombination process, due to their high carrier density, which allow holes from PEDOT:PSS and electrons from PC₆₁BM to recombine. The ITO NP layer creates an ohmic contact between both electron and hole-accepting layers, which allows for efficient charge transfer into the recombination layer.

This tandem device generated a short-circuit current-density (J_{SC}) of 11.5 mA cm⁻², a fill-factor (FF) of 0.63, an open-circuit voltage (V_{oc}) of 2.18 V, and a power conversion efficiency of 15.2% (stabilized) (Fig. 9). Perovskite solar cells have been prone to hysteretic behavior. Hence, a stabilized efficiency measurement by holding the device at a fixed maximum power point voltage of 1.72 V, reaching a stabilized efficiency of 15.2%, as shown in the inset of Fig. 3A was performed. In Fig. 3B an external quantum efficiency (EQE) of both junctions is shown, with an integrated current density of 10.0 mA cm⁻² for the front cell and 9.3 mA cm⁻² for the rear cell. During the EQE measurement, a voltage bias was applied to the solar cell equal to the V_{oc} of the optically biases sub-cell. This allowed for the EQE to be measured near J_{sc}. A slight current-density mismatch between the two sub-cells was noted. In Fig. 10 the calculated mismatch factor for each material used in the multi-junction solar cell is shown. The xenon arc lamp spectrum can be significantly mismatched with the AM1.5G spectrum due to the large intensity spikes in the infrared portion of the spectrum (shown in Fig. 11). As a result, specific sub-cells of the multi-junction solar cell may be over or underestimated, especially in the case of multi-junction solar cells. In this specific case here, the tandem cell is rear cell limited under AM1.5G spectrum, and top cell limited under the solar simulator lamp. To account for these discrepancies, a mismatch factor correction was applied, which lowered our estimated efficiency by approximately 0.4% relative. However, in the case of the triple-junction, a significant mismatch factor arises due to the xenon intensity spikes, which requires a correction of 32.3% relative reduction in efficiency to account for the spectral mismatch. Both correction factors have been applied to the reported efficiencies. Estimation of voltage losses is a critical metric to access the quality of the recombination interlayers. As shown in Fig. 12, using a PEDOT:PSS/ITO NPs interlayers as the recombination layer, a 2T tandem V_{oc} as high as 2.22 V was measured, resulting in a interlayer voltage loss of approximately 180mV, if it is assumed both sub-cells generated the highest measured single junction V_{oc} of 1.27 V for the front cell and 1.11V for the rear cell.

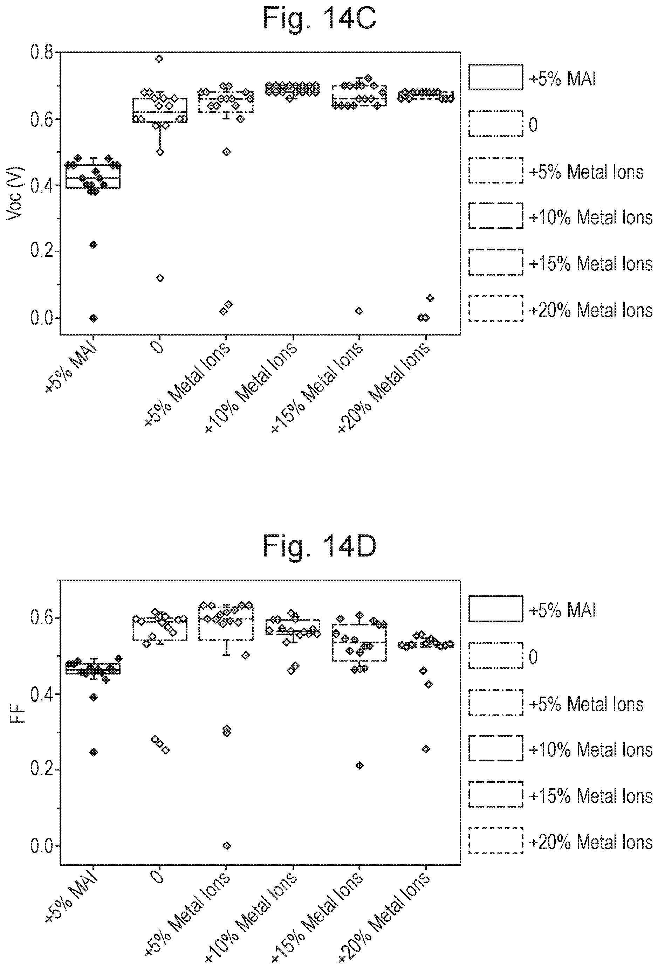

Although neat lead-based devices have led to stable perovskite materials, the drive to narrow the bandgap using less stable tin-based perovskites is still highly desirable for tandem applications. As shown in Fig. 2, the impact of non-stoichoimetric precursor solutions on the material properties of the MAPb_{0.75}Sn_{0.25}I₃ (with a band gap of 1.34 eV determined from Tauc plots, Fig. 13) by tuning the A-site to B-site ratio was also studied. In order to keep the intended MAPb_{0.75}Sn_{0.25}I₃ perovskite composition, excess PbI₂ and SnI₂ was added at a ratio of 75 to 25. Fig. 2A shows kelvin probe force microscopy (KPFM) images, and a stark increase in work function is observed as excess metal ions are incorporated in the MAPb_{0.75}Sn_{0.25}I₃ perovskite precursor solution. Slower time-resolved photoluminescence (PL) decays were also noted, shown in Fig. 2B. Fig. 2C presents the transient photo-conductivity for the corresponding samples for a range of excitation densities, measuring maximum perturbation of conductivity decay after photoexcitation by a laser pulse. Similarly, an increase in photo-conductivity for films with excess metals ions is observed, implying higher effective mobility. It was found that these longer-lived carrier lifetimes and higher photo-conductivities correlate to a substantial increase in device performance (Fig. 14), which results in an optimized MAPb_{0.75}Sn_{0.25}I₃ PCE of over 11%, as shown in Fig. 2D.

Surprisingly, a substantial difference was found in optimum A-site to B-site ratio for tin-lead based perovskite materials compared to neat lead-based perovskites. In the case of Sn/Pb-based perovskite, the research community appears to have consistently observed performance gains when using an excess of tin halides, most notably in the form of tin fluoride (SnF₂) or tin chloride (SnCl₂) (see D. Zhao, Y. Yu, C. Wang, W. Liao, N. Shrestha, C. R. Grice, A. J. Cimaroli, L. Guan, R. J. Ellingson, K. Zhu, X. Zhao, R.-G. Xiong, Y. Yan, Nat. Energy 2017, 2, 17018; K. P. Marshall, M. Walker, R. I. Walton, R. A. Hatton, Nat. Energy 2016, 1, 16178; S. J. Lee, S. S. Shin, Y. C. Kim, D. Kim, T. K. Ahn, J. H. Noh, J. Seo, S. Il Seok, J. Am. Chem. Soc. 2016, 138, 3974; M. H. Kumar, S. Dharani, W. L. Leong, P. P. Boix, R. R. Prabhakar, T. Baikie, C. Shi, H. Ding, R. Ramesh, M. Asta, M. Graetzel, S. G. Mhaisalkar, N. Mathews, Adv. Mater. 2014, 26, 7122; A. G. Kontos, A. Kaltzoglou, E. Siranidi, D. Palles, G. K. Angeli, M. K. Arfanis, V. Psycharis, Y. S. Raptis, E. I. Kamitsos, P. N. Trikalitis, C. C. Stoumpos, M. G. Kanatzidis, P. Falaras, Inorg. Chem. 2017, 56, 84). The tin fluoride as an additive has readily been used as a reducing agent with the aim of suppressing the tin oxidation from Sn²⁺ to Sn⁴⁺. By suppressing oxidation, Sn²⁺ vacancies are limited, which causes the undesirable p-type behavior found in Sn-based perovskites. In this study, MA is relied on to act as a reducing agent instead of SnF₂, since SnF₂ poorly dissolves in the ACN/MA solvent system. Amines have been known to act as reducing agents, a phenomenon most often exploited in the synthesis of metal nanoparticles (see J. D. S. N. and, G. J. Blanchard*, **2006,** DOI 10.1021/LA060045Z). Here, the reducing properties of amines is exploited, allowing SnF₂ to be effectively replaced with MA. Fig. 14 shows a plot of non-optimized devices with various ratios of A-site to B-site cations. Devices with excess MAI produced near-zero PCE and little to no short-circuit density (Jsc), whereas devices with excess amounts of metals ions clearly show an increase in single junction device efficiency, reaching an optimum composition with 15% excess metal ions. Thus, tin-based perovskites not only require a reducing agent to suppress Sn⁺² to Sn⁺⁴ oxidation, but also require excess metal ions for optimum performance. This is in agreement with the findings by Song et al., who observed that a non-stoichiometric CsSnI₃ perovskite composition of 0.4:1 of CsI:SnI₂ was required for optimum performance when processed under a reducing hydrazine atmosphere (see T.-B. Song, T. Yokoyama, S. Aramaki, M. G. Kanatzidis, ACS Energy Lett. 2017, 2, 897). Excess SnI₂ was identified for its role as a "compensator" salt to substitute any Sn²⁺ vacancies that occur as a result of exposure to moisture or oxygen, where Sn²⁺ losses two electrons to become Sn⁴⁺. In Fig. 2A, a deeper Fermi level for the MAPb_{0.75}Sn_{0.25}I₃ perovskite with MAI rich compositions is noted, which is consistent with a higher concentration of Sn²⁺ vacancies, which are expected to lead to p-doping of the perovskite. In contrast, the shallower Fermi levels, which were observed for metal ion rich perovskite films, would correspond to a more intrinsic perovskite material, indicative of fewer Sn²⁺ vacancies. The increase in carrier lifetimes in the perovskite absorber, which we observe in Fig. 2A, was interpreted to be consistent with and indicate a transition from a highly p-type material to a more intrinsic semiconductor. Furthermore, this change in Fermi level can potentially induce an energetic barrier between the perovskite and the electron or hole accepting layers, in this case, PC₆₁BM and spiro-OMeTAD doped with spiro-OMETAD⁺ bis(trifluoromethanesulfonyl)imide⁻ (spiro(TFSI)₂), respectively.

Fig. 3 shows the structure and performance characteristics of the first all-perovskite, monolithic, triple-junction solar cell, prepared via a solution processed route. The narrow band gap MAPb_{0.75}Sn_{0.25}I₃ perovskite solar cell, described in Fig 2, was processed on top of the dual-junction tandem solar cell architecture described in Fig. 1 to fabricate a triple-junction solar cell that absorbs light out to 925 nm. Fig. 3A shows a schematic of the 2T triple-junction cell comprised of FA_{0.83}Cs_{0.17}Pb(Br_{0.7}I_{0.3})₃/MAPbI₃/MAPb_{0.75}Sn_{0.25}I₃, where the FA_{0.83}Cs_{0.17}Pb(Br_{0.7}I_{0.3})₃ perovskite is acting as a front-cell, the MAPbI₃ perovskite is the middle cell, and the MAPb_{0.75}Sn_{0.25}I₃ perovskite is the rear cell. Fig. 3B shows a corresponding SEM cross-section image. Fig. 3C shows the forward and backward current-density voltage (J-V) characteristics of one of the "highest-performing" two-terminal triple-junction solar cells measured under 100 mW cm⁻² simulated air mass (AM) 1.5 and solar irradiation. A PCE of 7.5% (7.1% stabilized) was measured, while the highest V_{oc}, which is shown in Fig. 3D, was measured on a separate device (shown in Fig. 15) and exhibits a stabilized open-circuit voltage of 2.83 V after 60s.

Fig. 17 shows a high performing FA_{0.83}Cs_{0.17}Pb_{0.5}Sn_{0.5}I₃ perovskite in a p-i-n architecture, processed with a DMF/DMSO solvent, filtered with a FA_{0.83}Cs_{0.17}Pb(Br_{0.7}I_{0.3})₃/MAPbI₃ tandem solar cell without the Ag electrode. Although this is not a four-terminal (4T) tandem measurement since a semi-transparent electrode was not employed upon the front tandem stack, this measurement allows the expected efficiency gain if higher performances and lower band gaps were obtained with ACN/MA solvent system route to be roughly estimated. Fig. 17C shows a junction based on FA_{0.83}Cs_{0.17}Pb_{0.5}Sn_{0.5}I₃ with a 1.22 eV absorption onset, 15.5% PCE (stabilized) can be obtained when unfiltered and 2.6% PCE (stabilized) when filtered with the FA_{0.83}Cs_{0.17}Pb(Br_{0.7}I_{0.3})₃/MAPbI₃ tandem. Thus, a narrow band gap material could potentially boost the FA_{0.83}Cs_{0.17}Pb(Br_{0.7}I_{0.3})₃/MAPbI₃ by more than 2.6%, reaching 17.7% PCE. It is also noted that this measurement includes an air gap between the tandem and the narrow bandgap single-junction solar cell, and an additional PEDOT:PSS layer which would otherwise not be present in the standard monolithic triple-junction solar cell. For these reasons we measure a lower integrated current density from the EQE, shown in Fig. 17B.

As reported by Hörantner et al., all-perovskite triple junction solar cells employing perovskite absorbers with similar band gaps to those which we have used in the present work, should be capable of outperforming single and double-junction efficiencies. The modelling of H Hörantner et al. shows that an optimized 1.22 eV band gap material should current match the two wider band gap sub-cells of 2.04 eV and 1.58 eV, delivering a theoretical maximum J_{SC} of 12 mA cm⁻², a V_{oc} of 3.54 V and a PCE of 36.6 % (see M. T. Hörantner, T. Leijtens, M. E. Ziffer, G. E. Eperon, M. G. Christoforo, M. D. McGehee, H. J. Snaith, ACS Energy Lett. 2017, 2, 2506). However, this performance can only be obtained with optically transparent interlayers to reduce parasitic absorption and reflection losses. Fig. 16 shows the optical properties of each interlayer which are used in the multi-junction stack. The thick ~100nm PC₆₁BM layer employed in the interlayer structure is responsible for the majority of the parasitic absorption and reflection losses.

To assess the true potential of this fully-solution processed all-perovskite multi-junction solar cell architecture, a similar optical and electrical model to that used by Hörantner et al., was employed to simulate this semiconductor stack and reveal where improvements can be made to further increase the performance of multi -junction devices. Using the experimental thicknesses, in combination with the extracted electrical characteristics of the state-of-the-art single junction perovskite cells, Fig. 4A-B present an estimation of the performance of the tandem stack, and the corresponding modeled external quantum efficiency spectrum. It was estimated that the tandem solar cell (sub cells with 1.94eV and 1.57eV bandgaps) can be increased to nearly 19% by combining the electrical characteristics of the current champion FA_{0.83}Cs_{0.17}Pb(Br_{0.7}I_{0.3})₃ with a best-in-class ACN/MA MAPbI₃. A stack with identical absorber and interlayer materials was the modeled (shown in Fig. 4C-D), but with a state of the art MAPbI₃, processed via a DMF/DMSO route, an optimized perovskite thicknesses, interlayers with thickness' down to 50nm, and a MgF₂ anti-reflective coating. These improvements allow the tandem cell to reach a 21.8% PCE. In this figure, an optimized stack with an enhanced front cell with improved electrical characteristics was also modeled, assuming an electroluminescence efficiency (*EQE_{EL}*) of 1%, a series resistance (*R_{S}*) of 4 · 10⁻² Ω *cm*² and a shunt resistance (*R_{SH}*) of 10*M*Ω *cm*² for the FA_{0.83}Cs_{0.17}Pb(Br_{0.7}I_{0.3})₃, which increased the attainable PCE to 26.8%. Figures 4E-F reveal the performance of the triple junction architecture, assuming perovskite thicknesses optimized for current-matching, state-of-art MAPbI₃ and FA_{0.6}MA_{0.4}Pb_{0.4}Sn_{0.6}I₃ perovskite sub-cells, and an anti-reflective coating is added on top. A 26.7% PCE can be achieved by using optimized thickness, and over 30% PCE triple junction efficiency is within reach by improving the V_{oc} of the front cell. The specific layer thicknesses for each simulation, along with details of these are provided below.

### Conclusion

The fully-solution processed all-perovskite multi-junction solar cells which are presented open new avenues for the large-scale manufacture of highly efficient multi-junction architectures. These tandem architectures can be achieved using a highly volatile ACN/MA-based solvent system, which enabled sequential stacking of different energy gap perovskite absorbers. Using a highly transparent and effective PEDOT:PSS/ITO NPs recombination layer, the first fully-solution processed monolithic FA_{0.83}Cs_{0.17}Pb(Br_{0.7}I_{0.3})₃/MAPbI₃ tandem solar cell has been fabricated, reaching a stabilized power conversion efficiency of 15.2%. By adding a narrow band-gap MAPb_{0.75}Sn_{0.25}I₃ perovskite junction, the multi-junction's light absorption is extended to 925 nm and fabricated the first triple-junction perovskite solar cell, reaching a record high 2.83 V V_{oc}.

### Experimental details

### Top Cell (TC) Fabrication: Glass/FTO/SnO₂/PC₆₁BM/FA_{0.83}Cs_{0.17}Pb(Br_{0.7}I_{0.3})₃/Spiro-OMeTAD

**Substrate Preparation:** Devices were fabricated on fluorine-doped tin oxide (FTO) coated glass (Pilkington, 15Ω □⁻¹). Initially, FTO was removed at specific regions where the anode contact will be deposited. This FTO etching was done using a 2M HCl and zinc powder. Substrates were then cleaned sequentially in Hellmanex detergent, acetone, isopropyl alcohol, and dried with a compressed air gun.

**Tin Oxide (SnO₂) layer fabrication:** Immediately prior to spin coating, we prepared a SnO₂ precursor solution comprised of 17.5mg ml⁻¹ tin(IV) chloride pentahydrate (SnCl₄·5H₂O) (Sigma-Aldrich) dissolved in anhydrous 2-propanol (IPA). The solution was spin-coated in nitrogen at 3000 rpm for 30 s, with a ramp of 200 rpm/s. The substrates were then dried in nitrogen at 100 °C for 10 min. A subsequent annealing step was done in air 180 °C for 90 min.

**PC₆₁BM layer fabrication:** A Phenyl-C61-butyric acid methyl ester (PC₆₁BM) precursor solution was prepared by dissolving a 7.5 mg ml⁻¹ PC₆₁BM (99%, solenne) in anhydrous chlorobenzene (CB) (Sigma). We doped the PC₆₁BM using dihydro-1H-benzoimidazol-2-yl (N-DBI) derivatives, specifically 3-dimethyl-2-phenyl-2,3-dihydro-1H-benzoimidazole (N-DMBI) (see S. Rossbauer, C. Müller, T. D. Anthopoulos, Adv. Funct. Mater. 2014, 24, n/a; Z. Wang, D. P. McMeekin, N. Sakai, S. van Reenen, K. Wojciechowski, J. B. Patel, M. B. Johnston, H. J. Snaith, Adv. Mater. 2017, 29, 1604186; S. S. Kim, S. Bae, W. H. Jo, Chem. Commun. 2015, 51, 17413; P. Wei, T. Menke, B. D. Naab, K. Leo, M. Riede, Z. Bao, J. Am. Chem. Soc. 2012, 134, 3999; B. D. Naab, S. Guo, S. Olthof, E. G. B. Evans, P. Wei, G. L. Millhauser, A. Kahn, S. Barlow, S. R. Marder, Z. Bao, J. Am. Chem. Soc. 2013, 135, 15018; P. Wei, J. H. Oh, G. Dong, Z. Bao, J. Am. Chem. Soc. 2010, 132, 8852). We doped the PC₆₁BM precursor solution with N-DMBI at a 0.25% wt%. This solution was then filtered using a 0.45 µm PTFE filter. We spin coated this solution in a nitrogen-filled glovebox at 2000 rpm for 20s with a ramp rate of 1000 rpm/s, and annealed the substrate at 80 °C for 10 min.

**FAI synthesis:** Formamidinium iodide (FAI) was synthesized by dissolving formamidine acetate salt (99%, Sigma-Aldrich) in a 1.5x molar excess of hydriodic acid (HI), 57 wt. % in H₂O, distilled, stabilized, 99.95% (Sigma-Aldrich). After addition of acid the solution was left stirring for 10 minutes at 50 °C. Upon drying in a large glass dish at 100°C for 2h, a yellow-white powder was formed. This was then washed three times with diethyl ether. The power was later dissolved in anhydrous ethanol (99.5%, Sigma-Aldrich) and heated at 120 °C in a N₂-rich atmosphere to obtain a supersaturated solution. Once fully dissolved, the solution was then slowly cooled to room temperature in a N₂-rich atmosphere, until recrystallization occured. The recrystallization process formed white flake-like crystals. The solution was then placed and in a refrigerator at 4 °C, after which it was transferred to a freezer for further crystallization. The powder was later washed with diethyl ether three times. Finally, the powder was dried overnight in a vacuum oven at 50 °C.

**FA_{0.83}Cs_{0.17}Pb(Br_{0.7}I_{0.3})₃ with 2% K additive perovskite precursor solution preparation:** FA/Cs (formamidinium/Cs) with 2% K additive perovskite solutions were prepared by dissolving the precursor salts in anhydrous N,N-dimethylformamide (DMF) to obtain a stoichiometric solution with the desired FA_{0.83}Cs_{0.17}Pb(Br_{0.7}I_{0.3})₃ composition and 2% K additive using a molar ratio of 30% to 70% KI to KBr. The precursor solution was prepared using the following precursor salts: formamidinium iodide (FAI), cesium iodide (CsI) (99.9%, Alfa Aesar), lead iodide (PbI₂) (99%, Sigma-Aldrich), lead bromide (PbBr₂) (98%, Alfa Aesar), potassium iodide (KI) (99%, Sigma-Aldrich), potassium bromide (99%, KBr) (Sigma-Aldrich). 27.2 µl/ml of hydroiodic acid (HI) (57 wt. % in H₂O, distilled, stabilized, 99.95%, Sigma-Aldrich) and 54.8 µl/ml of hydrobromic (HBr) (48 wt. % in H₂O) was added to 1ml of 0.75 M precursor solutions. After the addition of the acids, the perovskite precursor solution was aged for 2 days under a nitrogen atmosphere.

**FA_{0.83}Cs_{0.17}Pb(Br_{0.7}I_{0.3})₃ perovskite layer preparation:** This aged precursor perovskite solution was spin-coated in a nitrogen-filled glovebox at 1200 rpm for 45s with a 500 rpm/s ramp rate. The films were dried inside a N₂ glovebox on a hot plate at a temperature of 70 ∘C for 1 minute. The films were then annealed in an oven in an air atmosphere at 185∘C for 90 minutes. During this annealing process, the samples were covered with a large glass container to prevent dust contamination.

**Spiro-OMeTAD hole-transporting layer fabrication:** The electron-blocking layer was deposited with a 72.5mg/ml of 2,2',7,7'-tetrakis-(N,N-di-p-methoxyphenylamine)9,9'-spirobifluorene (spiro-OMeTAD) (Lumtec) solution in chlorobenzene. Additives of 38µl of lithium bis(trifluoromethanesulfonyl)imide (170mg/mL in 1-butanol solution) per 1ml of spiro-OMeTAD solution and 21µl of 4-tert-butylpyridine (TBP) per 1mL of spiro-OMeTAD solution. The samples were left to oxidize in a desiccator for 24h. Spin-coating was carried out in a nitrogen-filled glovebox at 2000rpm for 20s with a ramp rate of 1000 rpm/s.

### Recombination Interlayer layer fabrication (for both TC/MC and MC/BC):

### PEDOT:PSS/ITO NPs

The interlayer is fabricated using both PEDOT:PSS (PH 1000) in water (Heraeus Clevios) and indium-tin oxide, 30 wt. % in isopropanol (IPA), (ITO) >100nm nanoparticles (NPs) dispersion (Sigma), as precursor solutions. We first deposit a thin layer of PEDOT:PSS directly on top of the existing spiro-OMeTAD layer. The PEDOT:PSS precursor solution was prepared immediately prior to spin coating, by diluting PEDOT:PSS (PH 1000) in anhydrous 2-propanol (IPA) at a volume ratio of 1 to 1.5 (PEDOT:PSS to IPA) and then filtered with a 2.7 µm GF/D membrane filter (Whatman). The substrates were preheated at 80 °C, and we then dynamically spin coated the diluted PEDOT:PSS solution, in a dry air atmosphere >10% relative humidity (RHM), at a speed of 6000 rpm for 20 s, and then annealed for at 80 °C for 10 min. We then deposited the ITO NPs layer. We prepared the ITO NPs precursor solution by diluting the 30 wt. % in IPA down to 1 wt. % in IPA. The diluted solution was sonicated, in a sonication bath, for 15 m prior to deposition. We dynamically spin coated the diluted ITO NPs solution, in a dry air atmosphere >10% relative humidity (RHM), at a speed of 6000 rpm for 20 s, and then annealed for at 80 °C for 10 m.

### Middle Cell (MC) Fabrication: PC₆₁BM/MAPbI₃/Spiro-OMeTAD

**PC₆₁BM layer fabrication:** A Phenyl-C61-butyric acid methyl ester (PC₆₁BM) precursor solution was prepared by dissolving a 30 mg ml⁻¹ PC₆₁BM (99%, solenne) in a mixture of anhydrous chlorobenzene (CB) (sigma) and anhydrous chloroform (CF) solvents. The solvents were mixed at a volume ratio of 2 to 1, CB to CF. We doped the PC₆₁BM using dihydro-1H-benzoimidazol-2-yl (N-DBI) derivatives, specifically 3-dimethyl-2-phenyl-2,3-dihydro-1H-benzoimidazole (N-DMBI). We doped the PC₆₁BM precursor solution with N-DMBI at a 0.25 wt%. This solution was then filtered using a 0.45 µm PTFE filter. The substrates were preheated at 80 °C, we then dynamically spin coated this solution in a dry air atmosphere >10% relative humidity (RHM) at 4000 rpm for 20s, and annealed the substrate at 80 °C for 10 min.

### ACN/MA MAPbI₃ perovskite precursor solution preparation:

In this work, we found that controlling the MA content in the acetonitrile(CH₃CN)/methylamine(CH₃NH₂) (ACN/MA) MAPbI₃ solution resulted in better tandem performance with higher reproducibility. Excess MA in the ACN/MA MAPbI₃ solution can potentially percolate through pinholes of thin imperfect interlayers, thus partially or completely dissolving the underlying junction. Thus, solutions with the minimal amount of MA required to dissolve the perovskite were employed. Controlling the MA content in the solution can potentially be done by controlling the MA flow rate and stirring speed, however, precisely controlling these parameters was sometimes challenging. Instead, we prepared two ACN MAPbI₃ dispersions, one with excess MA content resulting in a full ACN/MA MAPbI₃ solution, and another ACN MAPbI₃ dispersion without any MA. Immediately prior to spin coating, we slowly add the ACN/MA MAPbI₃ with excess MA to the ACN MAPbI₃ dispersion until this dispersion is fully dissolved, and becomes a full solution. The resulting solution is an ACN/MA MAPbI₃ solution at its critical solubility point. The preparations of the ACN/MA MAPbI₃ solution and the ACN MAPbI₃ dispersion are described below.

The ACN MAPbI₃ perovskite precursor solution without any MA was prepared, under nitrogen, using precursor salts methylammonium iodide (MAI) (Dyesol) and lead iodide (PbI₂) (TCI) added into anhydrous acetonitrile (ACN) (Sigma Aldrich) at a concentration of 1.03 M for MAI and 1 M for PbI₂, resulting in a non-stoichiometric solution (1.03:1 MAI:PbI₂). This solution was then sonicated, in a sonication bath, for 1 h in order to fully react the MAI with the PbI₂, a black perovskite dispersion is then seen at the bottom of the ACN filled vial.

The ACN/MA MAPbI₃ perovskite precursor solution was prepared using an adapted method described by Noel et al. (see N. K. Noel, S. N. Habisreutinger, B. Wenger, M. T. Klug, M. T. Hörantner, M. B. Johnston, R. J. Nicholas, D. T. Moore, H. J. Snaith, Energy Environ. Sci. 2017, 10, 145). We first prepare an ACN/MA MAPbI₃ perovskite precursor solution with the identical preparation method as described above. In order to dissolve the perovskite in ACN, a solution of methylamine (MA) in ethanol (Sigma Aldrich, 33 wt%) was placed into an aerator which was kept in an ice bath. Nitrogen was then bubbled into the solution, thus degassing the solution of MA. The MA gas which was produced was then passed through a drying tube filled with a desiccant (Drietire and CaO). The gas was bubbled into the black dispersion, while vigorously stirring the ACN/MA MAPbI₃ dispersion using a large magnetic stir bar at a speed of approximately 700 rpm. The dispersion was bubbled for 15 minutes, which resulted in a full dissolution of the black perovskite particles, resulting in a clear, light yellow solution. We note this solution has an "excess" amount of MA in the ACN/MA MAPbI₃ solution.

**ACN/MA MAPbI₃ perovskite layer preparation:** The ACN/MA MAPbI₃ precursor perovskite solution (at it's critical solubility point) is immediately dynamically spin coated in a dry air atmosphere >10% relative humidity (RHM) at 5000 rpm for 20s. A post treatment of methylammonium chloride (MACl) was then carried out by dynamically spincoating at 6000 rpm for 20s a 50 µl of MACl (Alfa Aesar, 2 mg/ml in isopropanol). The films were then annealed in an oven in an air atmosphere at 80°C for 90 minutes. During this annealing process, the samples were covered with a large glass container to prevent dust contamination. **Spiro-OMeTAD hole-transporting layer fabrication:** The electron-blocking layer was deposited by dynamically spin coating a 85mg/ml of 2,2',7,7'-tetrakis-(N,N-di-p-methoxyphenylamine)9,9'-spirobifluorene (spiro-OMeTAD) (Lumtec) solution in chlorobenzene. Additives of 20µl of lithium bis(trifluoromethanesulfonyl)imide (520mg/mL in acetonitrile solution) per 1ml of spiro-OMeTAD solution and 33µl of 4-tert-butylpyridine (tBP) per 1mL of spiro-OMeTAD solution. Spin-coating was done dynamically and carried out in a dry air atmosphere >10% relative humidity (RHM) at 2000 rpm for 30s. The samples were left to oxidize in a desiccator for 24h.

**Bottom Cell (BC) Fabrication: PC₆₁BM/ACN/MA MA-MAPb**_{**0**.}**₇₅Sn**_{**0**.}**₂₅I₃/Spiro(TFSI)₂ PC₆₁BM layer fabrication:** A Phenyl-C61-butyric acid methyl ester (PC₆₁BM) precursor solution was prepared by dissolving a 30 mg ml⁻¹ PC₆₁BM (99%, solenne) in a mixture of anhydrous chlorobenzene (CB) (sigma) and anhydrous chloroform (CF) solvents. The solvents were mixed at a volume ratio of 2 to 1, CB to CF. We doped the PC₆₁BM using dihydro-1H-benzoimidazol-2-yl (N-DBI) derivatives, specifically 3-dimethyl-2-phenyl-2,3-dihydro-1H-benzoimidazole (N-DMBI). We doped the PC₆₁BM precursor solution with N-DMBI at a 0.25% wt%. This solution was then filtered using a 0.45 µm PTFE filter. The substrates were preheated at 80 °C, we then dynamically spin coated this solution in a dry air atmosphere >10% relative humidity (RHM) at 4000 rpm for 20s, and annealed the substrate at 80 °C for 10 min.

**ACN/MA-MAPb**_{**0**.75}**Sn_{0.25}I₃ perovskite precursor solution preparation:**
To obtain a mixed-metal ACN/MA MAPb_{0.75}Sn_{0.25}I₃ perovskite precursor solution, we mixed an ACN/MA MAPbI₃ with an ACN/MA MAPb_{0.5}Sn_{0.5}I₃ (without any MA) at a 1:1 volume ratio, resulting in an ACN/MA MAPb_{0.75}Sn_{0.25}I₃. The ACN/MA MAPb_{0.5}Sn_{0.5}I₃ solution perovskite precursor solution without any MA was prepared, under nitrogen, using precursor salts methylammonium iodide (MAI) (Dyesol), lead iodide (PbI₂) (TCI), and anhydrous tin iodide (SnI₂) beads (TCI) added into anhydrous acetonitrile (ACN) (Sigma Aldrich) at a concentration of 0.8 M for MAI, 0.46 M for PbI₂ and 0.46 M for SnI₂, resulting in a non-stoichiometric solution with 15% excess metal salts (1: 1.15 MAI:PbI₂+SnI₂). This solution was then stirred under nitrogen at 70 °C for 1h, in order to fully react the MAI with the mixed metals, a black perovskite dispersion is then seen at the bottom of the ACN filled vial. The ACN/MA MAPbI₃ perovskite precursor solution was prepared using an adapted method described by Noel et al. We first prepare a ACN/MA MAPbI₃ perovskite precursor solution at a 0.8 M for MAI and 0.46 M for PbI₂, resulting in a non-stoichiometric solution with 15% excess metal salts (1:1.15 MAI:PbI₂). In order to dissolve the perovskite in ACN, a solution of methylamine (MA) in ethanol H₂O (Sigma Aldrich, 40 wt%) was placed into an aerator which was kept in an ice bath. Nitrogen was then bubbled into the solution, thus degassing the solution of MA. The MA gas which was produced was then passed through a drying tube filled with a desiccant (Drietire and CaO). The gas was bubbled into the black dispersion, while vigorously stirring the ACN/MA MAPbI₃ dispersion using a large magnetic stir bar at a speed of approximately 700 rpm. The dispersion was bubbled for 15 minutes, which resulted in a full dissolution of the black perovskite particles, resulting in a clear, light yellow solution. We note this solution has an "excess" amount of MA in the ACN/MA MAPbI₃ solution. The solution was then stored in nitrogen for approximately 3 h with activated 3 Å molecular sieves to remove any H₂O that was introduced during the MA bubbling process. ACN/MA MAPb_{0.75}Sn_{0.25}I₃ perovskite layer: This precursor perovskite solution is immediately dynamically spin coated in a nitrogen glovebox at 5000 rpm for 20s. A second subsequent spin coating step was used to deposit a methylammonium chloride (MACl) post treatment. A 2 mg ml⁻¹ solution of MACl in IPA was dynamically spin coated at 6000rpm for 20s. The films were then annealed in nitrogen at 80°C for 90 minutes.

**Spiro(TFSI)₂ synthesis:** The Spiro(TFSI)₂ hole-transporting layer used for the MAPb_{0.75}Sn_{0.25}I₃ perovskite was prepared using an adapted method described by Nguyen et al. (see W. H. Nguyen, C. D. Bailie, E. L. Unger, M. D. McGehee, J. Am. Chem. Soc. 2014, 136, 10996). We first dissolved 2,2',7,7'-tetrakis-(N,N-di-p-methoxyphenylamine)9,9'-spirobifluorene (spiro-OMeTAD) (Lumtec) solution in chlorobenzene (CB) at a 2 mg ml⁻¹ concentration. Separately, we dissolved the Silver(I) bis(trifluoromethanesulfonyl)imide (Ag-TFSI) in methanol at a 100 mg ml⁻¹. We slowly mixed identical volumes of both solutions together, while stirring. The final molar ratio is 1 to 0.95 (spiro-OMeTAD to Ag-TFSI). We then left the mixed solution stirring overnight. We filtered the solution with a 2 µm PTFE filter to remove the Ag colloids. We used a rotary evaporation to remove CB until approximately 5% of the original volume is left. We then added toluene to the remaining flask at a volume of 50% of the initial CB volume. We placed the solution in a refrigerator for 24h, where a fine black powder precipitated. Once, the black powder fully settled, we removed excess toluene using a glass frit filter. We washed the powder with a cold 4 °C toluene. Once the powder was dry, we prepared a 20 mg ml⁻¹ in methanol solution. This black powder should not have low solubility in methanol, which starts the precipitation process. We refrigerated the solution at 4 °C overnight. The black powder collected at the bottom of the vial. We removed the excess toluene using a glass frit filter, and washed with 4 °C methanol. Once dry, we collected and weighed the Spiro(TFSI)₂ powder.

### Spiro-OMeTAD doped with 10 wt.% Spiro(TFSI)₂ hole-transporting layer fabrication:

The electron-blocking layer was deposited by dynamically spin coating a spiro(TFSI)₂ doped spiro-OMeTAD at 2000 rpm for 30s in a nitrogen glovebox. This precursor solution was prepared with a 72.5 mg ml⁻¹ wt.% spiro solution composed of a 7.25 mg ml⁻¹ Spiro(TFSI)₂ and a 65.25 mg ml⁻¹ 2,2',7,7'-tetrakis-(N,N-di-p-methoxyphenylamine)9,9'-spirobifluorene (spiro-OMeTAD) (Lumtec) solution in chlorobenzene. No additives were added to the spiro-OMeTAD solution.

### Bottom Cell (BC) Fabrication: PEDOT:PSS/FA_{0.}₈₃Cs₀.₁₇Pb_{0.}₅Sn_{0.5}I₃/PC₆₁BM/BCP

**FA_{0.83}Cs_{0.17}Pb_{0.5}Sn_{0.5}I₃ perovskite precursor preparation:** A stoichiometric solution of 1.2 M FA_{0.83}Cs_{0.17}Pb_{0.5}Sn_{0.5}I₃ was prepared in a nitrogen atmosphere by dissolving FAI (Dyesol), CsI (99.9%, Alfa Aesar), PbI₂ (99.999%, Alfa Aesar), and SnI₂ (99.999%, Alfa Aesar) in a mixed solvent of 4:1 DMF:DMSO by volume. Also dissolved in the solution is 60 mM tin (II) fluoride (SnF₂, 99%, Sigma Aldrich) and 36 mM lead (II) thiocyanate (99.5%, Sigma Aldrich).

**Device preparation:** Patterned indium tin oxide (ITO) substrates were cleaned by sequentially rinsing in acetone and IPA. Once dried, the substrates were cleaned with an O₂-plasma for ten minutes. Immediately following plasma treatment, a PEDOT:PSS solution (PVP AI 4083, Heraeus, in a 1:2 volume ratio with methanol) was spin coated in ambient conditions at 4 krpm for 30 s, followed by annealing at 150 °C in ambient for 10 minutes. The devices were immediately transferred to a N₂ glovebox. Just prior to fabricating the perovskite film the PEDOT:PSS coated ITO substrates were annealed again at 120 °C for 10 minutes. The perovskite film was fabricated by spincoating the solution at 3.6 krpm for 14 s with a 6 s ramp. At 13 s after the start of the spincoating program, 200 µL of anisole was dispensed onto the spinning substrate. Once spincoating is finished, a stream of N₂ was applied to the film for 15 s and then immediately annealed at 120 °C for 10 minutes. The PC₆₁BM layer was produced by dynamically spincoating 50 uL of a hot solution (90°C) of PC₆₁BM (20 mg/mL dissolved in a mixed solvent of 3:1 chlorobenzene:1,2-dichlorobenzene by volume) at 2 krpm for 30 s and subsequently annealed at 90°C for 2 minutes. Once cooled to room temperature, 70 µL of a 0.5 mg/mL solution of bathocuproin (BCP, 98%, Alfa Aesar) was dynamically spincoated at 4 krpm for 20 s.

**Electrode:** A 100 nm silver or gold electrode was thermally evaporated under vacuum of ≈10⁻⁶ Torr, at a rate of ≈0.2 nm·s⁻¹.

**Solar cell characterization:** The current density-voltage (J-V) curves were measured (2400 Series SourceMeter, Keithley Instruments) under simulated AM 1.5 sunlight at 100 mWcm-2 irradiance generated by an Abet Class AAB sun 2000 simulator, with the intensity calibrated with an NREL calibrated KG5 filtered Si reference cell. The mismatch factor was calculated to be less than 1%. The active area of the solar cell is 0.0919 cm-2. The forward J-V scans were measured from forward bias (FB) to short circuit (SC) and the backward scans were from short circuit to forward bias, both at a scan rate of 0.25V s-1. A stabilization time of 5 seconds under 1 sun illumination and forward bias of 0.3V above the expected VOC was done prior to scanning.

**EQE characterization:** The multi-junction EQEs were measured by optically biasing the sub-cells that are not being measured with a 3W 470-475 nm LED and a 3W 730-740 nm LED, for the TC and for the BC, respectively. A negative bias equal to Voc of the sub-junction that is being optically biased was applied to the tandem during the measurement. This allows us to measure the response of the tandem in short-circuit condition.

**Transient photoconductivity:** The Nd:YAG laser excitation source tuned to 470 nm and pumped at 10 Hz with 7 ns pulses is used at the range of fluences to have various charge carrier density as described in the main text. This pulse light is illuminated in entire sample area to evenly excite the film. A bias of 24 V is applied across the in-plane (lateral) electrodes. Here, as the contact resistance between perovskite film and Au electrode is fairly small compared to sample resistance, we employ two electrodes conductivity measurement. A variable resistor is in series with sample in the circuit to always be <1% of the sample resistance. We monitored the voltage drop on variable series resistor through parallel oscilloscope (1MΩ) to determine the potential dropped across the two in-plane Au electrodes (4mm channel to channel distance) in sample. Perovskite film is scribed to have 5mm channel width, and coated with inert 200nm PMMA. Transient photoconductivity (σ_{Ph}) was calculated by the equation, ${σ}_{Ph} = \frac{Δ {V}_{Osc}}{{R}_{r} \times \left({V}_{bias}-{V}_{Osc}\right)} \times \frac{l}{w \times t}$ where, Rr is variable resistor, Vbias is bias voltage, l is channel-channel length, w is channel width, and t is film thickness.

### Modelling:

**Overview:** We modelled the optical properties of the stack using a generalized transfer matrix method (TMM) (see E. Centurioni, Appl. Opt. 2005, 44, 7532). All the calculations were done in Python with heavy use of the NumPy and SciPy libraries. The wavelength dependent complex refractive index, the layer thicknesses and the incidence angle were fed as input. The TMM model outputs the electric field distribution in the stack. This was used to calculate Transmittance *T*(*E*)*,* Reflectance *R*(*E*) and the absorption *A*(*E*) in each layer. The short circuit current of each sub-cell was then determined by assuming the internal quantum efficiency to be unity: ${J}_{SC} = q {\int }_{0}^{∞} A \left(E\right) ⋅ {ϕ}_{AM 1.5} \left(E\right) ⋅ dE$

Here, *ϕ*_{*AM*1.5}(*E*) is the photon flux from the AM1.5 spectrum.

The JV curve from each sub-cell was obtained by combining this modelled *J_{SC}* with the electrical characteristics of state-of-art single junction cells. To do this, we parametrized the JV curves of state-of-the-art single junctions as per the single diode equivalent model: $J \left(V\right) = {J}_{sun} - {J}_{0} \left({e}^{\frac{V + J \left(V\right) {R}_{S}}{{nV}_{T}}}-1\right) - \frac{V + J \left(V\right) {R}_{S}}{{R}_{SH}}$

Where *n, V_{T}, R_{S}, J*₀ *and R_{SH}* are respectively the electron charge, thermal voltage at 300K, series resistance, dark current, and shunt resistance. The JV curve of each multi-junction sub-cell is modelled by replacing *Jₛᵤₙ* in the fitted equation with the *J_{SC}* calculated from the multijunction stack. As the correlation between *Jₛᵤₙ* and other fitting parameters is negligible, we can be sure that *Jₛᵤₙ* can be changed without changing other parameters. The approach of Jain et al.(see A. Jain, A. Kapoor, Sol. Energy Mater. Sol. Cells 2004, 81, 269). was used to solve the single diode model using the Lambert W function. After calculating the JV curves of all sub-cells, we combined them to obtain the multi-junction JV curve (see A. Hadipour, B. de Boer, P. W. M. Blom, Org. Electron. 2008, 9, 617). The maximum point is calculated from this combined JV curve.

**Inputs for the Optical and Electrical Models:** The refractive indices for ITO, FTO, PEDOT:PSS, PCBM, Spiro-OMeTAD, Ag, MA_{0.4}FA_{0.6}Sn_{0.6}Pb_{0.4}I₃ and MAPbI₃ were taken from the literature (see T. A. F. König, P. A. Ledin, J. Kerszulis, M. A. Mahmoud, M. A. El-Sayed, J. R. Reynolds, V. V. Tsukruk, ACS Nano 2014, 8, 6182; J. M. Ball, S. D. Stranks, M. T. Hörantner, S. Hüttner, W. Zhang, E. J. W. Crossland, I. Ramirez, M. Riede, M. B. Johnston, R. H. Friend, H. J. Snaith, Energy Environ. Sci. 2015, 8, 602; D. Shi, V. Adinolfi, R. Comin, M. Yuan, E. Alarousu, A. Buin, Y. Chen, S. Hoogland, A. Rothenberger, K.

Katsiev, Y. Losovyj, X. Zhang, P. A. Dowben, O. F. Mohammed, E. H. Sargent, O. M. Bakr, Science 2015, 347, 519; V. S. Gevaerts, L. J. A. Koster, M. M. Wienk, R. A. J. Janssen, ACS Appl. Mater. Interfaces 2011, 3, 3252; M. Filipič, P. Löper, B. Niesen, S. De Wolf, J. Krč, C. Ballif, M. Topič, Opt. Express 2015, 23, A263; P. B. Johnson, R. W. Christy, Phys. Rev. B 1972, 6, 4370; M. T. Hörantner, T. Leijtens, M. E. Ziffer, G. E. Eperon, M. G. Christoforo, M. D. McGehee, H. J. Snaith, ACS Energy Lett. 2017, 2, 2506; P. Löper, M. Stuckelberger, B. Niesen, J. Werner, M. Filipič, S.-J. Moon, J.-H. Yum, M. Topič, S. De Wolf, C. Ballif, J. Phys. Chem. Lett. 2015, 6, 66). The extinction co-efficient *k* of FA_{0.83}Cs_{0.17}Pb(Br_{0.7}I_{0.3})₃ was obtained by measuring the transmittance *T* and the reflectance *R* of a thin film of thickness *t* on glass and using the relations: $α = \frac{4 πK}{λ}$ $\frac{T}{1 - R} = {e}^{αt}$

Once *k*(*λ*) was obtained, we parametrized it in terms of Lorentz oscillators to get an analytical representation, which was transformed into the refractive index *n*(*λ*) via the Kramers-Kronig transform: $n \left(λ\right) = 1 + \frac{2}{π} {\int }_{0}^{∞} \frac{E ′ k \left(E\right)}{E {′}^{2} - {E}^{2}} dE ′$

The electrical characteristics for the MAPbI₃ and the MAPb_{0.75}Sn_{0.25}I₃ are taken from best reported cells of same or similar class in the literature (see S. S. Shin, E. J. Yeom, W. S. Yang, S. Hur, M. G. Kim, J. Im, J. Seo, **2017,** *6620;* R. Prasanna, A. Gold-Parker, T. Leijtens, B. Conings, A. Babayigit, H. G. Boyen, M. F. Toney, M. D. McGehee, J. Am. Chem. Soc. 2017, 139, 11117). For the FA_{0.83}Cs_{0.17}Pb(Br_{0.7}I_{0.3})₃ sub-cell, we use the JV curve of our best FA_{0.83}Cs_{0.17}Pb(Br_{0.7}I_{0.3})₃ single junction cell (Fig. 7). To account for the ITO nanoparticles being embedded in PCBM, we model its refractive index as a Bruggeman Effective Medium with 75% ITO and 25% PCBM. The refractive index of this effective medium is calculated by solving: $\frac{{f}_{ITO} \left({n}_{ITO}^{2}-{n}^{2}\right)}{\left({n}_{ITO}^{2}+2{n}^{2}\right)} = \frac{\left(1-{f}_{FTO}\right) \left({n}_{PCBM}^{2}-{n}^{2}\right)}{\left({n}_{PCBM}^{2}+2{n}^{2}\right)}$

Where *n_{ITO}, n_{PCBM}* and *f_{ITO}* are respectively the complex refractive index of ITO, complex refractive index of PCBM and the fraction of ITO in the effective medium.

### Tandem Simulation

**FA_{0.83}Cs_{0.17}Pb(Br**_{**0**.}**₇I_{0.3})₃/MAPbI₃ simulation -** **Figure 4A****,B:** The thicknesses used in the optical model are obtained from an SEM cross section of the tandem. The electrical characteristics of FA_{0.83}Cs_{0.17}Pb(Br_{0.7}I_{0.3})₃ and MAPbI₃ presented are extracted from our own single junction devices (Fig. 7). The dotted JV models the performance assuming the MAPbI₃ performs as well as the best ACN processed MAPbI₃ cell in literature.

| **Layer** | **Thickness** |
|---|---|
| Glass | 2.2mm |
| ITO | 350nm |
| SnO₂ | 40nm |
| PCBM | 10nm |
| FA_{0.83}Cs_{0.17}Pb(Br_{0.7}I_{0.3})₃ | 350nm |
| Spiro-OMeTAD | 250nm |
| PEDOT:PSS | 50nm |
| ITO Nanoparticles:PCBM 75:25 Effective Medium | 50nm |
| PCBM | 80nm |
| MAPbI₃ | 530nm |
| Spiro-OMeTAD | 180nm |
| Ag | 100nm |

**FA_{0.83}Cs_{0.17}Pb(Br_{0.7}I_{0.3})₃/MAPbI₃ (optimized) -** **Figure 4C****,D:** We cap the thicknesses of the non-perovskite layers at 50nm. We add a MgF₂ anti-reflecting coating. We optimize the thicknesses of the perovskite layers and the anti-reflecting coating using a differential evolution algorithm to maximize the limiting current. The electrical characteristics of the FA_{0.83}Cs_{0.17}Pb(Br_{0.7}I_{0.3})₃ are from our own device (Fig 7). The characteristics of the MAPbI₃ are from the best cell MAPbI₃ in literature (see S. S. Shin, E. J. Yeom, W. S. Yang, S. Hur, M. G. Kim, J. Im, J. Seo, J. H. Noh, S. Il Seok, Science 2017, 356, 167). The dotted JV curve models the performance of the tandem assuming the top cell electrically performs as well as current state-of-the-art in Perovskites. We follow the approach of Hörantner et al (see M. T. Hörantner, T. Leijtens, M. E. Ziffer, G. E. Eperon, M. G. Christoforo, M. D. McGehee, H. J. Snaith, ACS Energy Lett. 2017, 2, 2506) for this, and assume *EQE_{EL}* = 0.01, *R_{S}* = 4 · 10⁻² Ω *cm*² and *R_{SH}* = 10*M*Ω *cm*²*.*

| Layer | Thickness |
|---|---|
| MgF₂ | Search space: 10-500nm |
| | Optimized: 104nm |
| Glass | 2.2mm |
| FTO | 50nm |
| SnO₂ | 40nm |
| PCBM | 10nm |
| FA_{0.83}Cs_{0.17}Pb(Br_{0.7}I_{0.3})₃ | Search space: 100-1500nm |
| | Optimized: 381nm |
| Spiro-OMeTAD | 50nm |
| PEDOT:PSS | 50nm |
| ITO Nanoparticles: PCBM 75:25 Effective Medium | 50nm |
| PCBM | 50nm |
| MAPbI₃ | Search space: 100-1500nm |
| | Optimized: 1382nm |
| Spiro-OMeTAD | 50nm |
| Ag | 100nm |

**FA_{0.83}Cs_{0.17}Pb(Br**_{**0**.}**₇I**_{**0**.}**₃)₃/MAPbI₃/MA_{0.4}FA_{0.6}Pb_{0.4}Sn_{0.6}I₃ (optimized) simulation** - **Figure 4** **E,F:** The calculations for figures E,F are performed exactly as for figures C,D. For the dotted triple junction JV curve, both the bottom and top cells are modelled as current state-of-the-art perovskite cells.

| **Layer** | **Thickness** |
|---|---|
| MgF₂ | Search space: 10-500nm |
| | Optimized: 92.8nm |
| Glass | 2.2mm |
| FTO | 50nm |
| SnO₂ | 40nm |
| PCBM | 10nm |
| FA_{0.83}Cs_{0.17}Pb(Br_{0.7}I_{0.3})₃ | Search space: 100-1500nm |
| | Optimized: 296.7nm |
| Spiro-OMeTAD | 50nm |
| PEDOT:PSS | 15nm |
| ITO Nanoparticles:PCBM 75:25 Effective Medium | 50nm |
| PCBM | 50nmnm |
| MAPbI₃ | Search space: 100-1500nm |
| | Optimized: 583.3 |
| Spiro-OMeTAD | 50nm |
| PEDOT:PSS | 15nm |
| ITO Nanoparticles:PCBM 75:25 Effective Medium | 50nm |
| PCBM | 50nm |
| MA_{0.4}FA_{0.6}Pb_{0.4}Sn_{0.6}I₃ | Search space: 100-1500nm |
| | Optimized: 1382.4 |
| Spiro-OMeTAD | 50nm |
| Ag | 100nm |

## Claims

1. A process for producing a multi-junction device comprising a layer of a crystalline A/M/X material, which crystalline A/M/X material comprises a compound of formula
[A]ₐ[M]_{b}[X]_{c}
wherein:
[A] comprises one or more A cations;
[M] comprises one or more M cations which are metal or metalloid cations;
[X] comprises one or more X anions;
a is a number from 1 to 6;
b is a number from 1 to 6; and
c is a number from 1 to 18; and
wherein the process comprises forming the layer of the crystalline A/M/X material by disposing a film-forming solution on a substrate, wherein the film-forming solution comprises:
(a) one or more M cations; and
(b) a solvent;
wherein the solvent comprises
(i) an aprotic solvent; and
(ii) an organic amine
and wherein the substrate comprises:
a photoactive region comprising a photoactive material, and
a charge recombination layer which is disposed on the photoactive region;
wherein the process further comprises a step of producing the substrate by disposing the charge recombination layer on the photoactive region by solution deposition, **characterized in that** said step comprises disposing a solvent dispersion of nanoparticles of a transparent conducting oxide on the photoactive region.

2. A process according to claim 1 wherein: the aprotic solvent is a polar aprotic solvent, and/or the substrate further comprises a layer of a charge transporting material disposed on the charge recombination layer.

3. A process according to claim 1 or claim 2 comprising a step of producing the substrate by:
disposing a layer of a charge transporting material on the charge recombination layer.

4. A process according to any preceding claim wherein:
(A) the photoactive material in the substrate is soluble in dimethylformamide (DMF), dimethysulfoxide (DMSO) or a mixture thereof, or at least one component of the charge recombination layer in the substrate is soluble in dimethylformamide (DMF), dimethysulfoxide (DMSO) or a mixture thereof;
preferably wherein both the photoactive material in the substrate, and at least one component of the charge recombination layer in the substrate, are soluble in dimethylformamide (DMF), dimethysulfoxide (DMSO) or a mixture thereof;
more preferably wherein both the photoactive material in the substrate, and the charge recombination layer in the substrate, are soluble in dimethylformamide (DMF), dimethysulfoxide (DMSO) or a mixture thereof; and/or
(B) the transparent conducting oxide comprises indium tin oxide (ITO), optionally wherein the nanoparticles of the transparent conducting oxide are disposed in a matrix material, for instance an organic matrix material, optionally an electron-transporting organic matrix material, optionally wherein the organic matrix material comprises [6,6]-phenyl-C61-butyric acid methyl ester (PCBM), and optionally wherein the charge recombination layer further comprises a conducting polymer, preferably wherein the conducting polymer comprises poly(3,4-ethylenedioxythiophene) and polystyrene sulfonate (PEDOT:PSS).

5. A process according to claim 3, or claim 4 as dependent on claim 3, wherein disposing the charge recombination layer on the photoactive region further comprises disposing a conducting polymer on the photoactive region, and disposing a solvent dispersion of nanoparticles of a transparent conducting oxide on the photoactive region; optionally wherein the solvent dispersion of nanoparticles further comprises a matrix material, for instance an organic matrix material, and optionally wherein the solvent dispersion of the nanoparticles and/or the conducting polymer is disposed on the photoactive region by spin-coating.

6. A process according to any preceding claim, wherein:
the aprotic solvent does not comprise dimethylformamide, preferably wherein the aprotic solvent does not comprise dimethylformamide, dimethylsulfoxide or mixtures thereof; and/or
the aprotic solvent comprises a compound selected from the group consisting of chlorobenzene, acetone, butanone, methylethylketone, acetonitrile, propionitrile, toluene or a mixture thereof, preferably wherein the aprotic solvent comprises acetonitrile; and/or
the organic amine is an unsubstituted or substituted alkylamine or an unsubstituted or substituted arylamine, optionally wherein the organic amine is an unsubstituted or substituted (C₁₋₁₀ alkyl) amine, preferably wherein the organic amine is an unsubstituted (C₁₋₁₀ alkyl) amine or a (C₁₋₁₀ alkyl) amine substituted with a phenyl group, more preferably wherein the organic amine is methylamine, ethylamine, propylamine, butylamine or pentylamine, or hexylamine, benzyl amine or phenyl ethyl amine, more preferably wherein the organic amine is methylamine.

7. A process according to any one of the preceding claims wherein:
the compound of formula [A]ₐ[M]_{b}[X]_{c} is a compound of formula [A][M][X]₃, wherein [A], [M] and [X] are as defined in claim 1; and/or
[A] comprises at least one organic cation; and/or
each A cation is selected from: an alkali metal cation; a cation of the formula [R₁R₂R₃R₄N]⁺, wherein each of R₁, R₂, R₃, R₄ is independently selected from hydrogen, unsubstituted or substituted C₁₋₂₀ alkyl, and unsubstituted or substituted C₆₋₁₂ aryl, and at least one of R₁, R₂, R₃ and R₄ is not hydrogen; a cation of the formula [R₅R₆N=CH-NR₇R₈]⁺, wherein each of R₅, R₆, R₇ and R₈ is independently selected from hydrogen, unsubstituted or substituted C₁₋₂₀ alkyl, and unsubstituted or substituted C₆₋₁₂ aryl; and C₁₋₁₀ alkylamammonium, C₂₋₁₀ alkenylammonium, C₁₋₁₀ alkyliminium, C₃₋₁₀ cycloalkylammonium and C₃₋₁₀ cycloalkyliminium, each of which is unsubstituted or substituted with one or more substituents selected from amino, C₁₋₆ alkylamino, imino, C₁₋₆ alkylimino, C₁₋₆ alkyl, C₂₋₆ alkenyl, C₃₋₆ cycloalkyl and C₆₋₁₂ aryl; preferably wherein each A cation is selected from Cs⁺, Rb⁺, methylammonium, dimethyl ammonium, trimethylammonium, ethylammonium, propylammonium. Butylammonium, pentylammoium, hexylammonium, septylammonium, octylammonium, tetramethylammonium, formamidinium, 1-aminoethan-1-iminium and guanidinium; and/or
[M] comprises two or more different M cations; and/or
each M cation is selected from Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ and Eu²⁺, preferably Sn²⁺, Pb²⁺, Cu²⁺, Ge²⁺, and Ni²⁺; preferably Sn²⁺ and Pb²⁺; and/or
each X anion is a halide, optionally wherein [X] comprises two or more different halide anions; and/or
[A] comprises a cation of the formula [R₁NH₃]⁺, wherein R₁ is unsubstituted C₁₋₁₀ alkyl and wherein the organic amine comprises an unsubstituted (C₁₋₁₀ alkyl) amine, preferably wherein the C₁₋₁₀ alkyl group on the A cation of formula [R₁NH₃]⁺ and the C₁₋₁₀ alkyl group on the unsubstituted (C₁₋₁₀ alkyl) amine are the same, more preferably wherein [A] comprises methylammonium and the organic amine comprises methylamine.

8. A process according to any preceding claim wherein:
the photoactive material in the photoactive region in the substrate comprises a crystalline A/M/X material, which crystalline A/M/X material comprises a compound of formula [A]ₐ[M]_{b}[X]_{c} as defined in claim 1 or claim 7, optionally wherein the crystalline A/M/X material deposited on the substrate and the crystalline A/M/X material in the photoactive region are different; and/or
the substrate comprises two separate photoactive regions, wherein each photoactive region comprises a photoactive material, preferably wherein each photoactive material in each photoactive region comprises a crystalline A/M/X material, which crystalline A/M/X material comprises a compound of formula [A]ₐ[M]_{b}[X]_{c} as defined in claim 1 or claim 7, optionally wherein at least two of the crystalline A/M/X materials selected from the crystalline A/M/X material deposited on the substrate and the crystalline A/M/X materials in the two photoactive regions are different, optionally wherein all three of the crystalline A/M/X materials selected from the crystalline A/M/X material deposited on the substrate and the crystalline A/M/X materials in the two photoactive regions are different are different; and/or
the film-forming solution further comprises one or more A cations and one or more X anions; and/or
the process further comprises a step of disposing on the substrate a composition comprising one or more A cations and optionally one or more X anions; and/or
disposing the film-forming composition on the substrate comprises a step of spin-coating the film-forming solution on the substrate; and/or
the process further comprises removing the solvent to form the layer comprising the crystalline A/M/X material, optionally wherein the solvent is removed by heating the film-forming solution treated substrate, optionally by heating the film-forming solution treated substrate to a temperature of from 50°C to 200°C, optionally for a time of from 10 to 100 minutes.

9. A process according to any one of the preceding claims wherein:
(A) the substrate comprises
i) a first electrode, preferably wherein the first electrode comprises a transparent conducting oxide,
ii) a photoactive region, said photoactive region preferably comprising a crystalline A/M/X material which crystalline A/M/X material comprises a compound of formula [A]ₐ[M]_{b}[X]_{c} as defined in claim 1 or claim 7,
iii) a charge recombination layer disposed on the photoactive region, optionally wherein the charge recombination layer is as defined in claim 4, and
iv) optionally, a layer of a charge transporting material disposed on the charge recombination layer; and/or
(B) the process further comprises:
disposing a second electrode on the layer of the crystalline A/M/X material disposed on the substrate,
or, preferably, disposing a charge transporting material on the layer of the crystalline A/M/X material disposed on the substrate, and disposing a second electrode on the charge transporting material,
preferably wherein the second electrode comprises elemental metal.

10. A process according to any one of claims 1 to 9, wherein the multi-junction device is an optoelectronic device, optionally wherein the optoelectronic device is a photovoltaic device or a light-emitting device.

## Patentansprüche

1. Verfahren zur Herstellung einer Mehrfachübergangsvorrichtung, die eine Schicht aus einem kristallinen A/M/X-Material umfasst, wobei das kristalline A/M/X-Material eine Verbindung der folgenden Formel umfasst:
[A]ₐ[M]_{b}[X]_{c}
wobei:
[A] ein oder mehrere A-Kationen umfasst;
[M] ein oder mehrere M-Kationen umfasst, die Metall- oder Metalloid-Kationen sind;
[X] ein oder mehrere X-Anionen umfasst;
a eine Zahl von 1 bis 6 ist;
b eine Zahl von 1 bis 6 ist; und
c eine Zahl von 1 bis 18 ist; und
wobei das Verfahren die Bildung der Schicht des kristallinen A/M/X-Materials durch Aufbringen einer filmbildenden Lösung auf ein Substrat umfasst, wobei die filmbildende Lösung umfasst:
(a) ein oder mehrere M-Kationen; und
(b) ein Lösungsmittel;
wobei das Lösungsmittel umfasst
(i) ein aprotisches Lösungsmittel; und
(ii) ein organisches Amin
und wobei das Substrat umfasst:
einen photoaktiven Bereich, der ein photoaktives Material umfasst, und
eine Ladungsrekombinationsschicht, die auf dem photoaktiven Bereich angeordnet ist;
wobei das Verfahren ferner einen Schritt der Herstellung des Substrats durch Aufbringen der Ladungsrekombinationsschicht auf dem photoaktiven Bereich durch Lösungsabscheidung umfasst,
**dadurch gekennzeichnet, dass** der Schritt das Aufbringen einer Lösungsmitteldispersion von Nanopartikeln eines transparenten leitenden Oxids auf den photoaktiven Bereich umfasst.

2. Verfahren nach Anspruch 1, wobei: das aprotische Lösungsmittel ein polares aprotisches Lösungsmittel ist, und/oder das Substrat ferner eine Schicht aus einem ladungstransportierenden Material umfasst, die auf der Ladungsrekombinationsschicht angeordnet ist.

3. Verfahren nach Anspruch 1 oder Anspruch 2, umfassend einen Schritt der Herstellung des Substrats durch:
Aufbringen einer Schicht aus einem ladungstransportierenden Material auf die Ladungsrekombinationsschicht.

4. Verfahren nach einem der vorhergehenden Ansprüche, wobei:
(A) das photoaktive Material im Substrat in Dimethylformamid (DMF), Dimethysulfoxid (DMSO) oder einer Mischung davon löslich ist, oder mindestens eine Komponente der Ladungsrekombinationsschicht im Substrat in Dimethylformamid (DMF), Dimethysulfoxid (DMSO) oder einem Gemisch davon löslich ist;
wobei vorzugsweise sowohl das photoaktive Material im Substrat als auch mindestens eine Komponente der Ladungsrekombinationsschicht im Substrat in Dimethylformamid (DMF), Dimethysulfoxid (DMSO) oder einem Gemisch davon löslich sind;
noch bevorzugter wobei sowohl das photoaktive Material im Substrat als auch mindestens eine Komponente der Ladungsrekombinationsschicht im Substrat in Dimethylformamid (DMF), Dimethysulfoxid (DMSO) oder einem Gemisch davon löslich sind; und/oder
(B) das transparente leitende Oxid Indium-Zinn-Oxid (ITO) umfasst, optional wobei die Nanopartikel des transparenten leitenden Oxids in einem Matrixmaterial angeordnet sind, zum Beispiel einem organischen Matrixmaterial, optional einem elektronentransportierenden organischen Matrixmaterial, optional wobei das organische Matrixmaterial [6,6]-Phenyl-C61-Buttersäuremethylester (PCBM) umfasst, und optional wobei die Ladungsrekombinationsschicht ferner ein leitendes Polymer umfasst, vorzugsweise wobei das leitende Polymer Poly(3,4-ethylendioxythiophen) und Polystyrolsulfonat (PEDOT:PSS) umfasst.

5. Verfahren nach Anspruch 3, oder Anspruch 4 in Abhängigkeit von Anspruch 3, wobei das Aufbringen der Ladungsrekombinationsschicht auf den photoaktiven Bereich ferner das Aufbringen eines leitenden Polymers auf den photoaktiven Bereich und das Aufbringen einer Lösungsmitteldispersion von Nanopartikeln eines transparenten leitenden Oxids auf den photoaktiven Bereich umfasst; optional wobei die Lösungsmitteldispersion von Nanopartikeln ferner ein Matrixmaterial, beispielsweise ein organisches Matrixmaterial, umfasst, und optional wobei die Lösungsmitteldispersion der Nanopartikel und/oder das leitende Polymer durch Schleuderbeschichtung auf dem photoaktiven Bereich angeordnet ist.

6. Verfahren nach einem der vorhergehenden Ansprüche, wobei:
das aprotische Lösungsmittel nicht Dimethylformamid umfasst, vorzugsweise wobei das aprotische Lösungsmittel nicht Dimethylformamid, Dimethylsulfoxid oder Mischungen davon umfasst; und/oder
das aprotische Lösungsmittel eine Verbindung umfasst, die ausgewählt ist aus der Gruppe bestehend aus Chlorbenzol, Aceton, Butanon, Methylethylketon, Acetonitril, Propionitril, Toluol oder einem Gemisch davon, vorzugsweise wobei das aprotische Lösungsmittel Acetonitril umfasst; und/oder
das organische Amin ein unsubstituiertes oder substituiertes Alkylamin oder ein unsubstituiertes oder substituiertes Arylamin ist, optional wobei das organische Amin ein unsubstituiertes oder substituiertes (C₁₋₁₀-Alkyl)amin ist, vorzugsweise wobei das organische Amin ein unsubstituiertes (C₁₋₁₀-Alkyl)amin oder ein mit einer Phenylgruppe substituiertes (C₁₋₁₀-Alkyl)amin ist, noch bevorzugter wobei das organische Amin Methylamin, Ethylamin, Propylamin, Butylamin oder Pentylamin, oder Hexylamin, Benzylamin oder Phenylethylamin ist, noch bevorzugter wobei das organische Amin Methylamin ist.

7. Verfahren nach einem der vorhergehenden Ansprüche, wobei:
die Verbindung der Formel [A ]ₐ[M]_{b}[X]_{c} eine Verbindung der Formel [A][M][X]₃ ist, wobei [A], [M] und [X] wie in Anspruch 1 definiert sind; und/oder
[A] mindestens ein organisches Kation umfasst; und/oder
jedes A-Kation ausgewählt ist aus: einem Alkalimetallkation; einem Kation der Formel [R₁R₂R₃R₄N]⁺, wobei jedes von R₁, R₂, R₃, R₄ unabhängig voneinander ausgewählt ist aus Wasserstoff, unsubstituiertem oder substituiertem C₁₋₂₀-Alkyl und unsubstituiertem oder substituiertem C₆₋₁₂-Aryl, und mindestens eines von R₁, R₂, R₃ und R₄ nicht Wasserstoff ist; einem Kation der Formel [R₅R₆N=CH-NR₇R₈]⁺, wobei jedes von R₅, R₆, R₇ und R₈ unabhängig voneinander ausgewählt ist aus Wasserstoff, unsubstituiertem oder substituiertem C₁₋₂₀-Alkyl und unsubstituiertem oder substituiertem C₆₋₁₂-Aryl; und C₁₋₁₀-Alkylammonium, C₂₋₁₀-Alkenylammonium, C₁₋₁₀-Alkyliminium, C₃₋₁₀-Cycloalkylammonium und C₃₋₁₀-Cycloalkyliminium, von denen jedes unsubstituiert oder mit einem oder mehreren Substituenten, ausgewählt aus Amino, C₁₋₆-Alkylamino, Imino, C₁₋₆-Alkylimino, C₁₋₆-Alkyl, C₂₋₆-Alkenyl, C₃₋₆-Cycloalkyl und C₆₋₁₂-Aryl, substituiert ist; vorzugsweise wobei jedes A-Kation ausgewählt ist aus Cs⁺, Rb⁺, Methylammonium, Dimethylammonium, Trimethylammonium, Ethylammonium, Propylammonium, Butylammonium, Pentylammonium, Hexylammonium, Septylammonium, Octylammonium, Tetramethylammonium, Formamidinium, 1-Aminoethan-1-iminium und Guanidinium; und/oder
[M] zwei oder mehr verschiedene M-Kationen umfasst; und/oder
jedes M-Kation ausgewählt ist aus Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺ und Eu²⁺, vorzugsweise Sn²⁺, Pb²⁺, Cu²⁺, Ge²⁺ und Ni²⁺; vorzugsweise Sn²⁺ und Pb²⁺; und/oder
jedes Anion X ein Halogenid ist, vorzugsweise wobei [X] zwei oder mehr verschiedene Halogenidanionen umfasst; und/oder
[A] ein Kation der Formel [R₁NH₃]⁺ umfasst, wobei R₁ unsubstituiertes C₁₋₁₀-Alkyl ist und wobei das organische Amin ein unsubstituiertes (C₁₋₁₀-Alkyl)amin umfasst, vorzugsweise wobei die C₁₋₁₀-Alkylgruppe an dem A-Kation der Formel [R₁NH₃]⁺ und die C₁₋₁₀-Alkylgruppe an dem unsubstituierten (C₁₋₁₀-Alkyl)amin gleich sind, noch bevorzugter, wobei [A] Methylammonium und das organische Amin Methylamin umfasst.

8. Verfahren nach einem der vorhergehenden Ansprüche, wobei:
das photoaktive Material in dem photoaktiven Bereich in dem Substrat ein kristallines A/M/X-Material umfasst, wobei das kristalline A/M/X-Material eine Verbindung der Formel [A]ₐ[M]_{b}[X]_{c} wie in Anspruch 1 oder 7 definiert umfasst, optional, wobei das auf dem Substrat abgeschiedene kristalline A/M/X-Material und das kristalline A/M/X-Material in dem photoaktiven Bereich unterschiedlich sind; und/oder
das Substrat zwei getrennte photoaktive Bereiche umfasst, wobei jeder photoaktive Bereich ein photoaktives Material umfasst, vorzugsweise wobei jedes photoaktive Material in jedem photoaktiven Bereich ein kristallines A/M/X-Material umfasst, wobei das kristalline A/M/X-Material eine Verbindung der Formel [A]ₐ[M]_{b}[X]_{c}, wie in Anspruch 1 oder Anspruch 7 definiert, umfasst, optional wobei mindestens zwei der kristallinen A/M/X-Materialien, ausgewählt aus dem auf dem Substrat abgeschiedenen kristallinen A/M/X-Material und den kristallinen A/M/X-Materialien in den beiden photoaktiven Bereichen, unterschiedlich sind, optional wobei alle drei der kristallinen A/M/X-Materialien, ausgewählt aus dem auf dem Substrat abgeschiedenen kristallinen A/M/X-Material und den kristallinen A/M/X-Materialien in den beiden photoaktiven Bereichen, unterschiedlich sind; und/oder
die filmbildende Lösung ferner ein oder mehrere A-Kationen und ein oder mehrere X-Anionen enthält; und/oder
das Verfahren ferner einen Schritt des Aufbringens einer Zusammensetzung, die ein oder mehrere A-Kationen und optional ein oder mehrere X-Anionen enthält, auf das Substrat umfasst; und/oder
das Aufbringen der filmbildenden Zusammensetzung auf das Substrat einen Schritt der Schleuderbeschichtung der filmbildenden Lösung auf das Substrat umfasst; und/oder
das Verfahren ferner das Entfernen des Lösungsmittels umfasst, um die Schicht zu bilden, die das kristalline A/M/X-Material umfasst, optional wobei das Lösungsmittel durch Erhitzen des mit filmbildender Lösung behandelten Substrats entfernt wird, optional durch Erhitzen des mit filmbildender Lösung behandelten Substrats auf eine Temperatur von 50°C bis 200°C, optional für eine Zeit von 10 bis 100 Minuten.

9. Verfahren nach einem der vorhergehenden Ansprüche, wobei:
(A) das Substrat umfasst
i) eine erste Elektrode, wobei die erste Elektrode vorzugsweise ein transparentes, leitendes Oxid umfasst,
ii) einen photoaktiven Bereich, wobei der photoaktive Bereich vorzugsweise ein kristallines A/M/X-Material umfasst, wobei das kristalline A/M/X-Material eine Verbindung der Formel [A]ₐ[M]_{b}[X]_{c}, wie in Anspruch 1 oder Anspruch 7 definiert, umfasst,
iii) eine Ladungsrekombinationsschicht, die auf dem photoaktiven Bereich angeordnet ist, optional, wobei die Ladungsrekombinationsschicht wie in Anspruch 4 definiert ist, und
iv) optional eine Schicht aus einem ladungstransportierenden Material, die auf der Ladungsrekombinationsschicht angeordnet ist; und/oder
(B) das Verfahren ferner umfasst:
Anordnen einer zweiten Elektrode auf der Schicht des kristallinen A/M/X-Materials, die auf dem Substrat angeordnet ist,
oder, vorzugsweise, Anordnen eines ladungstransportierenden Materials auf der Schicht des kristallinen A/M/X-Materials, die auf dem Substrat angeordnet ist, und Anordnen einer zweiten Elektrode auf dem ladungstransportierenden Material,
wobei die zweite Elektrode vorzugsweise aus elementarem Metall besteht.

10. Verfahren nach einem der Ansprüche 1 bis 9, wobei die Mehrfachübergangsvorrichtung eine optoelektronische Vorrichtung ist, optional wobei die optoelektronische Vorrichtung eine photovoltaische Vorrichtung oder eine lichtemittierende Vorrichtung ist.

## Revendications

1. Procédé pour produire un dispositif multi-jonction comprenant une couche d'un matériau A/M/X cristallin, lequel matériau A/M/X cristallin comprend un composé de la formule
[A]ₐ[M]_{b}[X]_{c}
dans lequel :
[A] comprend un ou plusieurs cations A ;
[M] comprend un ou plusieurs cations M qui sont des cations métalliques ou métalloïdes ;
[X] comprend un ou plusieurs anions X ;
a est un nombre de 1 à 6 ;
b est un nombre de 1 à 6 ; et
c est un nombre de 1 à 18 ; et
dans lequel le procédé comprend le fait de former la couche du matériau A/M/X cristallin en disposant une solution filmogène sur un substrat, dans lequel la solution filmogène comprend :
(a) un ou plusieurs cations M ; et
(b) un solvant ;
dans lequel le solvant comprend
(i) un solvant aprotique ; et
(ii) une amine organique,
et dans lequel le substrat comprend :
une région photoactive comprenant un matériau photoactif, et
une couche de recombinaison de charge qui est disposée sur la région photoactive ;
dans lequel le procédé comprend en outre une étape consistant à produire le substrat en disposant la couche de recombinaison de charge sur la région photoactive par dépôt en solution,
**caractérisé en ce que** ladite étape comprend le fait de disposer une dispersion de solvant de nanoparticules d'un oxyde conducteur transparent sur la région photoactive.

2. Procédé selon la revendication 1 dans lequel : le solvant aprotique est un solvant aprotique polaire, et/ou le substrat comprend en outre une couche d'un matériau de transport de charge disposée sur la couche de recombinaison de charge.

3. Procédé selon la revendication 1 ou la revendication 2, comprenant une étape consistant à produire le substrat en :
disposant une couche d'un matériau de transport de charge sur la couche de recombinaison de charge.

4. Procédé selon une quelconque revendication précédente, dans lequel :
(A) le matériau photoactif dans le substrat est soluble dans du diméthylformamide (DMF), diméthylsulfoxyde (DMSO), ou un mélange de ceux-ci, ou au moins un composant de la couche de recombinaison de charge dans le substrat est soluble dans du diméthylformamide (DMF), du diméthylsulfoxyde (DMSO), ou un mélange de ceux-ci ;
de préférence dans lequel le matériau photoactif dans le substrat, et au moins un composant de la couche de recombinaison de charge dans le substrat, sont tous les deux solubles dans du diméthylformamide (DMF), du diméthylsulfoxyde (DMSO), ou un mélange de ceux-ci ;
mieux encore dans lequel le matériau photoactif dans le substrat, et la couche de recombinaison de charge dans le substrat, sont tous les deux solubles dans du diméthylformamide (DMF), du diméthylsulfoxyde (DMSO), ou un mélange de ceux-ci ; et/ou
(B) l'oxyde conducteur transparent comprend de l'oxyde d'indium-étain (ITO), facultativement dans lequel les nanoparticules de l'oxyde conducteur transparent sont disposées dans un matériau de base, par exemple un matériau de base organique, facultativement un matériau de base organique de transport d'électrons, facultativement dans lequel le matériau de base organique comprend de l'ester méthylique d'acide [6,6]-phényl-C61-butyrique (PCBM), et facultativement dans lequel la couche de recombinaison de charge comprend en outre un polymère conducteur, de préférence dans lequel le polymère conducteur comprend du poly(3,4-éthylènedioxythiophène) et du sulfonate de polystyrène (PEDOT : PSS).

5. Procédé selon la revendication 3, ou la revendication 4 lorsqu'elle dépend de la revendication 3, dans lequel le fait de disposer la couche de recombinaison de charge sur la région photoactive comprend en outre le fait de disposer un polymère conducteur sur la région photoactive, et le fait de disposer une dispersion de solvant de nanoparticules d'un oxyde conducteur transparent sur la région photoactive ; facultativement dans lequel la dispersion de solvant de nanoparticules comprend en outre un matériau de base, par exemple un matériau de base organique, et facultativement dans lequel la dispersion de solvant des nanoparticules et/ou le polymère conducteur est disposé(e) sur la région photoactive par dépôt à la tournette.

6. Procédé selon une quelconque revendication précédente, dans lequel :
le solvant aprotique ne comprend pas de diméthylformamide, de préférence dans lequel le solvant aprotique ne comprend pas de diméthylformamide, de diméthylsulfoxyde, ou de mélanges de ceux-ci ; et/ou
le solvant aprotique comprend un composé sélectionné parmi le groupe constitué de : chlorobenzène, acétone, butanone, méthyléthylcétone, acétonitrile, propionitrile, toluène, ou un mélange de ceux-ci, de préférence dans lequel le solvant aprotique comprend de l'acétonitrile ; et/ou
l'amine organique est une alkylamine non substituée ou substituée ou une arylamine non substituée ou substituée, facultativement dans lequel l'amine organique est une (alkyle en C₁₋₁₀)-amine non substituée ou substituée, de préférence dans lequel l'amine organique est une (alkyle en C₁₋₁₀)-amine non substituée ou une (alkyle en C₁₋₁₀)-amine substituée avec un groupe phényle, mieux encore dans lequel l'amine organique est : méthylamine, éthylamine, propylamine, butylamine ou pentylamine, ou hexylamine, benzylamine ou phényléthylamine, mieux encore dans lequel l'amine organique est méthylamine.

7. Procédé selon l'une quelconque des revendications précédentes, dans lequel :
le composé de la formule [A]ₐ[M]_{b}[X]_{c} est un composé de la formule [A] [M] [X]₃, dans lequel [A], [M] et [X] sont tels que définis dans la revendication 1 ; et/ou
[A] comprend au moins un cation organique ; et/ou
chaque cation A est sélectionné parmi : un cation de métal alcalin ; un cation de la formule [R₁R₂R₃R₄N]⁺, dans lequel chacun de R₁, R₂, R₃, R₄ est indépendamment sélectionné parmi : hydrogène, alkyle en C₁₋₂₀ non substitué ou substitué, et aryle en C₆₋₁₂ non substitué ou substitué, et au moins un de R₁, R₂, R₃, et R₄ n'est pas hydrogène ; un cation de la formule [R₅R₆N=CH-NR₇R₈]⁺, dans lequel chacun de R₅, R₆, R₇, et R₈ est indépendamment sélectionné parmi : hydrogène, alkyle en C₁₋₂₀ non substitué ou substitué, et aryle en C₆₋₁₂ non substitué ou substitué ; et alkylamammonium en C₁₋₁₀, alcénylammonium en C₂₋₁₀, alkyliminium en C₁₋₁₀, cycloalkylammonium en C₃₋₁₀ et cycloalkyliminium en C₃₋₁₀, dont chacun est non substitué ou substitué avec un ou plusieurs substituants sélectionnés parmi : amino, alkylamino en C₁₋₆, imino, alkylimino en C₁₋₆, alkyle en C₁₋₆, alcényle en C₂₋₆, cycloalkyle en C₃₋₆ et aryle en C₆₋₁₂ ; de préférence dans lequel chaque cation A est sélectionné parmi : Cs⁺, Rb⁺, méthylammonium, diméthylammonium, triméthylammonium, éthylammonium, propylammonium. butylammonium, pentylammoium, hexylammonium, septylammonium, octylammonium, tétraméthylammonium, formamidinium, 1-aminoéthan-1-iminium, et guanidinium ; et/ou
[M] comprend deux ou plus de deux cations M différents ; et/ou
chaque cation M est sélectionné parmi : Ca²⁺, Sr²⁺, Cd²⁺, Cu²⁺, Ni²⁺, Mn²⁺, Fe²⁺, Co²⁺, Pd²⁺, Ge²⁺, Sn²⁺, Pb²⁺, Yb²⁺, et Eu²⁺, de préférence Sn²⁺, Pb²⁺, Cu²⁺, Ge²⁺, et Ni²⁺ ; de préférence Sn²⁺ et Pb²⁺ ; et/ou
chaque anion X est un halogénure, facultativement dans lequel [X] comprend deux ou plus de deux anions d'halogénure différents ; et/ou
[A] comprend un cation de la formule [R₁NH₃]⁺, dans lequel R₁ est alkyle en C₁₋₁₀ non substitué et dans lequel l'amine organique comprend une (alkyle en C₁₋₁₀)-amine non substituée, de préférence dans lequel le groupe alkyle en C₁₋₁₀ sur le cation A de la formule [RiNH₃]⁺ et le groupe alkyle en C₁₋₁₀ sur la (alkyle en C₁₋₁₀)-amine non substituée sont les mêmes, mieux encore dans lequel [A] comprend du méthylammonium et l'amine organique comprend de la méthylamine.

8. Procédé selon une quelconque revendication précédente dans lequel :
le matériau photoactif dans la région photoactive dans le substrat comprend un matériau A/M/X cristallin, lequel matériau A/M/X cristallin comprend un composé de la formule [A]ₐ[M]_{b}[X]_{c} tel que défini dans la revendication 1 ou la revendication 7, facultativement dans lequel le matériau A/M/X cristallin déposé sur le substrat et le matériau A/M/X cristallin dans la région photoactive sont différents ; et/ou
le substrat comprend deux régions photoactives distinctes, dans lequel chaque région photoactive comprend un matériau photoactif, de préférence dans lequel chaque matériau photoactif dans chaque région photoactive comprend un matériau A/M/X cristallin, lequel matériau A/M/X cristallin comprend un composé de la formule [A]ₐ[M]_{b}[X]_{c} tel que défini dans la revendication 1 ou la revendication 7, facultativement dans lequel au moins deux des matériaux A/M/X cristallins sélectionnés parmi le matériau A/M/X cristallin déposé sur le substrat et les matériaux A/M/X cristallins dans les deux régions photoactives sont différents, facultativement dans lequel tous les trois des matériaux A/M/X cristallins sélectionnés parmi le matériau A/M/X cristallin déposé sur le substrat et les matériaux A/M/X cristallins dans les deux régions photoactives sont différents ; et/ou
la solution filmogène comprend en outre un ou plusieurs cations A et un ou plusieurs anions X ; et/ou
le procédé comprend en outre une étape consistant à disposer sur le substrat une composition comprenant un ou plusieurs cations A et facultativement un ou plusieurs anions X ; et/ou
le fait de disposer la composition filmogène sur le substrat comprend une étape consistant à déposer à la tournette la solution filmogène sur le substrat ; et/ou
le procédé comprend en outre le fait d'éliminer le solvant pour former la couche comprenant le matériau A/M/X cristallin, facultativement dans lequel le solvant est éliminé en chauffant le substrat traité par solution filmogène, facultativement en chauffant le substrat traité par solution filmogène jusqu'à une température de 50 °C à 200 °C, facultativement pendant une période de 10 à 100 minutes.

9. Procédé selon l'une quelconque des revendications précédentes, dans lequel :
(A) le substrat comprend
i) une première électrode, de préférence dans lequel la première électrode comprend un oxyde conducteur transparent,
ii) une région photoactive, ladite région photoactive comprenant de préférence comprenant un matériau A/M/X cristallin, lequel matériau A/M/X cristallin comprend un composé de la formule [A]ₐ[M]_{b}[X]_{c} tel que défini dans la revendication 1 ou la revendication 7,
iii) une couche de recombinaison de charge disposée sur la région photoactive, facultativement dans lequel la couche de recombinaison de charge est telle que définie dans la revendication 4, et
iv) facultativement, une couche d'un matériau de transport de charge disposée sur la couche de recombinaison de charge ; et/ou
(B) le procédé comprend en outre :
le fait de disposer une seconde électrode sur la couche du matériau A/M/X cristallin disposée sur le substrat,
ou, de préférence, le fait de disposer un matériau de transport de charge sur la couche du matériau A/M/X cristallin disposée sur le substrat, et le fait de disposer une seconde électrode sur la matériau de transport de charge,
de préférence dans lequel la seconde électrode comprend un métal élémentaire.

10. Procédé selon l'une quelconque des revendications 1 à 9, dans lequel le dispositif multi-jonction est un dispositif optoélectronique, facultativement dans lequel le dispositif optoélectronique est un dispositif photovoltaïque ou un dispositif électroluminescent.
